# EUROPEAN PATENT APPLICATION

(11) **EP 4 826 498 A1**
(43) Date of publication of application: **21.10.2026**
(21) Application number: 24904436.3
(22) Date of filing: 13.12.2024
(51) Int. Cl.: G06F 3/041, G06F 3/044, G06F 3/047

(54) **ELECTRONIC DEVICE**

(30) Priority: 15.12.2023 KR 20230183593
(71) Applicant: Samsung Display Co., Ltd., Yongin-si, Gyeonggi-do 17113 (KR)
(72) Inventor: NA, Hyunjae, Yongin-Si Gyeonggi-do 17113 (KR); LEE, Youngjin, Yongin-Si Gyeonggi-do 17113 (KR); JANG, Seokwon, Yongin-Si Gyeonggi-do 17113 (KR); CHO, Sunhaeng, Yongin-Si Gyeonggi-do 17113 (KR)
(74) Representative: Dr. Weitzel & Partner
(86) International application number: PCT/KR2024/096937
(87) International publication number: WO 2025/127871

(57) **Abstract**

Disclosed is an electronic device which includes a display module and a digitizer that is disposed under the display module and that includes a folding part folded about a folding axis extending in a first direction and a first non-folding part and a second non-folding part spaced apart from each other in a second direction crossing the first direction with the folding part therebetween. The digitizer includes a plurality of sensing coils, and different sensing coils among the plurality of sensing coils are shared through a common line disposed at least in the folding part.

## Description

### [TECHNICAL FIELD]

Embodiments of the present disclosure described herein relate to an electronic device, and more particularly, relate to an electronic device including a digitizer.

### [BACKGROUND]

In the information society, the importance of electronic devices as visual information delivery media is emerging. The electronic devices are activated by electrical signals applied thereto. Each of the electronic devices includes a digitizer that senses an input applied from outside a display layer that displays an image.

The digitizer of the electronic device may include various sensing coils so as to be activated by an electrical signal. The area where the sensing coils are activated responds to a signal applied from the outside.

### [DISCLOSURE OF THE INVENTION]

### [TECHNICAL PROBLEM]

Embodiments of the present disclosure provide an electronic device with improved folding characteristics of a digitizer and improved sensing sensitivity in a folding area.

### [TECHNICAL SOLUTION]

According to an embodiment, an electronic device includes a display module including an active area where an image is provided and a peripheral area adjacent to the active area and a digitizer that is disposed under the display module and that includes a folding part folded about a folding axis extending in a first direction and a first non-folding part and a second non-folding part spaced apart from each other in a second direction crossing the first direction with the folding part therebetween. The digitizer includes a plurality of sensing coils, and different sensing coils among the plurality of sensing coils are shared through a common line disposed at least in the folding part.

The common line may extend in the second direction.

When one of the different sensing coils shared through the common line is driven for sensing, the rest of the different sensing coils shared through the common line may be driven to be floated.

The plurality of sensing coils may include first sensing coils arranged in the first direction and each extending in the second direction and second sensing coils arranged in the second direction and each extending in the first direction. The second sensing coils may include non-folding coils disposed in the first non-folding part or the second non-folding part and folding coils at least partially disposed in the folding part. The first sensing coils and the second sensing coils may be insulated from each other, and each of the first sensing coils and the second sensing coils may form an open loop.

The common line may be shared by two folding coils.

The common line may be shared by two folding coils and one first sensing coil.

The common line may be shared by two first sensing coils.

The common line may be shared by one folding coil and two first sensing coils.

Each of the first sensing coils may include first extending lines that extend in the second direction and first connecting lines that are connected with the first extending lines and that extend in the first direction, and each of the first extending lines may extend from the first non-folding part to the second non-folding part via the folding part.

Each of the non-folding coils may include second extending lines that extend in the first direction and second connecting lines that are connected with the second extending lines and that extend in the second direction. Each of the folding coils may include third extending lines that extend in the first direction and third connecting lines that are connected with the third extending lines and that extend in the second direction, and each of the third connecting lines may be disposed at least in the folding part.

The folding coils may include a first folding coil, a second folding coil, and a third folding coil. The common line may include a plurality of common lines, and the plurality of common lines may include a first common line and a second common line. The first common line may be shared by one third connecting line of the first folding coil and one third connecting line of the second folding coil. The second common line may be shared by another third connecting line of the second folding coil and one third connecting line of the third folding coil.

The digitizer may include at least one base layer, and third extending lines disposed in the folding part may be connected to corresponding third connecting lines through contact holes formed through the base layer.

The contact holes may be defined in the folding part, and the third extending lines disposed in the folding part may extend in the first direction in the folding part.

The contact holes may be defined in the first non-folding part or the second non-folding part, and each of the third extending lines disposed in the folding part may include an extension that extends in the first direction in the folding part and a connecting portion that connects the extension and a corresponding contact hole.

The folding part may include an inner portion and an upper outer portion and a lower outer portion spaced apart from each other in the first direction with the inner portion therebetween, and up to four lines may be disposed in a same layer in each of the upper outer portion and the lower outer portion. The first common line may be disposed at least in the upper outer portion, and the second common line may be disposed at least in the lower outer portion.

At least one of two first extending lines of a first-first sensing coil and two first extending lines of a second-first sensing coil may cross the upper outer portion. At least one of two first extending lines of an (n-1)^{th}-first sensing coil and two first extending lines of an n^{th}-first sensing coil may cross the lower outer portion, and n may be a natural number greater than or equal to 4.

The first common line may be additionally shared by one first extending line of a first-first sensing coil. The second common line may be additionally shared by one first extending line of an (n-1)^{th}-first sensing coil, and n may be a natural number greater than or equal to 4.

Each of the first sensing coils and the folding coils may form an open loop wound twice. The first extending lines of each of the first sensing coils may include first-first to first-fourth extending lines, and the first connecting lines of each of the first sensing coils may include first-first to first-fourth connecting lines. The third extending lines of each of the folding coils may include third-first to third-fourth extending lines, and the third connecting lines of each of the folding coils may include third-first to third-fourth connecting lines.

The folding coils may include a first folding coil, a second folding coil, and a third folding coil arranged in the second direction. The common line may be shared by a third-first connecting line of the first folding coil, a third-first connecting line of the second folding coil, and a first-second extending line of a first-first sensing coil.

The digitizer may include a first base layer, a second base layer disposed under the first base layer, a first cover layer disposed on the first base layer, a second cover layer disposed under the second base layer, a first conductive layer disposed between the first base layer and the first cover layer, a second conductive layer disposed between the first base layer and the second base layer, and a third conductive layer disposed between the second base layer and the second cover layer. The folding part may include an inner portion and an outer portion spaced apart from the inner portion in the first direction, and up to four lines may be disposed in the same layer in the outer portion.

The folding coils may further include a left folding coil and a right folding coil spaced apart from each other in the second direction with the first to third folding coils therebetween. A first-first extending line of the first-first sensing coil, first-first and first-second extending lines of a second-first sensing coil, and a third-second connecting line of the second folding coil may be included in the first conductive layer and may pass through the outer portion. The common line, a third-second connecting line of the first folding coil, and third-first and third-second connecting lines of the third folding coil may be included in the second conductive layer and may pass through the outer portion. Third-third and third-fourth extending lines of the first folding coil, third-first and third-second extending lines of the third folding coil, third-first and third-second connecting lines and third-third and third-fourth extending lines of the left folding coil, and third-first and third-second connecting lines and third-first and third-second extending lines of the right folding coil may be included in the third conductive layer and may pass through the outer portion.

The folding part may include an inner portion and an outer portion spaced apart from the inner portion in the first direction, and up to four lines may be disposed in a same layer in the outer portion. The common line may be shared by one first extending line of an i^{th}-first sensing coil and one first extending line of a j^{th}-first sensing coil and may pass through the inner portion.

The digitizer may further include bridge lines that electrically connect second sensing coils disposed in the first non-folding part and a connector and pass through the folding part, and the common line may be additionally shared by at least one bridge line.

The folding part may include an inner portion and an outer portion spaced apart from the inner portion in the first direction, and first holes disposed in the inner portion and second holes and third holes disposed at least in the outer portion may be defined in the folding part. The first holes may include first group holes arranged in the first direction and each extending in the first direction and second group holes arranged in the first direction and each extending in the first direction, and the second group holes may alternate with the first group holes and may be shifted in the first direction with the first group holes. The second holes may be spaced apart from the first group holes in the first direction, and each of the second holes may extend in the first direction. The third holes may include third-first holes spaced apart from the second group holes in the first direction and each extending in the first direction and third-second holes spaced apart from the third-first holes in the first direction and arranged in the second direction at an edge of the outer portion, and the third-second holes may form an open opening

Up to four lines may be disposed in the same layer between holes adjacent to each other in the first direction, and up to two lines may be disposed in a same layer between holes adjacent to each other in the second direction.

At least some of the plurality of sensing coils may include sensing lines that cross the folding part and curvedly extend along peripheries of the holes. A gap between a hole and a sensing line adjacent to each other may be less than 75 micrometers. A gap between sensing lines adjacent to each other may range from 20 micrometers to 40 micrometers. Each of the sensing lines may have a width of 40 micrometers to 200 micrometers.

The digitizer may include a first base layer having first base holes defined therein, a second base layer that is disposed under the first base layer and that has second base holes defined therein, a first cover layer that is disposed on the first base layer and that has first cover holes defined therein, and a second cover layer that is disposed under the second base layer and that has second cover holes defined therein. Holes may be defined in the folding part of the digitizer, and each of the holes may be defined by a corresponding first base hole, a corresponding second base hole, a corresponding first cover hole, and a corresponding second cover hole aligned in a thickness direction.

Each of the first base layer, the second base layer, the first cover layer, and the second cover layer may include a fiber reinforced composite and may have a modulus of 10GPa to 30GPa.

The digitizer may include a first base layer having first base holes defined therein, a second base layer that is disposed under the first base layer and that has second base holes defined therein, a third base layer that is disposed under the second base layer and that has third base holes defined therein, a first cover layer that is disposed on the first base layer and that has first cover holes defined therein, and a second cover layer that is disposed under the third base layer and that has second cover holes defined therein. Holes may be defined in the folding part of the digitizer, and each of the holes may be defined by a corresponding first base hole, a corresponding second base hole, a corresponding third base hole, a corresponding first cover hole, and a corresponding second cover hole aligned in a thickness direction.

According to an embodiment, an electronic device includes a display module including an active area where an image is provided and a peripheral area adjacent to the active area and a digitizer that is disposed under the display module and that includes a folding part folded about a folding axis extending in a first direction and a first non-folding part and a second non-folding part spaced apart from each other in a second direction crossing the first direction with the folding part therebetween. The digitizer includes a plurality of sensing coils, each of which includes a plurality of sensing lines, and a plurality of bridge lines that connect the plurality of sensing coils and a connector. Some of the plurality of sensing lines and the plurality of bridge lines that pass through the folding part are shared through a common line.

### [ADVANTAGEOUS EFFECTS]

According to the present disclosure, the wiring density in the folding part may be reduced by providing the common line in the digitizer. Accordingly, wiring reliability may be prevented from being compromised due to concentration of wiring, and lines provided in the form of a bypass path may be reduced. Thus, the digitizer with improved sensing performance in the folding part may be provided. In addition, the sensing performance in the folding part may be improved even without an additional conductive layer, and the folding reliability of the digitizer may be prevented from being compromised due to concentration of wiring. Thus, the digitizer with improved folding characteristics may be provided.

### [BRIEF DESCRIPTION OF THE DRAWINGS]

FIGS. 1A to 1C are perspective views of an electronic device according to an embodiment of the present disclosure.
FIG. 2A is an exploded perspective view of the electronic device according to an embodiment of the present disclosure.
FIG. 2B is a block diagram of the electronic device according to an embodiment of the present disclosure.
FIG. 3 is a plan view of a display panel according to an embodiment of the present disclosure.
FIG. 4A is a schematic cross-sectional view of a display module according to an embodiment of the present disclosure.
FIG. 4B is a view illustrating a section of the display module corresponding to any one pixel illustrated in FIG. 3.
FIG. 5A is a cross-sectional view of a display device taken along line I-I' of FIG. 3 according to an embodiment of the present disclosure.
FIG. 5B is a cross-sectional view of the bent display device according to an embodiment of the present disclosure.
FIG. 6A is a plan view of a digitizer illustrating first sensing coils of the digitizer according to an embodiment of the present disclosure.
FIG. 6B is a plan view illustrating the first sensing coil according to an embodiment of the present disclosure.
FIG. 7A is a plan view of the digitizer illustrating second sensing coils of the digitizer according to an embodiment of the present disclosure.
FIG. 7B is a plan view illustrating the second sensing coil according to an embodiment of the present disclosure.
FIGS. 8A and 8B are cross-sectional views of the digitizer according to an embodiment of the present disclosure.
FIG. 9 is a cross-sectional view of the digitizer according to an embodiment of the present disclosure.
FIGS. 10A to 10C illustrate portions of long sides of the first sensing coils according to an embodiment of the present disclosure.
FIG. 11 is an enlarged plan view illustrating some of the holes defined in the digitizer according to an embodiment of the present disclosure.
FIG. 12A is an enlarged plan view of a portion of the digitizer according to an embodiment of the present disclosure.
FIGS. 12B to 12D are enlarged cross-sectional views of a portion of the digitizer according to an embodiment of the present disclosure.
FIG. 13A is an enlarged plan view of a portion of the digitizer according to an embodiment of the present disclosure.
FIGS. 13B to 13D are enlarged sectional views of a portion of the digitizer according to an embodiment of the present disclosure.
FIG. 14A is an enlarged plan view of a portion of the digitizer according to an embodiment of the present disclosure.
FIG. 14B is an enlarged cross-sectional view of a portion of the digitizer according to an embodiment of the present disclosure.
FIG. 15 is an enlarged plan view of a portion of the digitizer according to an embodiment of the present disclosure.
FIG. 16 is an enlarged plan view of a portion of the digitizer according to an embodiment of the present disclosure.
FIG. 17A is an enlarged cross-sectional view of a portion of the digitizer according to an embodiment of the present disclosure.
FIGS. 17B to 17D are enlarged plan views of a portion of the digitizer according to an embodiment of the present disclosure.
FIG. 18 is an enlarged plan view of a portion of a digitizer according to a comparative example.
FIG. 19A is an enlarged cross-sectional view of a portion of the digitizer according to the comparative example.
FIGS. 19B to 19E are enlarged plan views of a portion of the digitizer according to the comparative example.
FIGS. 20 to 23 are enlarged plan views of a portion of the digitizer according to an embodiment of the present disclosure.
FIG. 24 is a sectional view of a base layer according to an embodiment of the present disclosure.
FIG. 25 is a plan view of the base layer according to an embodiment of the present disclosure.

### [MODE FOR CARRYING OUT THE INVENTION]

In this specification, when it is mentioned that a component (or, an area, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description. As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

Hereinafter, embodiments of the present disclosure will be described with reference to the accompanying drawings.

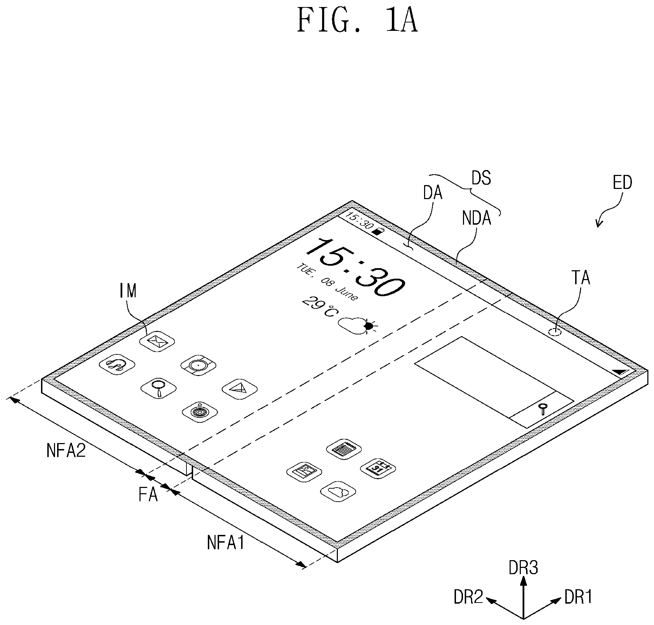

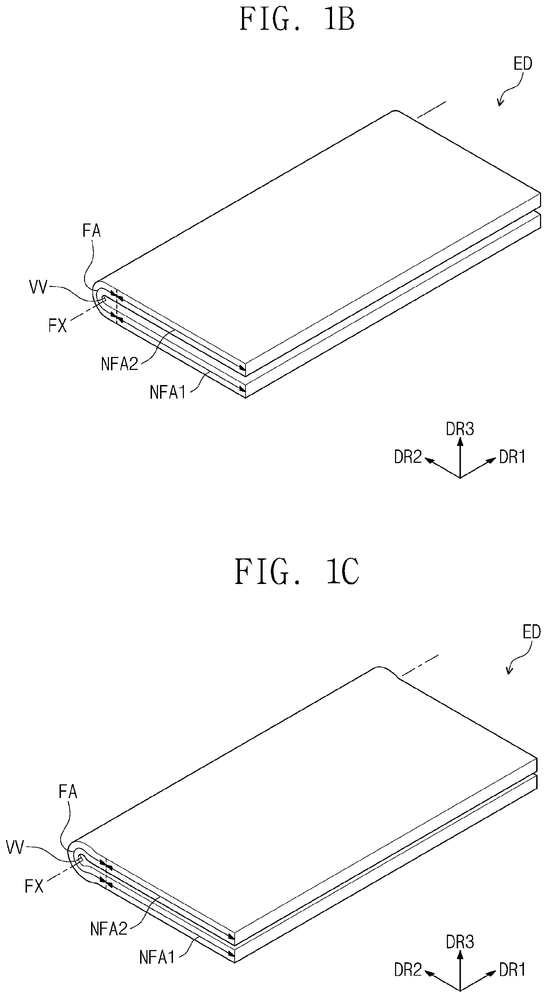

FIGS. 1A to 1C are perspective views of an electronic device ED according to an embodiment of the present disclosure. FIG. 1A illustrates an unfolded state of the electronic device ED, and FIGS. 1B and 1C illustrate a folded state of the electronic device ED.

Referring to FIGS. 1A to 1C, the electronic device ED according to an embodiment of the present disclosure may include a display surface DS defined in a first direction DR1 and a second direction DR2 crossing the first direction DR1. The electronic device ED may provide an image IM to a user through the display surface DS.

The display surface DS may include a display area DA and a non-display area NDA around the display area DA. The display area DA may display the image IM, and the non-display area NDA may not display the image IM. The non-display area NDA may surround the display area DA. However, without being limited thereto, the shape of the display area DA and the shape of the non-display area NDA may be modified.

The display surface DS may further include a sensing area TA. The sensing area TA may be one area of the display area DA. The sensing area TA has a higher light transmittance than the other area of the display area DA. Hereinafter, the other area of the display area DA other than the sensing area TA may be defined as a general display area.

An optical signal, for example, visible light or infrared light may travel through the sensing area TA. The electronic device ED may take an image of an external object through the visible light passing through the sensing area TA, or may determine accessibility of the external object through the infrared light passing through the sensing area TA. In FIG. 1A, one sensing area TA is illustrated as an example. However, the present disclosure is not limited thereto, and a plurality of sensing areas TA may be provided.

Hereinafter, a direction substantially perpendicular to a plane defined by the first direction DR1 and the second direction DR2 is defined as a third direction DR3. Front surfaces and rear surfaces of members are distinguished from each other based on the third direction DR3. The expression "when viewed from above the plane" used herein may mean that it is viewed in the third direction DR3.

The electronic device ED may include a folding area FA and a plurality of non-folding areas NFA1 and NFA2. The non-folding areas NFA1 and NFA2 may include the first non-folding area NFA1 and the second non-folding area NFA2. The first non-folding area NFA1 and the second non-folding area NFA2 may be spaced apart from each other in the second direction DR2 with the folding area FA therebetween.

As illustrated in FIG. 1B, the folding area FA may be folded about a folding axis FX parallel to the first direction DR1. The folding area FA has a certain curvature and a certain radius of curvature VV. The distance between the first non-folding area NFA1 and the second non-folding area NFA2 may be substantially the same as twice the radius of curvature VV. According to an embodiment, the electronic device ED may be folded in an in-folding manner such that the first non-folding area NFA1 and the second non-folding area NFA2 face each other and the display surface DS is not exposed to the outside.

As illustrated in FIG. 1C, the distance between the first non-folding area NFA1 and the second non-folding area NFA2 may be smaller than twice the radius of curvature VV. Accordingly, in the folded state, the separation distance between the first non-folding area NFA1 and the second non-folding area NFA2 may be decreased. Thus, the electronic device ED having a slim state when folded may be provided.

However, the present disclosure is not limited thereto, and in an embodiment, the electronic device ED may be folded in an out-folding manner such that the display surface DS is exposed to the outside. In an embodiment of the present disclosure, the electronic device ED may be configured such that an in-folding operation and an out-folding operation are repeatedly performed in the unfolded state. However, the present disclosure is not limited thereto. In an embodiment of the present disclosure, the electronic device ED may be configured to select one of an unfolding operation, an in-folding operation, and an out-folding operation.

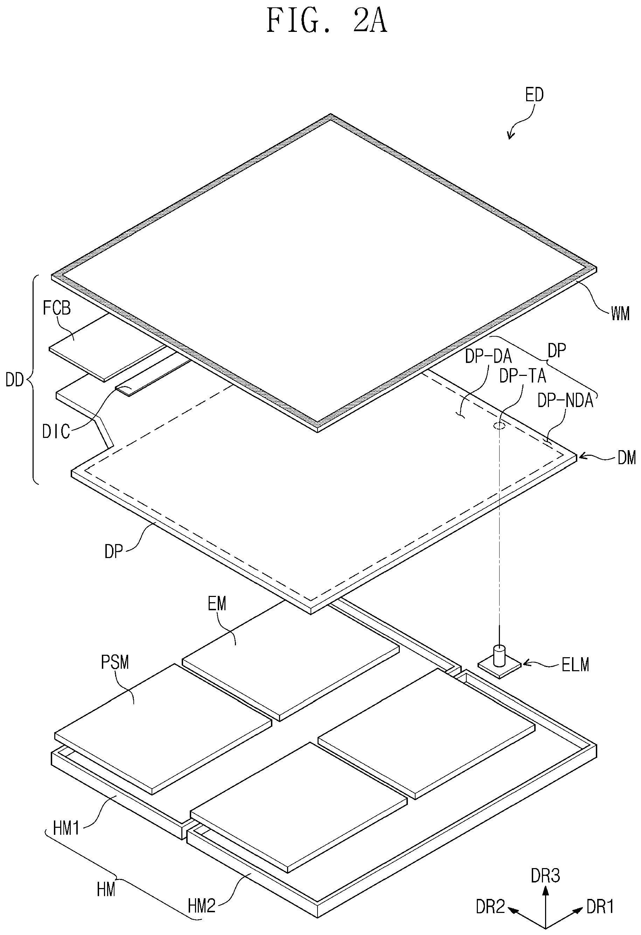

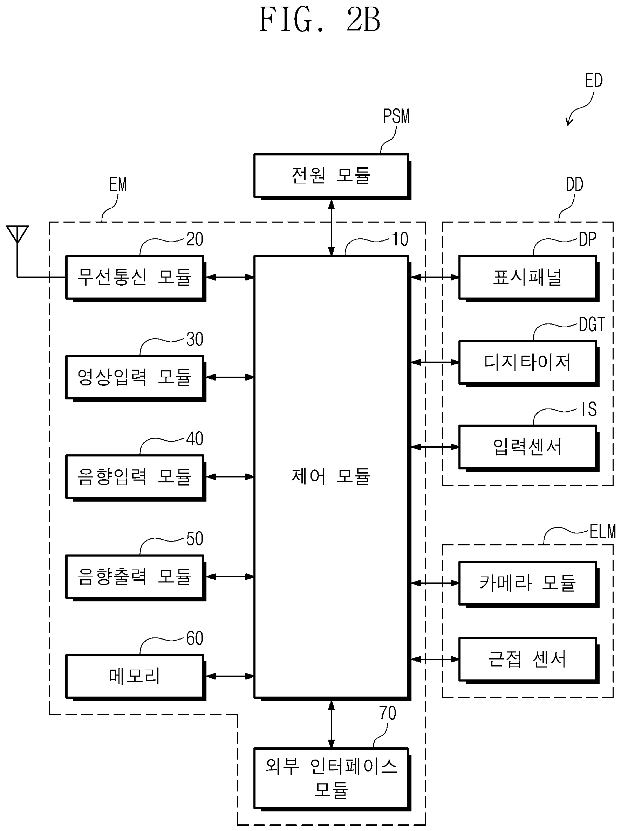

FIG. 2A is an exploded perspective view of the electronic device ED according to an embodiment of the present disclosure. FIG. 2B is a block diagram of the electronic device ED according to an embodiment of the present disclosure.

Referring to FIGS. 2A and 2B, the electronic device ED may include a display device DD, electronic modules EM, an electro-optical module ELM, power supply modules PSM, and a housing HM. Although not separately illustrated, the electronic device ED may further include a mechanical structure (e.g., a hinge) for controlling a folding operation of the display device DD.

The display device DD generates an image and senses an external input. The display device DD includes a window WM and a display module DM. The window WM provides the front surface of the electronic device ED. Detailed description of the window WM will be given below.

The display module DM may include a display panel DP. Although FIG. 2A illustrates only the display panel DP among stacked structures of the display module DM, the display module DM may substantially further include a plurality of components disposed over the display panel DP. Detailed description of a stack structure of the display module DM will be given below.

The type of display panel DP is not particularly limited. For example, the display panel DP may be an emissive display panel such as an organic light emitting display panel or a quantum-dot light emitting display panel.

The display panel DP includes a display area DP-DA and a non-display area DP-NDA that correspond to the display area DA (refer to FIG. 1A) and the non-display area NDA (refer to FIG. 1A) of the electronic device ED. The expression "one area/portion corresponds to another area/portion" used herein may mean that the areas/portions overlap each other and is not limited to having the same area.

The display panel DP may include a sensing area DP-TA (or, a first area) corresponding to the sensing area TA of FIG. 1A. The sensing area DP-TA may have a lower resolution than the display area DP-DA (or, the second area).

As illustrated in FIG. 2A, a driver IC DIC may be disposed on the non-display area DP-NDA of the display panel DP. A flexible circuit board FCB may be coupled to the non-display area DP-NDA of the display panel DP. The flexible circuit board FCB may be connected to a main circuit board. The main circuit board may be one electronic part constituting the electronic modules EM.

The driver IC DIC may include drive elements (e.g., a data drive circuit) for driving pixels of the display panel DP. Although FIG. 2 illustrates the structure in which the driver IC DIC is mounted on the display panel DP, the present disclosure is not limited thereto. For example, the driver IC DIC may be mounted on the flexible circuit board FCB.

As illustrated in FIG. 2B, the display device DD may further include an input sensor IS and a digitizer DGT. The input sensor IS senses an input of the user. The input sensor IS of a capacitive type may be disposed on the display panel DP. The digitizer DGT senses an input of a stylus pen. The digitizer DGT of an electromagnetic induction type may be disposed under the display panel DP.

The electronic modules EM may include a control module 10, a wireless communication module 20, an image input module 30, a sound input module 40, a sound output module 50, a memory 60, an external interface module 70, and the like. The electronic modules EM may include the main circuit board, and the modules may be mounted on the main circuit board, or may be electrically connected to the main circuit board through flexible circuit boards. The input sensor IS and the digitizer DGT may be connected to the main circuit board through connectors. The electronic modules EM are electrically connected with the power supply modules PSM.

As illustrated in FIG. 2A, the housing HM may include a first housing HM1 and a second housing HM2. The electronic modules EM may be disposed in the first housing HM1 and the second housing HM2, and the power supply modules PSM may be disposed in the first housing HM1 and the second housing HM2. Although not illustrated, the electronic module EM disposed in the first housing HM1 and the electronic module EM disposed in the second housing HM2 may be electrically connected with each other through a flexible circuit board.

As illustrated in FIG. 2B, the control module 10 controls overall operation of the electronic device ED. For example, the control module 10 activates or deactivates the display device DD in response to a user input. The control module 10 may control the image input module 30, the sound input module 40, and the sound output module 50 in response to user inputs. The control module 10 may include at least one microprocessor.

The wireless communication module 20 may transmit/receive wireless signals with another terminal through Bluetooth or Wi-Fi. The wireless communication module 20 may transmit/receive sound signals using a general communication line. The wireless communication module 20 may include a plurality of antenna modules.

The image input module 30 processes an image signal to covert the image signal into image data that is able to be displayed on the display device DD. The sound input module 40 receives an external sound signal through a microphone in a voice recording mode or a voice recognition mode and converts the external sound signal into electrical voice data. The sound output module 50 converts sound data received from the wireless communication module 20 or sound data stored in the memory 60 and outputs the converted data to the outside.

The external interface module 70 serves as an interface connected to an external charger, a wired/wireless data port, a card socket (e.g., a memory card or a SIM/UIM card), or the like.

The power supply modules PSM supply power required for overall operation of the electronic device ED. The power supply modules PSM may include a conventional battery device.

The electro-optical module ELM may be an electronic part that outputs or receives an optical signal. The electro-optical module ELM may include a camera module and/or a proximity sensor. The camera module takes an image of an external object through the sensing area DP-TA. The electro-optical module ELM may be disposed under the display device DD and may overlap the sensing area DP-TA.

The housing HM is coupled with the window WM and accommodates the other modules described above. Although the housing HM is illustrated as including the first and second housings HM1 and HM2 separated from each other, the present disclosure is not limited thereto. The electronic device ED according to an embodiment may further include a hinge structure for connecting the first and second housings HM1 and HM2.

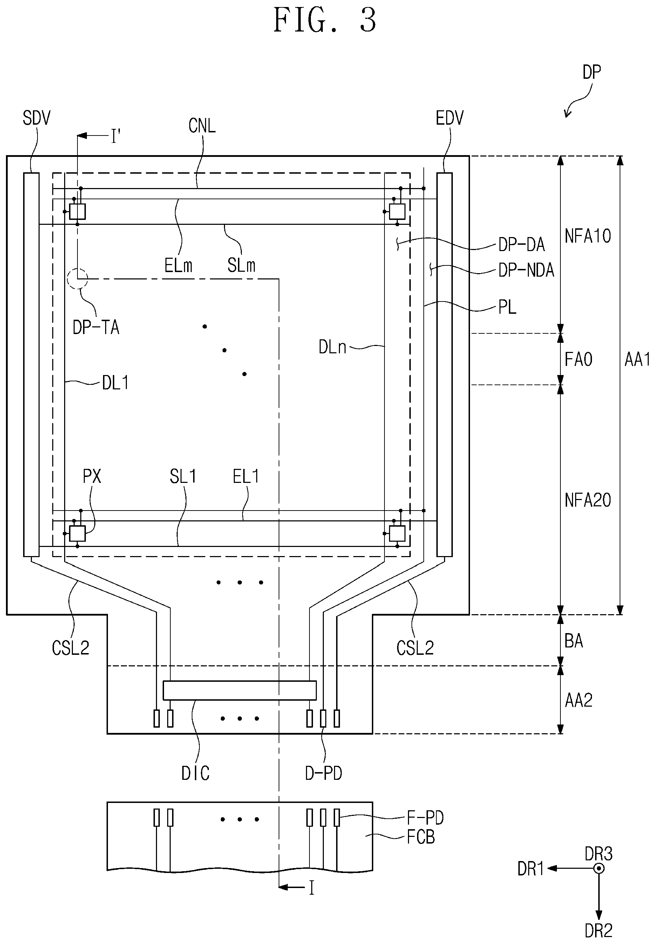

FIG. 3 is a plan view of the display panel DP according to an embodiment of the present disclosure.

Referring to FIG. 3, the display panel DP may include the display area DP-DA and the non-display area DP-NDA around the display area DP-DA. The display area DP-DA and the non-display area DP-NDA may be distinguished from each other depending on a presence or absence of pixels PX. The pixels PX are disposed in the display area DP-DA. A scan driver SDV, a data driver, and an emission driver EDV may be disposed in the non-display area DP-NDA. The data driver may be a circuit configured in the driver IC DIC.

The display panel DP includes a first non-bending area AA1, a second non-bending area AA2, and a bending area BA distinguished from one another in the second direction DR2. The second non-bending area AA2 and the bending area BA may be partial areas of the non-display area DP-NDA. The bending area BA is disposed between the first non-bending area AA1 and the second non-bending area AA2.

The first non-bending area AA1 is an area corresponding to the display surface DS of FIG. 1A. The first non-bending area AA1 may include a first non-folding area NFA10, a second non-folding area NFA20, and a folding area FA0. The first non-folding area NFA10, the second non-folding area NFA20, and the folding area FA0 correspond to the first non-folding area NFA1, the second non-folding area NFA2, and the folding area FA of FIGS. 1A to 1C, respectively.

The above-described sensing area DP-TA may be defined in the display area DP-DA and the first non-folding area NFA10. The sensing area DP-TA may have a higher light transmittance and a lower resolution than the other area in the display area DP-DA. The light transmittance and the resolution are measured in a reference area. The number of pixels disposed in the reference area (or, the same area) is smaller in the sensing area DP-TA than in the display area DP-DA. The occupancy percentage of a light blocking structure in the reference area may be lower in the sensing area DP-TA than in the other area of the display area DP-DA. The light blocking structure may include a conductive pattern of a circuit layer, an electrode of a light emitting element, a light blocking pattern, and the like that will be described below. According to an embodiment, the electro-optical module ELM described with reference to FIG. 2A may overlap the sensing area DP-TA having a high light transmittance and thus may improve the reception efficiency of an optical signal.

The widths of the bending area BA and the second non-bending area AA2 in the first direction DR1 may be smaller than the width of the first non-bending area AA1 in the first direction DR1. The bending area BA having a relatively small width in the first direction DR1 may be easily bent about a bending axis extending in the first direction DR1.

The display panel DP may include the plurality of pixels PX, a plurality of scan lines SL1 to SLm, a plurality of data lines DL1 to DLn, a plurality of emission lines EL1 to ELm, first and second control lines CSL1 and CSL2, a power line PL, and a plurality of display pads D-PD. Here, "m" and "n" are natural numbers. The pixels PX may be connected to the scan lines SL1 to SLm, the data lines DL1 to DLn, and the emission lines EL1 to ELm.

The scan lines SL1 to SLm may extend in the first direction DR1 and may be connected to the scan driver SDV. The data lines DL1 to DLn may extend in the second direction DR2 and may be connected to the driver IC DIC via the bending area BA. The emission lines EL1 to ELm may extend in the first direction DR1 and may be connected to the emission driver EDV.

The power line PL may include a portion extending in the second portion DR2 and a portion extending in the first direction DR1. The portion extending in the first direction DR1 and the portion extending in the second portion DR2 may be disposed on different layers. The portion of the power line PL that extends in the second direction DR2 may extend to the second non-bending area AA2 via the bending area BA. The power line PL may receive a drive voltage.

Connecting lines CNL may extend in the first direction DR1 and may be arranged in the second direction DR2. The connecting lines CNL may be connected to the power line PL and the pixels PX. The drive voltage may be applied to the pixels PX through the power line PL and the connecting lines CNL connected with each other.

The first control line CSL1 may be connected to the scan driver SDV and may extend toward a lower end of the second non-bending area AA2 via the bending area BA. The second control line CSL2 may be connected to the emission driver EDV and may extend toward the lower end of the second non-bending area AA2 via the bending area BA.

The display pads D-PD may be disposed adjacent to the lower end of the second non-bending area AA2 when viewed from above the plane. The driver IC DIC, the power line PL, the first control line CSL1, and the second control line CSL2 may be connected to the display pads D-PD. Substrate pads F-PD included in the flexible circuit board FCB may be electrically connected with the corresponding display pads D-PD through an anisotropic conductive adhesive layer.

Although not illustrated, a timing controller and a voltage generator may be disposed on the flexible circuit board FCB. The timing controller may be manufactured in the form of an integrated circuit chip and may be mounted on a printed circuit board. The timing controller and the voltage generator may be connected to the pads PD through the printed circuit board.

The timing controller may control operations of the scan driver SDV, the data driver, and the emission driver EDV. The timing controller may generate a scan control signal, a data control signal, and an emission control signal in response to control signals received from the outside. The voltage generator may generate the drive voltage.

The scan control signal may be provided to the scan driver SDV through the first control line CSL1. The emission control signal may be provided to the emission driver EDV through the second control line CSL2. The data control signal may be provided to the data driver. The timing controller may receive image signals from the outside, may convert the data format of the image signals according to the specification of an interface with the data driver, and may provide the converted signals to the data driver.

The scan driver SDV may generate a plurality of scan signals in response to the scan control signal. The scan signals may be applied to the pixels PX through the scan lines SL1 to SLm. The scan signals may be sequentially applied to the pixels PX.

The data driver may generate a plurality of data voltages corresponding to the image signals in response to the data control signal. The data voltages may be applied to the pixels PX through the data lines DL1 to DLn. The emission driver EDV may generate a plurality of emission signals in response to the emission control signal. The emission signals may be applied to the pixels PX through the emission lines EL1 to ELm.

The pixels PX may receive the data voltages in response to the scan signals. The pixels PX may display an image by emitting light having luminance corresponding to the data voltages in response to the emission signals. The light emission time of the pixels PX may be controlled by the emission signals.

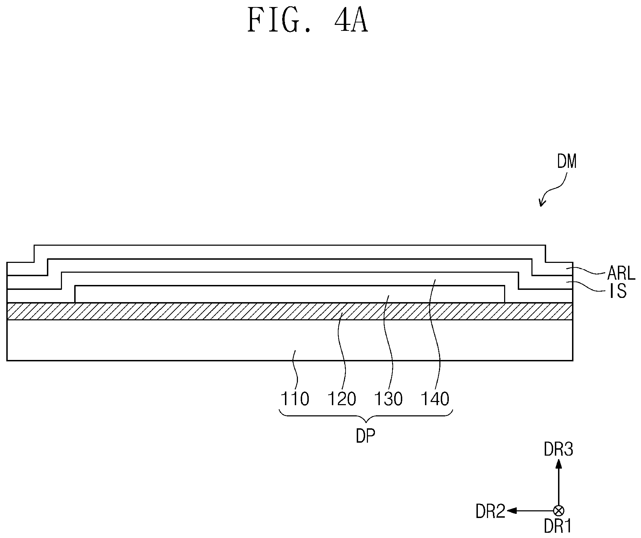

FIG. 4A is a schematic cross-sectional view of the display module DM according to an embodiment of the present disclosure.

Referring to FIG. 4A, the display module DM may include the display panel DP, the input sensor IS, and an anti-reflective layer ARL. The display panel DP may include a base layer 110, a circuit layer 120, a light emitting element layer 130, and an encapsulation layer 140.

The base layer 110 may provide a base surface on which the circuit layer 120 is disposed. The base layer 110 may be a flexible substrate that is able to be bent, folded, or rolled. The base layer 110 may be a glass substrate, a metal substrate, a polymer substrate, or the like. However, embodiments of the present disclosure are not limited thereto, and the base layer 110 may be an inorganic layer, an organic layer, or a composite layer.

The base layer 110 may have a multi-layer structure. For example, the base layer 110 may include a first synthetic resin layer, an inorganic layer having a multi-layer structure or a single-layer structure, and a second synthetic resin layer disposed on the inorganic layer having the multi-layer structure or the single-layer structure. Each of the first and second synthetic resin layers may include a polyimide-based resin, but is not particularly limited.

The circuit layer 120 may be disposed on the base layer 110. The circuit layer 120 may include an insulating layer, a semiconductor pattern, a conductive pattern, and a signal line.

The light emitting element layer 130 may be disposed on the circuit layer 120. The light emitting element layer 130 may include light emitting elements. For example, the light emitting elements may include an organic luminescent material, an inorganic luminescent material, an organic-inorganic luminescent material, a quantum dot, a quantum rod, a micro-LED, or a nano-LED.

The encapsulation layer 140 may be disposed on the light emitting element layer 130. The encapsulation layer 140 may protect the light emitting element layer 130 from foreign matter such as moisture, oxygen, and dust particles. The encapsulation layer 140 may include at least one inorganic layer. The encapsulation layer 140 may include a stacked structure of an inorganic layer/an organic layer/an inorganic layer.

The input sensor IS may be directly disposed on the display panel DP. The display panel DP and the input sensor IS may be formed through a continuous process. The expression "directly disposed" used herein may mean that a third component is not disposed between the input sensor IS and the display panel DP. That is, a separate adhesive layer may not be disposed between the input sensor IS and the display panel DP.

The anti-reflective layer ARL may be directly disposed on the input sensor IS. The anti-reflective layer ARL may decrease the reflectance of external light incident from outside the display device DD (refer to FIG. 1). The anti-reflective layer ARL may include color filters. The color filters may have a certain arrangement. For example, the color filters may be arranged in consideration of light emission colors of the pixels included in the display panel DP. In addition, the anti-reflective layer ARL may further include a black matrix adjacent to the color filters.

In an embodiment of the present disclosure, the position of the input sensor IS and the position of the anti-reflective layer ARL may be interchanged with each other. In an embodiment of the present disclosure, the anti-reflective layer ARL may be replaced with a polarizer film. The polarizer film may be coupled to the input sensor IS through an adhesive layer.

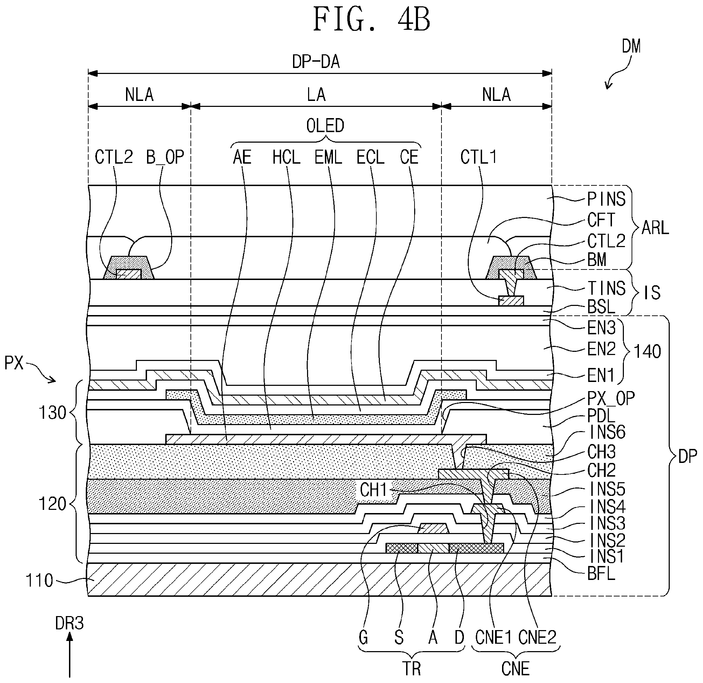

FIG. 4B is a view illustrating a section of the display module DM corresponding to any one pixel illustrated in FIG. 3.

Referring to FIG. 4B, the pixel PX may include a transistor TR and a light emitting element OLED. The light emitting element OLED may include a first electrode AE (or, an anode), a second electrode CE (or, a cathode), a hole control layer HCL, an electron control layer ECL, and an emissive layer EML.

The transistor TR and the light emitting element OLED may be disposed on the base layer 110. Although one transistor TR is illustrated as an example, the pixel PX may substantially include a plurality of transistors and at least one capacitor for driving the light emitting element OLED.

The display area DA may include an emissive area LA corresponding to each of the pixels PX and a non-emissive area NLA around the emissive area LA. The emissive layer EML of the light emitting element OLED may be disposed at least in the emissive area LA.

A buffer layer BFL may be disposed on the base layer 110. The buffer layer BFL may be an inorganic layer. A semiconductor pattern may be disposed on the buffer layer BFL. The semiconductor pattern may include poly silicon, amorphous silicon, or metal oxide.

The semiconductor pattern may be doped with an N-type dopant or a P-type dopant. The semiconductor pattern may include highly doped areas and a lightly doped area. The highly doped areas may have a higher conductivity than the lightly doped area and may substantially serve as a source electrode and a drain electrode of the transistor TR. The lightly doped area may substantially correspond to an active (or, channel) area of the transistor TR.

The source S, the active area A, and the drain D of the transistor TR may be formed from the semiconductor pattern. A first insulating layer INS1 may be disposed on the semiconductor pattern. A gate G of the transistor TR may be disposed on the first insulating layer INS1. A second insulating layer INS2 may be disposed on the gate G. A third insulating layer INS3 may be disposed on the second insulating layer INS2.

To connect the transistor TR and the light emitting element OLED, a connecting electrode CNE may include a first connecting electrode CNE1 and a second connecting electrode CNE2. The first connecting electrode CNE1 may be disposed on the third insulating layer INS3 and may be connected to the drain D through a first contact hole CH1 defined in the first to third insulating layers INS1 to INS3.

A fourth insulating layer INS4 may be disposed on the first connecting electrode CNE1. A fifth insulating layer INS5 may be disposed on the fourth insulating layer INS4. The second connecting electrode CNE2 may be disposed on the fifth insulating layer INS5. The second connecting electrode CNE2 may be connected to the first connecting electrode CNE1 through a second contact hole CH2 defined in the fourth and fifth insulating layers INS4 and INS5.

A sixth insulating layer INS6 may be disposed on the second connecting electrode CNE2. The layers from the buffer layer BFL to the sixth insulating layer INS6 may be defined as the circuit layer 120. The first to sixth insulating layers INS1 to INS6 may be inorganic layers or organic layers.

The first electrode AE may be disposed on the sixth insulating layer INS6. The first electrode AE may be connected to the second connecting electrode CNE2 through a third contact hole CH3 defined in the sixth insulating layer INS6. A pixel defining layer PDL having an opening PX_OP defined therein to expose a certain portion of the first electrode AE may be disposed on the first electrode AE and the sixth insulating layer INS6.

The hole control layer HCL may be disposed on the first electrode AE and the pixel defining layer PDL. The hole control layer HCL may include a hole transport layer and a hole injection layer.

The emissive layer EML may be disposed on the hole control layer HCL. The emissive layer EML may be disposed in an area corresponding to the opening PX_OP. The emissive layer EML may include an organic material and/or an inorganic material. The emissive layer EML may generate one of red light, green light, and blue light.

The electron control layer ECL may be disposed on the emissive layer EML and the hole control layer HCL. The electron control layer ECL may include an electron transport layer and an electron injection layer. The hole control layer HCL and the electron control layer ECL may be commonly disposed in the emissive area LA and the non-emissive area NLA.

The second electrode CE may be disposed on the electron control layer ECL. The second electrode CE may be commonly disposed for the pixels PX. The layer in which the light emitting element OLED is disposed may be defined as the light emitting element layer 130.

The encapsulation layer 140 may be disposed on the second electrode CE and may cover the pixel PX. The encapsulation layer 140 may include a first encapsulation layer EN1 disposed on the second electrode CE, a second encapsulation layer EN2 disposed on the first encapsulation layer EN1, and a third encapsulation layer EN3 disposed on the second encapsulation layer EN2.

The first and third encapsulation layers EN1 and EN3 may include inorganic insulating layers and may protect the pixel PX from moisture/oxygen. The second encapsulation layer EN2 may include an organic insulating layer and may protect the pixel PX from foreign matter such as dust particles.

A first voltage may be applied to the first electrode AE through the transistor TR, and a second voltage having a lower level than the first voltage may be applied to the second electrode CE. Holes and electrons injected into the emissive layer EML may be combined to form excitons, and as the excitons transition to a ground state, the light emitting element OLED may emit light.

The input sensor IS may be disposed on the encapsulation layer 140. The input sensor IS may be directly manufactured on the upper surface of the encapsulation layer 140.

A base layer BSL may be disposed on the encapsulation layer 140. The base layer BSL may include an inorganic insulating layer. At least one inorganic insulating layer may be provided on the encapsulation layer 140 as the base layer BSL.

The input sensor IS may include a first conductive pattern CTL1 and a second conductive pattern CTL2 disposed over the first conductive pattern CTL1. The first conductive pattern CTL1 may be disposed on the base layer BSL. An insulating layer TINS may be disposed on the base layer BSL to cover the first conductive pattern CTL1. The insulating layer TINS may include an inorganic insulating layer or an organic insulating layer. The second conductive pattern CTL2 may be disposed on the insulating layer TINS.

The first and second conductive patterns CTL1 and CTL2 may overlap the non-emissive area NLA. Although not illustrated, the first and second conductive patterns CTL1 and CTL2 may be disposed on the non-emissive area NLA between the emissive areas LA and may have a mesh shape.

The first and second conductive patterns CTL1 and CTL2 may form the above-described sensors of the input sensor IS. For example, the first and second conductive patterns CTL1 and CTL2 having a mesh shape may be separated from each other in a certain area to form the sensors. A portion of the second conductive pattern CTL2 may be connected to the first conductive pattern CTL1.

The anti-reflective layer ARL may be disposed on the second conductive pattern CTL2. In an embodiment, the anti-reflective layer ARL may include a black matrix BM and a plurality of color filters CFT. The black matrix BM may overlap the non-emissive area NLA, and the color filters CFT may overlap the emissive areas LA, respectively.

The black matrix BM may be disposed on the insulating layer TINS to cover the second conductive pattern CTL2. An opening B_OP overlapping the emissive area LA and the opening PX_OP may be defined in the black matrix BM. The black matrix BM may absorb and block light. The width of the opening B_OP may be greater than the width of the opening PX_OP.

The color filters CFT may be disposed on the insulating layer TINS and the black matrix BM. The color filters CFT may be disposed in the openings B_OP, respectively. A planarization insulating layer PINS may be disposed on the color filters CFT. The planarization insulating layer PINS may provide a flat upper surface.

When external light travelling toward the display panel DP is reflected from the display panel DP and provided back to the user, the user may visually recognize the external light as in a mirror. To prevent such a phenomenon, the anti-reflective layer ARL may include the plurality of color filters CFT that display the same colors as those of the pixels PX of the display panel DP. The color filters CFT may filter external light into the same colors as those of the pixels PX. In this case, the external light may not be visible to the user.

However, embodiments of the present disclosure are not limited thereto, and the anti-reflective layer ARL may include a polarizer film to decrease the reflectance of external light. The polarizer film may be separately manufactured and may be attached to the input sensor IS by an adhesive layer. The polarizer film may include a phase retarder and/or a polarizer.

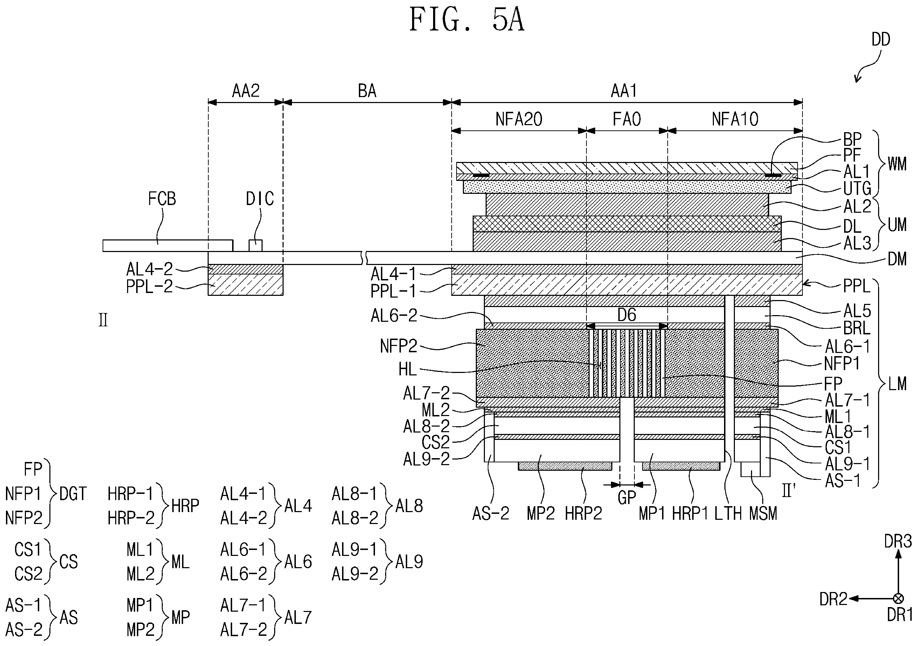

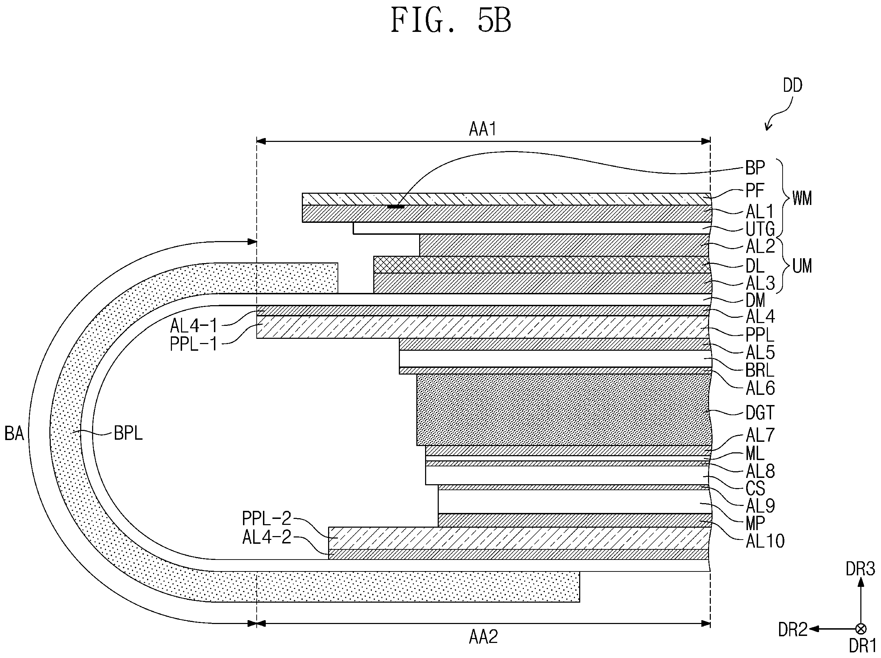

FIG. 5A is a cross-sectional view of the display device taken along line I-I' of FIG. 3 according to an embodiment of the present disclosure. FIG. 5B is a cross-sectional view of the bent display device DD according to an embodiment of the present disclosure. FIG. 5A illustrates an unfolded state in which the display module DM is not bent. FIG. 5B illustrates a state in which the bending area BA of the display module DM is bent.

Referring to FIGS. 5A and 5B, the display device DD includes the window WM, an upper member UM, the display module DM, and a lower member LM. Components disposed between the window WM and the display module DM are collectively referred to as the upper member UM, and components disposed under the display module DM are collectively referred to as the lower member LM.

The window WM may include a thin glass substrate UTG, a window protection layer PF disposed over the thin glass substrate UTG, and a bezel pattern BP disposed on the lower surface of the window protection layer PF. In this embodiment, the window protection layer PF may include a synthetic resin film. A functional layer may be disposed on the window protection layer PF.

The bezel pattern BP may be disposed on one surface of the thin glass substrate UTG or one surface of the window protection layer PF. FIG. 5A exemplarily illustrates the bezel pattern BP disposed on the lower surface of the window protection layer PF. However, without being limited thereto, the bezel pattern BZP may be disposed on the upper surface of the window protection layer PF. The bezel pattern BP may be a colored light-blocking film. For example, the bezel pattern BP may be formed by a coating method. The bezel pattern BP may include a base material and a dye or pigment mixed with the base material. The non-display area NDA illustrated in FIG. 1A may be defined by the shape of the bezel pattern BP.

The thin glass substrate UTG may have a thickness of 15 µm to 45 µm. The thin glass substrate UTG may be a chemically strengthened glass substrate. The occurrence of a crease in the thin glass substrate UTG may be minimized even though the thin glass substrate UTG is repeatedly folded and unfolded.

The window protection layer PF may have a thickness of 50 µm to 80 µm. The synthetic resin film of the window protection layer PF may include polyimide, polycarbonate, polyamide, triacetylcellulose, polymethylmethacrylate, or polyethylene terephthalate.

According to an embodiment, the window WM may further include a functional layer disposed on the upper surface of the window protection layer PF. The functional layer may include at least one of a hard coating layer, an anti-fingerprint layer, or an anti-reflective layer.

The window protection layer PF and the thin glass substrate UTG may be coupled by a first adhesive layer AL1. The first adhesive layer AL1 may be a pressure sensitive adhesive (PSA) film or an optically clear adhesive (OCA) member. Adhesive layers to be described below may also include the same adhesive as the first adhesive layer AL1.

The first adhesive layer AL1 may be separated from the thin glass substrate UTG. That is, the adhesive force between the first adhesive layer AL1 and the thin glass substrate UTG may be smaller than the adhesive force between the first adhesive layer AL1 and the window protection layer PF. Since the window protection layer PF is disposed over the thin glass substrate UTG, the window protection layer PF may be relatively easily scratched when compared to the thin glass substrate UTG. After the first adhesive layer AL1 and the window protection layer PF are separated, a new window protection layer PF may be attached to the thin glass substrate UTG.

The upper member UM includes an upper film DL. The upper film DL may include a synthetic resin film. The synthetic resin film may include polyimide, polycarbonate, polyamide, triacetylcellulose, polymethylmethacrylate, or polyethylene terephthalate.

The upper film DL may absorb external impact applied to the front side of the display device DD. The display module DM described with reference to FIG. 4 may include the anti-reflective layer ARL that replaces a polarizer film, and therefore the impact strength of the front side of the display device DD may be decreased. The upper film DL may compensate for the impact strength of the display device DD that is decreased by the application of the anti-reflective layer ARL. In an embodiment of the present disclosure, the upper film DL may be omitted. The thin glass substrate UTG and the upper film DL may be coupled by a second adhesive layer AL2. The upper film DL and the display module DM may be coupled by a third adhesive layer AL3.

The lower member LM may include a panel protection layer PPL, a barrier layer BRL, a digitizer DGT, a metal layer ML, a cushion layer CS, a metal plate MP, a heat radiating layer HRP, a magnetic field shielding sheet MSM, and a step compensation member AS. The components of the lower member LM other than the digitizer DGT may be defined as functional layers.

The panel protection layer PPL may be disposed under the display module DM. The panel protection layer PPL may protect the bottom of the display module DM. The panel protection layer PPL may include a flexible synthetic resin film. For example, the panel protection layer PPL may include polyethylene terephthalate.

In an embodiment, the panel protection layer PPL may not be disposed in the bending area BA. The panel protection layer PPL may include a first panel protection layer PPL-1 that protects the first non-bending area AA1 of the display panel DP (refer to FIG. 3) and a second panel protection layer PPL-2 that protects the second non-bending area AA2.

A fourth adhesive layer AL4 couples the panel protection layer PPL and the display module DM. The fourth adhesive layer AL4 may include a first portion AL4-1 corresponding to the first panel protection layer PPL-1 and a second portion AL4-2 corresponding to the second panel protection layer PPL-2.

As illustrated in FIG. 5B, the second panel protection layer PPL-2, together with the second non-bending area AA2, may be disposed under the first non-bending area AA1 and the first panel protection layer PPL-1 when the bending area BA is bent. Since the panel protection layer PPL is not disposed in the bending area BA, the bending area BA may be more easily bent. The second panel protection layer PPL-2 may be attached to the metal plate MP through a tenth adhesive layer AL10. The tenth adhesive layer AL10 may be omitted. Although not separately illustrated, an additional component such as an insulating tape may be further disposed between the second panel protection layer PPL-2 and the metal plate MP.

As illustrated in FIG. 5B, the bending area BA has a certain curvature and a certain radius of curvature. The radius of curvature may range from about 0.1 mm to about 0.5 mm. A bending protection layer BPL is disposed at least in the bending area BA. The bending protection layer BPL may overlap the bending area BA, the first non-bending area AA1, and the second non-bending area AA2. The bending protection layer BPL may be disposed on the entire bending area BA and may be disposed on a portion of the first non-bending area AA1 and a portion of the second non-bending area AA2.

The bending protection layer BPL may be bent together with the bending area BA. The bending protection layer BPL protects the bending area BA from external impact and controls the neutral plane of the bending area BA. The bending protection layer BPL controls stress of the bending area BA such that the neutral plane approaches signal lines disposed in the bending area BA.

The barrier layer BRL may be disposed under the panel protection layer PPL. The barrier layer BRL and the panel protection layer PPL may be coupled to each other by a fifth adhesive layer AL5.

The barrier layer BRL may increase resistance to a compressive force caused by external pressing. Accordingly, the barrier layer BRL may serve to prevent deformation of the display panel DP. The barrier layer BRL may include a flexible plastic material such as polyimide or polyethylene terephthalate. Furthermore, the barrier layer BRL may be a colored film having a low light transmittance. The barrier layer BRL may absorb light incident from the outside. For example, the barrier layer BRL may be a black synthetic resin film. The components disposed under the barrier layer BRL may not be visible to the user when the display device DD is viewed from above the window protection layer PF.

The sixth adhesive layer AL6 couples the barrier layer BRL and the digitizer DGT. The sixth adhesive layer AL6 may include a first portion AL6-1 and a second portion AL6-2 spaced apart from each other. The separation distance D6 (or, the gap) between the first portion AL6-1 and the second portion AL6-2 may correspond to the width of the folding area FA0 and may be greater than a gap GP that will be described below. The separation distance D6 between the first portion AL6-1 and the second portion AL6-2 may range from 5 mm to 15 mm.

In this embodiment, the first portion AL6-1 and the second portion AL6-2 are defined as different portions of one adhesive layer. However, the present disclosure is not limited thereto. When the first portion AL6-1 is defined as one adhesive layer (e.g., a first adhesive layer or a second adhesive layer), the second portion AL6-2 may be defined as another adhesive layer (e.g., the second adhesive layer or a third adhesive layer). The above-described definition may be applied not only to the sixth adhesive layer AL6 but also to adhesive layers including two portions among adhesive layers that will be described below.

The digitizer DGT according to the present disclosure may sense an input by an electromagnetic pen. In this case, the digitizer DGT may sense the input by the electromagnetic pen through a method using electromagnetic resonance (EMR).

The digitizer DGT may include a first non-folding part NFP1 overlapping the first non-folding area NFA10, a folding part FP overlapping the folding area FA0, and a second non-folding part NFP2 overlapping the second non-folding area NFA20. According to an embodiment, the folding part FP may include holes HL formed through the folding part FP in the third direction DR3. Since the holes HL are defined in the folding part FP, the shape of the digitizer DGT may be easily deformed in a folding operation of the display device DD. The components included in the digitizer DGT will be described below.

The metal layer ML may be disposed under the digitizer DGT. The metal layer ML may include a first metal layer ML1 and a second metal layer ML2 that overlap the first non-folding part NFP1 and the second non-folding part NFP2, respectively. The first metal layer ML1 and the second metal layer ML2 may each overlap a portion of the folding part FP and may be spaced apart from each other in an area overlapping the folding part FP.

The metal layer ML may release heat generated during operation of the digitizer DGT to the outside. The metal layer ML transfers the heat generated from the digitizer DGT to the lower side. The metal layer ML may have a higher electrical conductivity and a higher thermal conductivity than the metal plate MP that will be described below. The metal layer ML may include copper or aluminum. The metal layer ML having a relatively high electrical conductivity may prevent electromagnetic waves generated from the electronic modules EM (refer to FIG. 2A) disposed under the metal layer ML from affecting the digitizer DGT as noise.

A seventh adhesive layer AL7 may couple the digitizer DGT and the metal layer ML. The seventh adhesive layer AL7 may include a first portion AL7-1 and a second portion AL7-2 that correspond to the first metal layer ML1 and the second metal layer ML2, respectively.

The cushion layer CS may include a first cushion layer CS1 and a second cushion layer CS2 that overlap the first non-folding part NFP1 and the second non-folding part NFP2, respectively. The first cushion layer CS1 and the second cushion layer CS2 may each overlap a portion of the folding part FP and may be spaced apart from each other in an area overlapping the folding part FP.

The first cushion layer CS1 and the second cushion layer CS2 may prevent infiltration of foreign matter into the holes HL when the display device DD is folded. Even though the folding part FP is folded with a certain curvature when the display device DD is folded, the shape of the digitizer DGT may be easily deformed because the first cushion layer CS1 and the second cushion layer CS2 are spaced apart from each other in the area overlapping the folding part FP.

The cushion layer CS may be disposed under the metal layer ML. The cushion layer CS may protect the display module DM from impact transferred from below the display module DM. The cushion layer CS may include expanded foam or a sponge. The expanded foam may include polyurethane foam or thermoplastic polyurethane foam. When the cushion layer CS includes expanded foam, a barrier film may be added to the cushion layer CS as a base layer, and the cushion layer CS may be formed by causing a foaming agent to foam on the barrier film.

An eighth adhesive layer AL8 may couple the metal layer ML and the cushion layer CS. The eighth adhesive layer AL8 may include a first portion AL8-1 and a second portion AL8-2 that correspond to the first cushion layer CS1 and the second cushion layer CS2, respectively.

The metal plate MP may be disposed under the cushion layer CS. The metal plate MP may include a first metal plate MP1 and a second metal plate MP2 that overlap the first cushion layer CS1 and the second cushion layer CS2, respectively. The metal plate MP may absorb external impact applied from below. The metal plate MP may have a higher strength and a greater thickness than the metal layer ML. The metal plate MP may include a metallic material such as stainless steel.

A ninth adhesive layer AL9 couples the cushion layer CS and the metal plate MP. The ninth adhesive layer AL9 may include a first portion AL9-1 and a second portion AL9-2 that correspond to the first metal plate MP1 and the second metal plate MP2, respectively.

The heat radiating layer HRP may be disposed under the metal plate MP. The heat radiating layer HRP may include a first heat radiating layer HRP1 and a second heat radiating layer HRP2 that overlap the first metal plate MP1 and the second metal plate MP2, respectively. The heat radiating layer HRP releases heat generated from electronic parts disposed under the heat radiating layer HRP. The electronic parts may be the electronic modules EM illustrated in FIGS. 2A and 2B. The heat radiating layer HRP may have a structure in which adhesive layers and graphite layers are alternately stacked one above another. The heat radiating layer HRP may be attached to the metal plate MP through an additional adhesive layer disposed between the heat radiating layer HRP and the metal plate MP.

The magnetic-field shielding sheet MSM may be disposed under the metal plate MP. The magnetic-field shielding sheet MSM shields a magnetic field generated from a magnetic material (not illustrated) that is disposed under the magnetic-field shielding sheet MSM. The magnetic-field shielding sheet MSM may prevent the magnetic field generated from the magnetic material from interfering with the digitizer DGT.

The magnetic-field shielding sheet MSM includes a plurality of portions. At least some of the plurality of portions may have different thicknesses. The plurality of portions may be disposed to match steps of a bracket (not illustrated) that is located on a lower side of the display device DD. The magnetic-field shielding sheet MSM may have a structure in which magnetic-field shielding layers and adhesive layers are alternately stacked one above another. A portion of the magnetic-field shielding sheet MSM may be directly attached to the metal plate MP.

The step compensation member AS may be disposed under the metal layer ML. The step compensation member AS may be a double-sided tape or an insulating film. The step compensation member AS may include a first step compensation member AS-1 and a second step compensation member AS-2 and may compensate for steps caused by different widths of the components included in the lower member LM.

The functional layers of the lower member LM disposed under the first non-folding part NFP1 and the second non-folding part NFP2 are spaced apart from each other with the certain gap GP in the area overlapping the folding part FP. The gap GP may range from 0.3 mm to 3 mm.

A through-hole LTH may be formed through some of the members of the lower member LM. The through-hole LTH is disposed to overlap the sensing area DP-TA of FIG. 2A. As illustrated in FIG. 5A, the through-hole LTH may penetrate from the fifth adhesive layer AL5 to the metal plate MP. The through-hole LTH may correspond to a state in which a light blocking structure is removed on the path of an optical signal. The through-hole LTH may improve efficiency in receiving an optical signal by the electro-optical module ELM.

The display device DD according to an embodiment may not include at least one of the metal layer ML, the cushion layer CS, the metal plate MP, or the step compensation member AS and is not limited to any one embodiment.

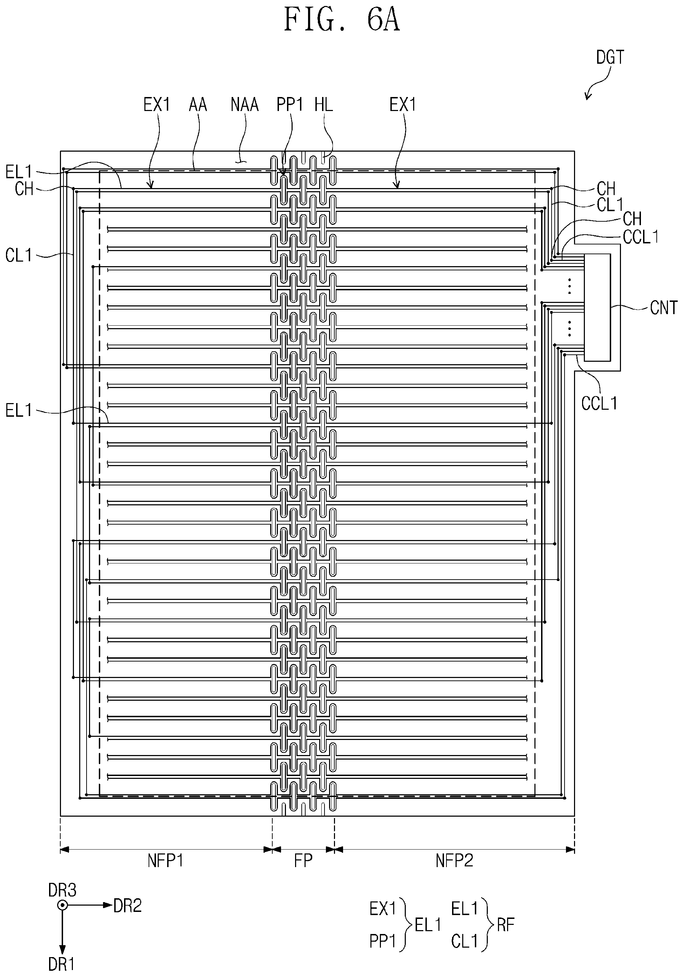

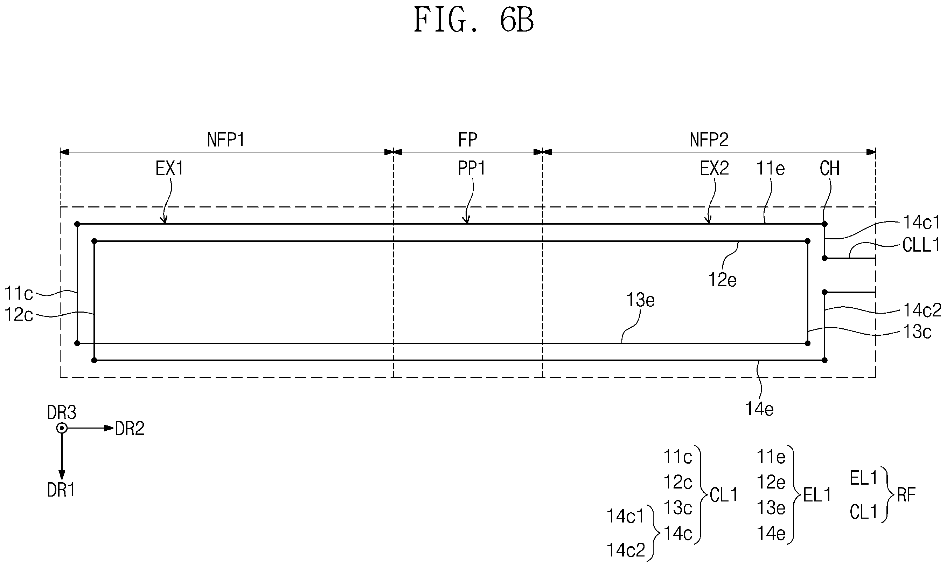

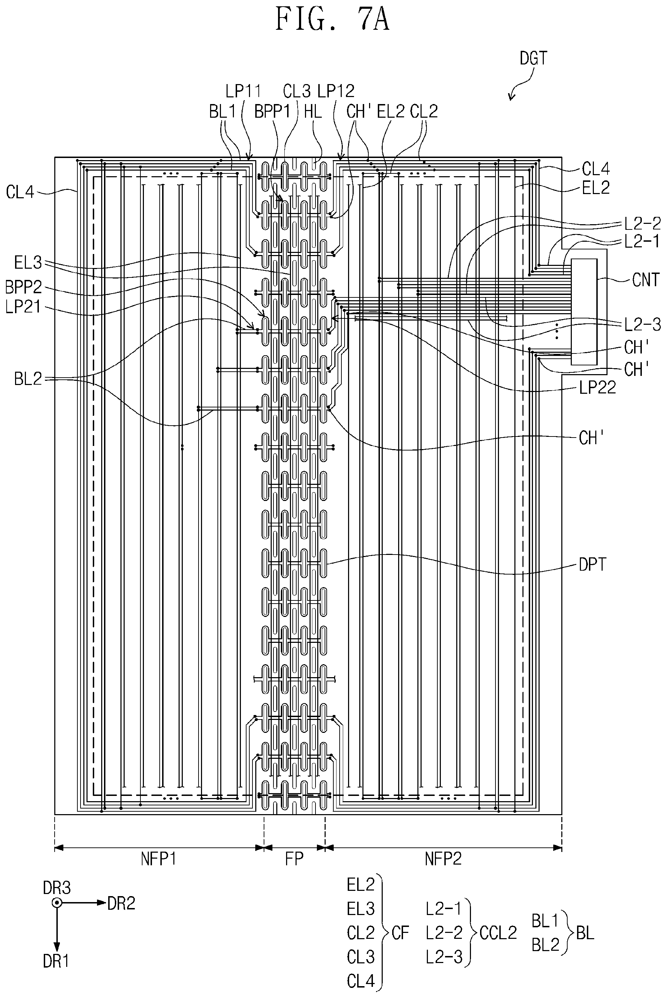

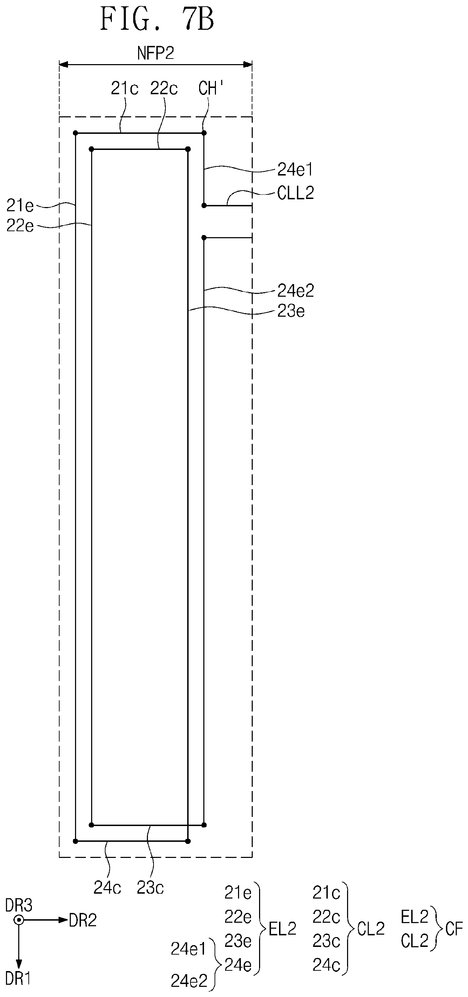

FIG. 6A is a plan view of the digitizer DGT illustrating first sensing coils RF of the digitizer DGT according to an embodiment of the present disclosure. FIG. 6B is a plan view illustrating the first sensing coil RF according to an embodiment of the present disclosure. FIG. 7A is a plan view of the digitizer DGT illustrating second sensing coils CF of the digitizer DGT according to an embodiment of the present disclosure. FIG. 7B is a plan view illustrating the second sensing coil CF according to an embodiment of the present disclosure.

Referring to FIG. 6A, the area of the digitizer DGT on the plane may include an active area AA and an inactive area NAA around the active area AA. The inactive area NAA may surround the active area AA. The active area AA may overlap the above-described display area DA, and the inactive area NAA may overlap the above-described non-display area NDA.

The digitizer DGT may include a connector CNT, a plurality of first connector connecting lines CCL1, and the plurality of first sensing coils RF. The connector CNT may be disposed on one side of the digitizer DGT. For example, the connector CNT may be disposed in the right inactive area NAA. The connector CNT may be disposed on the second non-folding part NFP2.

The first connector connecting lines CCL1 may be disposed in the right inactive area NAA. The first connector connecting lines CCL1 may extend in the second direction DR2. The first connector connecting lines CCL1 may be arranged in the first direction DR1 and may be connected to the connector CNT. The first sensing coils RF may be connected to the first connector connecting lines CCL1. The first sensing coils RF may be connected to the connector CNT through the first connector connecting lines CCL1.

The first sensing coils RF may be disposed in the inactive area NAA and the active area AA. The first sensing coils RF may extend from the second non-folding part NFP2 to the first non-folding part NFP1. The first sensing coils RF may extend through between the holes HL in the folding part FP. The first sensing coils RF may curvedly extend along the peripheries of the holes HL in the folding part FP.

The first sensing coils RF may extend to form an open loop shape. For example, the first sensing coils RF may extend from the right inactive area NAA to the left inactive area NAA through the active area AA and thereafter may extend from the left inactive area NAA to the right inactive area NAA through the active area AA to form an open loop shape. The first sensing coils RF may be connected to the first connector connecting lines CCL1 and may be connected to the connector CNT through the first connector connecting lines CCL1.

For example, some of the first sensing coils RF are illustrated in an open loop shape, and the other first sensing coils RF are illustrated as extending only in the second direction DR2 in the active area AA, with a loop shape omitted. However, this is illustrative, and the other first sensing coils RF may also extend in an open loop shape.

Each of the first sensing coils RF may include a plurality of sensing lines. The first sensing coil RF may include a plurality of first extending lines EL1 and a plurality of first connecting lines CL1. The first extending lines EL1 may be disposed in the active area AA. The first extending lines EL1 may extend in the second direction DR2 and may be arranged in the first direction DR1. For example, the first sensing coil RF may include at least a pair of first extending lines EL1, and the pair of first extending lines EL1 may extend parallel to each other in the second direction DR2.

The first extending lines EL1 of the first sensing coil RF may be disposed adjacent to each other in pairs in the active area AA and may extend parallel to each other in the second direction DR2. The first extending lines EL1 may extend through between the holes HL. The first extending lines EL1 may curvedly extend along the peripheries of the holes HL in the folding part FP.

The lengths of the first extending lines EL1 may be different from the lengths of the first connecting lines CL1. For example, the first extending lines EL1 may be longer than the first connecting lines CL1. However, embodiments of the present disclosure are not limited thereto.

The first connecting lines CL1 may be disposed in the inactive area NAA and may extend in the first direction DR1. For example, the first connecting lines CL1 may be disposed in the left and right inactive areas NAA. The first connecting lines CL1 may be connected to the first extending lines EL1. For example, the first connecting lines CL1 of the first sensing coil RF may be connected to the opposite ends of the first extending lines EL1 of the first sensing coil RF.

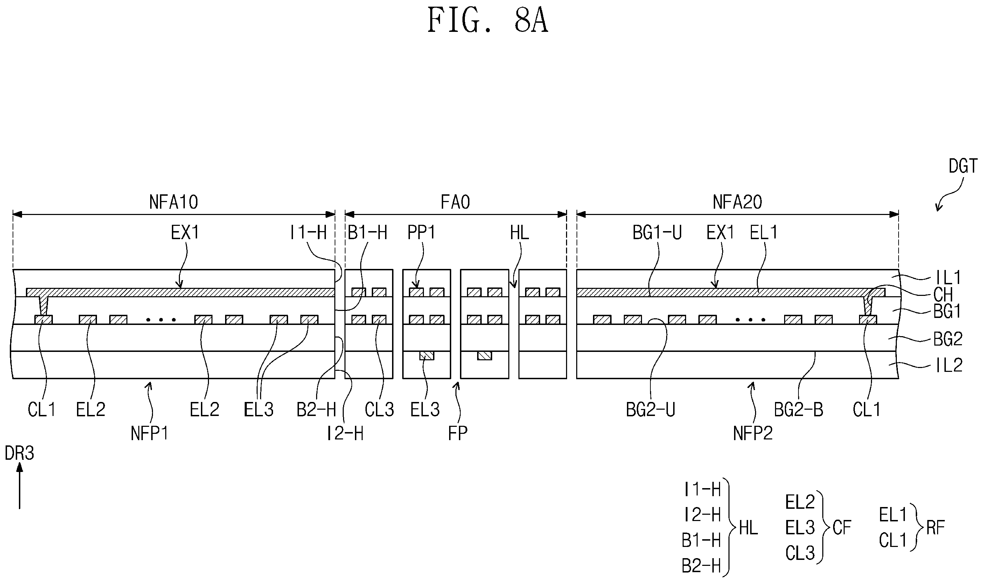

In an embodiment, the first extending lines EL1 may be disposed in a layer different from the layer in which the first connecting lines CL1 are disposed. For example, the first connecting lines CL1 may be disposed below the first extending lines EL1. The first connecting lines CL1 may be connected to the first extending lines EL1 through contact holes CH. This stacked configuration will be described below in detail with reference to FIGS. 8A to 9.

The first connector connecting lines CCL1 may be connected to the first connecting lines CL1 disposed in the right inactive area NAA. In an embodiment, the first connector connecting lines CCL1 may be disposed in the same layer as the first extending lines EL1 and may be disposed in a layer different from the layer in which the first connecting lines CL1 are disposed. The first connecting lines CL1 may be connected to the first connector connecting lines CCL1 through the contact holes CH. However, embodiments are not limited thereto, and the first connector connecting lines CCL1 may be disposed in the same layer as the first connecting lines CL1 and may be disposed in a layer different from the layer in which the first extending lines EL1 are disposed. Alternatively, the first connector connecting lines CCL1 may be disposed in a layer different from the layer in which the first connecting lines CL1 and the first extending lines EL1 are disposed. For example, the first connector connecting lines CCL1 may be disposed below the first connecting lines CL1 and the first extending lines EL1.

Each of the first extending lines EL1 may include first extensions EX1 disposed in the first and second non-folding parts NFP1 and NFP2, respectively, and a first pattern portion PP1 disposed in the folding part FP. The first extensions EX1 may extend in the second direction DR2 in the first and second non-folding parts NFP1 and NFP2. The first pattern portion PP1 may extend through between the holes HL. The first pattern portion PP1 may curvedly extend along the peripheries of the holes HL in the folding part FP. The first pattern portion PP1 may extend from the first extensions EX1. That is, in an embodiment of the present disclosure, the first pattern portion PP1 may be integrally formed with the first extensions EX1.

Meanwhile, each of the first sensing coils RF according to an embodiment of the present disclosure may be formed in an open loop shape wound twice. In FIG. 6B, one first sensing coil RF having an open loop shape wound twice and first connector lines CLL1 connected to the one first sensing coil RF are illustrated.

Referring to FIG. 6B, the first sensing coil RF may include the first extending lines EL1 and the first connecting lines CL1.

The first extending lines EL1 may include first-first, first-second, first-third, and first-fourth extending lines 11e, 12e, 13e, and 14e. The first-first to first-fourth extending lines 11e, 12e, 13e, and 14e may be sequentially arranged in the first direction DR1. Each of the first-first to first-fourth extending lines 11e, 12e, 13e, and 14e may include the first extensions EX1 disposed in the first and second non-folding parts NFP1 and NFP2, respectively, and the first pattern portion PP1 disposed in the folding part FP. In FIG. 6B, the first pattern portion PP1 is simply illustrated as extending in a straight-line shape in the second direction DR2. However, the first pattern portion PP1 may curvedly extend along the peripheries of the holes HL in the folding part FP.

The first connecting lines CL1 may include first-first, first-second, first-third, and first-fourth connecting lines 11c, 12c, 13c, and 14c. The first-first and first-second extending lines 11c and 12c may be sequentially arranged in the second direction DR2 in the first non-folding part NFP1. The first-third and first-fourth extending lines 13c and 14c may be sequentially arranged in the second direction DR2 in the second non-folding part NFP2.

The first-fourth connecting line 14c may include a first-first sub-line 14c1 and a first-second sub-line 14c2. The first-first sub-line 14c1 and the first-second sub-line 14c2 may each extend in the first direction DR1 and may be spaced apart from each other in the first direction DR1. The first-first sub-line 14c1 and the first-second sub-line 14c2 may be connected to a pair of corresponding first connector connecting lines CCL1 through contact holes CH, respectively.

The first-first sub-line 14c1 of the first-fourth connecting line 14c, the first-first extending line 11e, the first-first connecting line 11c, the first-third extending line 13e, the first-third connecting line 13c, the first-second extending line 12e, the first-second connecting line 12c, the first-fourth extending line 14e, and the first-second sub-line 14c2 of the first-fourth connecting line 14c may be sequentially connected to form an open loop shape wound twice.

Referring to FIG. 7A, the digitizer DGT may include the plurality of second sensing coils CF, a plurality of bridge lines BL, and a plurality of second connector connecting lines CCL2.

The second sensing coils CF may be connected to the second connector connecting lines CCL2, and the second connector connecting lines CCL2 may be connected to the connector CNT. The second sensing coils CF may be connected to the connector CNT through the second connector connecting lines CCL2. Some of the second sensing coils CF may be connected with the bridge lines BL and may be connected to the second connector connecting lines CCL2 through the bridge lines BL.

The second sensing coils CF may extend to form an open loop shape. For example, the second sensing coils CF may extend from the upper inactive area NAA to the lower inactive area NAA through the active area AA and thereafter may extend from the lower inactive area NAA to the upper inactive area NAA through the active area AA to form an open loop shape. The second sensing coils CF may be connected to the second connector connecting lines CCL2 and may be connected to the connector CNT through the second connector connecting lines CCL2. In an embodiment, some of the second sensing coils CF may be connected to the second connector connecting lines CCL2 through first bridge lines BL1 and may be connected to the connector CNT through the first bridge lines BL1 and the second connector connecting lines CCL2.

For example, some of the second sensing coils CF are illustrated in a loop shape, and the other second sensing coils CF are illustrated as extending in the first direction DR1 in the active area AA, with a loop shape omitted. However, this is illustrative, and the other second sensing coils CF may also extend in an open loop shape.

The bridge lines BL may include the plurality of first bridge lines BL1 and a plurality of second bridge lines BL2. In FIG. 7A, some of the first bridge line BL1 and some of the second bridge lines BL2 are omitted.

The first bridge lines BL1 may be adjacent to the upper side and the lower side of the digitizer DGT in the first direction DR1. The second bridge lines BL2 may be disposed between the first bridge lines BL1 adjacent to the upper side of the digitizer DGT and the first bridge lines BL1 adjacent to the lower side of the digitizer DGT.

The first bridge lines BL1 may include first-first bridge line portions LP11, first-second bridge line portions LP12, and first bridge pattern portions BPP1. The first-first and first-second bridge line portions LP11 and LP12 may be adjacent to the holes HL. The first-first bridge line portions LP11 may be disposed in an area of the first non-folding part NFP1 that is adjacent to the folding part FP. The first-second bridge line portions LP12 may be disposed in an area of the second non-folding part NFP2 that is adjacent to the folding part FP. The first bridge pattern portions BPP1 may be disposed in the folding part FP. The first bridge pattern portions BPP1 may extend through between the holes HL in the folding part FP. The first bridge pattern portions BPP1 may curvedly extend along the peripheries of the holes HL in the folding part FP. The first bridge pattern portions BPP1 may connect the first-first bridge line portions LP11 and the first-second bridge line portions LP12. Each of the first bridge lines BL1 may include the first-first bridge line portion LP11, the first bridge pattern portion BPP1, and the first-second bridge line portion LP12 connected together.

The second bridge lines BL2 may include second-first bridge line portions LP21, second-second bridge line portions LP22, and second bridge pattern portions BPP2. The second-first and second-second bridge line portions LP21 and LP22 may be adjacent to the holes HL. The second-first bridge line portions LP21 may be disposed in an area of the first non-folding part NFP1 that is adjacent to the folding part FP. The second-second bridge line portions LP22 may be disposed in an area of the second non-folding part NFP2 that is adjacent to the folding part FP. The second bridge pattern portions BPP2 may be disposed in the folding part FP. The second bridge pattern portions BPP2 may extend through between the holes HL in the folding part FP. The second bridge pattern portions BPP2 may curvedly extend along the peripheries of the holes HL in the folding part FP. The second bridge pattern portions BPP2 may connect the second-first bridge line portions LP21 and the second-second bridge line portions LP22. Each of the second bridge lines BL2 may include the second-first bridge line portion LP21, the second bridge pattern portion BPP2, and the second-second bridge line portion LP22 connected together.

In an embodiment, the bridge lines BL may be disposed in the same layer as some of the second sensing coils CF. However, embodiments are not limited thereto, and the bridge lines BL may be disposed below the second sensing coils CF.

In an embodiment, the first-first to second-second bridge line portions LP11, LP12, LP21, and LP22 and the first and second bridge pattern portions BPP1 and BPP2 may be disposed on different layers and may be connected through contact holes CH'. However, embodiments are not limited thereto. The first-first to second-second bridge line portions LP11, LP12, LP21, and LP22 and the first and second bridge pattern portions BPP1 and BPP2 may be disposed on the same layer, and the first and second bridge lines BL1 and BL2 may each continuously extend.

The second sensing coils CF may include non-folding coils disposed in the first non-folding part NFP1 or the second non-folding part NFP2 and folding coils at least partially disposed in the folding part FP. The second sensing coils CF may include a plurality of second extending lines EL2, a plurality of third extending lines EL3, a plurality of second connecting lines CL2, a plurality of third connecting lines CL3, and a plurality of fourth connecting lines CL4.

Each of the non-folding coils may include a plurality of sensing lines. The sensing lines of the non-folding coil may include the plurality of second extending lines EL2, the plurality of second connecting lines CL2, and the plurality of fourth connecting lines CL4. Each of the folding coils may include a plurality of sensing lines. The sensing lines of the folding coil may include the plurality of third extending lines EL3 and the plurality of third connecting lines CL3.

The second extending lines EL2 may be disposed at least in the active area AA. The second extending lines EL2 may extend in the first direction DR1 and may be arranged in the second direction DR2. The second extending lines EL2 may be disposed in the first and second non-folding part NFP1 and NFP2. The second extending lines EL2 may be disposed adjacent to each other in pairs and may extend parallel to each other in the first direction DR1.

Some of the third extending lines EL3 may be disposed in the folding part FP, and the other third extending lines EL3 may be disposed in the first and second non-folding parts NFP1 and NFP2 adjacent to the folding part FP. The third extending lines EL3 disposed in the folding part FP may extend through between the adjacent holes HL in the second direction DR2. The other third extending lines EL3 may be closer to the holes HL than the second extending lines EL2. The third extending lines EL3 may be disposed adjacent to each other in pairs and may extend parallel to each other in the first direction DR1.

The second extending lines EL2 and the third extending lines EL3 may be disposed below the first extending lines EL1. That is, in the active area AA, the second sensing coils CF may be disposed below the first sensing coils RF (refer to FIG. 6A). In an embodiment, the second extending lines EL2 may be disposed in the same layer as the first connecting lines CL1.

The second connecting lines CL2 may be disposed in the inactive area NAA and may extend in the second direction DR2. For example, the second connecting lines CL2 may be disposed in the upper and lower inactive areas NAA. In an embodiment, the second connecting lines CL2 may be disposed in the same layer as the first extending lines EL1 (refer to FIG. 6A).

The second connecting lines CL2 may be connected to the opposite ends of the second extending lines EL2 through the contact holes CH'. Some of the second connecting lines CL2 may be connected to the first bridge lines BL1 through the contact holes CH'.

At least a portion of each of the third connecting lines CL3 may be disposed in the folding part FP. The third connecting lines CL3 may extend through between the holes HL. The third connecting lines CL3 may curvedly extend along the peripheries of the holes HL. Although not illustrated in FIG. 7A, the third connecting lines CL3 may be connected to the opposite ends of the third extending lines EL3. The arrangement and connection relationship of the third connecting lines CL3 and the third extending lines EL3 will be described below.

The fourth connecting lines CL4 may be disposed in the inactive area NAA and may extend in the first direction DR1. The fourth connecting lines CL4 may be disposed in the left and right inactive areas NAA.

The fourth connecting lines CL4 disposed in the right inactive area NAA may be connected, through the contact holes CH', to the second connecting lines CL2 disposed in the second non-folding part NFP2. The fourth connecting lines CL4 disposed in the left inactive area NAA may be connected, through the contact holes CH', to the second connecting lines CL2 disposed in the first non-folding part NFP1.

The second connector connecting lines CCL2 may be connected to the connector CNT and may extend in the second direction DR2. Some of the second connector connecting lines CCL2 may be connected to the second connecting lines CL2, and other second connector connecting lines CCL2 may extend to the active area AA and may be connected to some of the second extending lines EL2 and some of the third extending lines EL3. In an embodiment, the second connector connecting lines CCL2 may be disposed in the same layer as the above-described first extending lines EL1 (refer to FIG. 6A). However, embodiments are not limited thereto, and the second connector connecting lines CCL2 may be disposed below the first extending lines EL1 (refer to FIG. 6A) and the second extending lines EL2.

The second connector connecting lines CCL2 may include a plurality of second-first lines L2-1, a plurality of second-second lines L2-2, and a plurality of second-third lines L2-3. The second-first lines L2-1 may be disposed in the right inactive area NAA. The second-first lines L2-1 may be connected to the fourth connecting lines CL4 through the contact holes CH'. The second-first lines L2-1 may be connected to the second connecting lines CL2 through the fourth connecting lines CL4.

The second-second lines L2-2 may be disposed in the second non-folding part NFP2. Some of the second-second lines L2-2 may extend to the active area AA and may be connected to some of the second extending lines EL2 through the contact holes CH'. The some of the second-second lines L2-2 may be connected to some of the second extending lines EL2 disposed in the active area AA. In addition, although not illustrated, the other second-second lines L2-2 may extend to the active area AA and may be connected to some of the third extending lines EL3 through the contact holes CH'.

The second-third lines L2-3 may be disposed in the second non-folding part NFP2. The second-third lines L2-3 may extend to the active area AA. In the active area AA, the second-third lines L2-3 may be connected to the second bridge lines BL2 through the contact holes CH'. A pair of second-third lines L2-3 may be connected to a corresponding pair of second bridge lines BL2.

In an embodiment, a plurality of dummy pattern portions DPT may be disposed between the holes HL where the first and second bridge pattern portions BPP1 and BPP2 and the third connecting lines CL3 are not disposed. The dummy pattern portions DPT may be insulated from neighboring conductors and may be in a floating state. However, in some embodiments, the dummy pattern portions DPT may be omitted.

Meanwhile, each of the second sensing coils CF according to an embodiment of the present disclosure may be formed in an open loop shape wound twice. In FIG. 7B, one second sensing coil CF having an open loop shape wound twice and second connector lines CLL2 connected to the one second sensing coil CF are illustrated. In FIG. 7B, the second sensing coil CF (or, the non-folding coil) disposed in the second non-folding part NFP2 is illustrated.

Referring to FIG. 7B, the second sensing coil CF may include the second extending lines EL2 and the second connecting lines CL2.

The second extending lines EL2 may include second-first, second-second, second-third, and second-fourth extending lines 21e, 22e, 23e, and 24e. The second-first, second-second, second-third, and second-fourth extending lines 21e, 22e, 23e, and 24e may be sequentially arranged in the second direction DR2.

The second connecting lines CL2 may include second-first, second-second, second-third, and second-fourth connecting lines 21c, 22c, 23c, and 24c. The second-first and second-second connecting lines 21c and 22c may be sequentially arranged in the first direction DR1. The second-third and second-fourth connecting lines 23c and 24c may be sequentially arranged in the first direction DR1.

The second-fourth extending line 24e may include a second-first sub-line 24e1 and a second-second sub-line 24e2. The second-first sub-line 24e1 and the second-second sub-line 24e2 may each extend in the first direction DR1 and may be spaced apart from each other in the first direction DR1. The second-first sub-line 24e1 and the second-second sub-line 24e2 may be connected to a pair of corresponding second connector connecting lines CCL2 through contact holes CH', respectively. Meanwhile, in the case of the second sensing coil CF disposed in the first non-folding part NFP1 (refer to FIG. 7A), the second-first sub-line 24e1 and the second-second sub-line 24e2 may be connected to a pair of corresponding second bridge lines BL2 (refer to FIG. 7A) through contact holes CH', respectively.

The second-first sub-line 24e1 of the second-fourth extending line 24e, the second-first connecting line 21c, the second-first extending line 21e, the second-fourth connecting line 24c, the second-third extending line 23e, the second-second connecting line 22c, the second-second extending line 22e, the second-third connecting line 23c, and the second-second sub-line 24e2 of the second-fourth extending line 24e may be sequentially connected to form an open loop shape wound twice.

Referring to FIGS. 6A to 7B, in an embodiment of the present disclosure, the second sensing coils CF may be defined as drive coils, and the first sensing coils RF may be defined as sensing coils. However, the present disclosure is not limited thereto. In contrast, the second sensing coils CF may be defined as sensing coils, and the first sensing coils RF may be defined as drive coils. When an electric current flows through the second sensing coils CF, lines of magnetic force may be induced between the second sensing coils CF and the first sensing coils RF. The first sensing coils RF may sense an induced electromagnetic force released from the electromagnetic pen and may output the sensed induced electromagnetic force to terminals of the first sensing coils RF as a sensing signal.

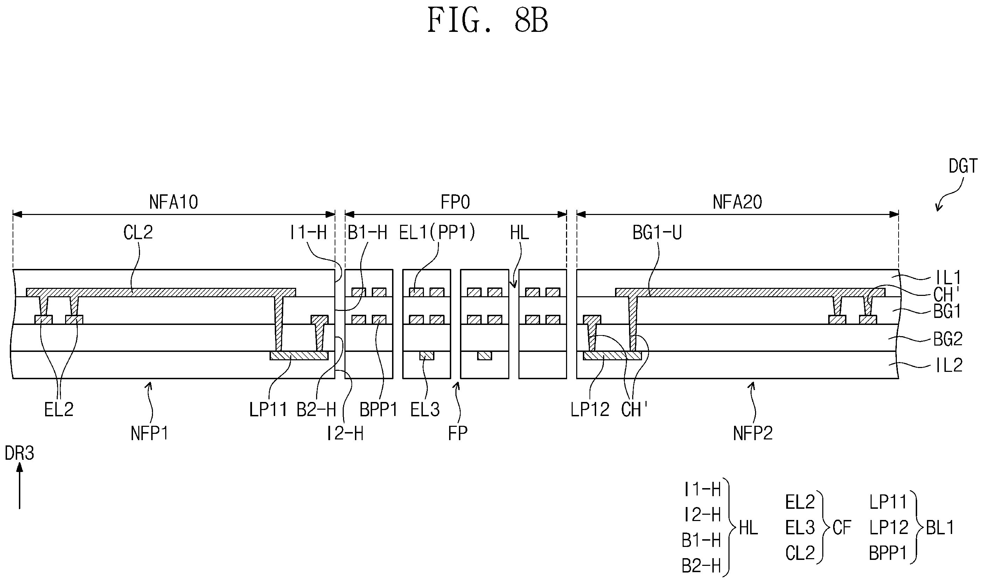

FIG. 8A is a cross-sectional view of the digitizer DGT according to an embodiment of the present disclosure. FIG. 8B is a cross-sectional view of the digitizer DGT according to an embodiment of the present disclosure. Components identical/similar to the components described with reference to FIGS. 5A to 7B will be assigned with identical/similar reference numerals, and repetitive descriptions will be omitted.

Referring to FIG. 8A, the digitizer DGT according to an embodiment may include the first non-folding part NFP1 overlapping the first non-folding area NFA10, the second non-folding part NFP2 overlapping the second non-folding area NFA20, and the folding part FP overlapping the folding area FA0. The folding part FP may have the plurality of holes HL defined therein.

The digitizer DGT according to an embodiment may include a first base layer BG1, a second base layer BG2, the first sensing coils RF, the second sensing coils CF, the bridge lines BL (refer to FIG. 7A), a first cover layer IL1, and a second cover layer IL2. In FIG. 8A, the first bridge line BL1 among the bridge lines BL (refer to FIG. 7A) is representatively illustrated. The first sensing coils RF, the second sensing coils CF, and the bridge lines BL (refer to FIG. 7A) may include copper.

The second base layer BG2 may be disposed under the first base layer BG1. The first cover layer IL1 may be disposed on the first base layer BG1, and the second cover layer IL2 may be disposed under the second base layer BG2. A first base hole B1-H may be defined to penetrate the front surface and the rear surface of the first base layer BG1. A second base hole B2-H may be defined to penetrate the front surface and the rear surface of the second base layer BG2. A first cover hole I1-H may be defined to penetrate the front surface and the rear surface of the first cover layer IL1. A second cover hole I2-H may be defined to penetrate the front surface and the rear surface of the second cover layer IL2.

Each of the holes HL defined in the folding part FP may be formed by a corresponding first base hole B1-H, a corresponding second base hole B2-H, a corresponding first cover hole I1-H, and a corresponding second cover hole I2-H aligned in the third direction DR3. Accordingly, the inner surfaces that define the first base hole B1-H, the second base hole B2-H, the first cover hole I1-H, and the second cover hole I2-H may be aligned in the third direction DR3.

At least portions of the first extending lines EL1 of the first sensing coil RF may be disposed on the upper surface BG1-U of the first base layer BG1. At least portions of the first connecting lines CL1 of the first sensing coil RF may be disposed on the upper surface BG2-U of the second base layer BG2. The first extending line EL1 and the first connecting line CL1 of the first sensing coil RF may be connected through the contact hole CH penetrating the first base layer BG1.

At least portions of the second extending lines EL2 of the second sensing coil CF may be disposed on the upper surface BG2-U of the second base layer BG2. At least portions of the second connecting lines CL2 of the second sensing coil CF may be disposed on the upper surface BG1-U of the first base layer BG1. The second extending line EL2 and the second connecting line CL2 of the second sensing coil CF may be connected through the contact hole CH' penetrating the first base layer BG1.

The third extending lines EL3 of the second sensing coil CF disposed in the non-folding parts NFP1 and NFP2 may be disposed on the upper surface BG2-U of the second base layer BG2, and the third extending lines EL3 disposed in the folding part FP may be disposed on the lower surface BG2-B of the second base layer BG2. At least portions of the third connecting lines CL3 of the second sensing coil CF may be disposed on the upper surface BG2-U of the second base layer BG2.

Meanwhile, the arrangement of the first extending lines EL1 and the third connecting lines CL3 passing through the folding part FP is not limited to that illustrated in FIGS. 8A and 8B. Various embodiments regarding this will be described below.

The first-first and first-second bridge line portions LP11 and LP12 of the first bridge line BL1 may be disposed on the lower surface BG2-B of the second base layer BG2. The first bridge pattern portion BPP1 of the first bridge line BL1 may be disposed on the upper surface BG2-U of the second base layer BG2. The first-first and first-second bridge line portions LP11 and LP12 and the first bridge pattern portion BPP1 may be connected through the contact hole CH' defined to penetrate the second base layer BG2. The first-first and first-second bridge line portions LP11 and LP12 may be connected to the second connecting line CL2 through the contact hole CH' defined to penetrate the first and second base layers BG1 and BG2.

Although the second bridge line BL2 (refer to FIG. 7A) is not illustrated in FIGS. 8A and 8B, the second-first and second-second bridge line portions LP21 and LP22 (refer to FIG. 7A) and the second bridge pattern portion BPP2 (refer to FIG. 7A) of the second bridge line BL2 (refer to FIG. 7A) may be disposed on the same layers as the first-first and first-second bridge line portions LP11 and LP12 and the first bridge pattern portion BPP1 of the first bridge line BL1, respectively.

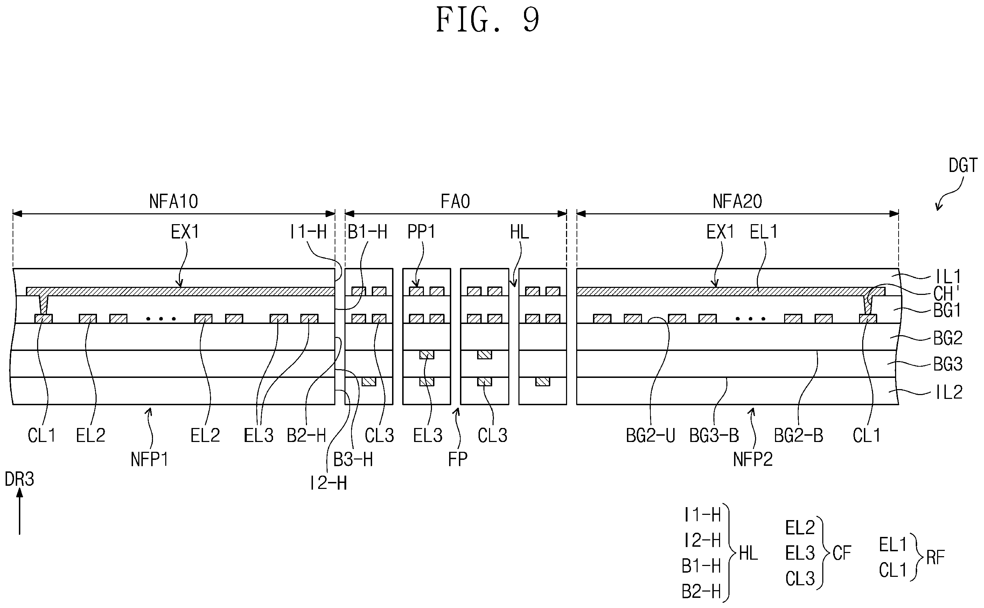

FIG. 9 is a cross-sectional view of the digitizer DGT according to an embodiment of the present disclosure. Components identical/similar to the components described with reference to FIGS. 5A to 8B will be assigned with identical/similar reference numerals, and repetitive descriptions will be omitted.

Referring to FIG. 9, the digitizer DGT according to an embodiment may include the first base layer BG1, the second base layer BG2, a third base layer BG3, the first cover layer IL1, and the second cover layer IL2. The third base layer BG3 may be disposed under the second base layer BG2, and the second cover layer IL2 may be disposed under the third base layer BG3. A third base hole B3-H may be defined to penetrate the front surface and the rear surface of the third base layer BG3.

Each of the holes HL defined in the folding part FP may be formed by the corresponding first base hole B1-H, the corresponding second base hole B2-H, a corresponding third base hole B3-H, the corresponding first cover hole I1-H, and the corresponding second cover hole I2-H aligned in the third direction DR3. Accordingly, the inner surfaces that define the first base hole B1-H, the second base hole B2-H, the third base hole B3-H, the first cover hole I1-H, and the second cover hole I2-H may be aligned in the third direction DR3.

According to this embodiment, some of the third connecting lines CL3 may be disposed on the upper surface BG2-U of the second base layer BG2, and the other third connecting lines CL3 may be disposed on the lower surface BG3-B of the third base layer BG3. Accordingly, as compared with when the third connecting lines CL3 are all disposed in the same layer, the third connecting lines CL3 may be prevented from being densely arranged and may not be provided in the form of a bypass path to pass through the folding part FP having a space limitation.

Meanwhile, although not illustrated, according to an embodiment of the present disclosure, some of the first extending lines EL1 may be disposed on the upper surface BG1-U of the first base layer BG1, and the other first extending lines EL1 may be disposed on the lower surface BG3-B of the third base layer BG3.

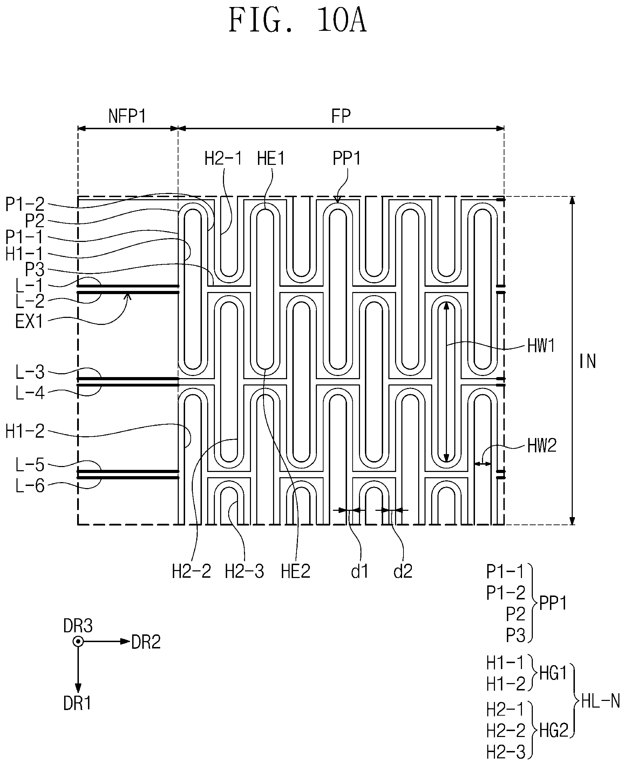

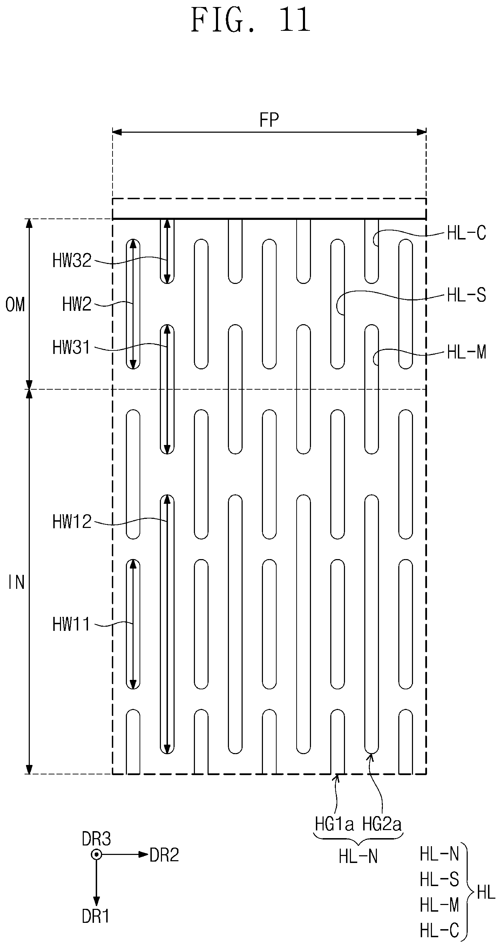

FIGS. 10A to 10C illustrate portions of the long sides (or, the first extending lines EL1 (refer to FIG. 6A)) of the first sensing coils RF (refer to FIG. 6A). FIG. 11 is an enlarged plan view illustrating some of the holes HL defined in the digitizer DGT according to an embodiment of the present disclosure. Components identical/similar to the components described with reference to FIGS. 5A to 8B will be assigned with identical/similar reference numerals, and repetitive descriptions will be omitted.

Referring to FIGS. 10A to 11, the folding part FP of the digitizer DGT in this embodiment may include an outer portion OM and an inner portion IN. The outer portion OM may be a portion disposed outward of the inner portion IN based on the first direction DR1. A plurality of outer portions OM may be provided. The outer portions OM may be disposed at the upper end and the lower end of the folding part FP. For convenience of description, only the outer portion OM disposed at the upper end of the folding part FP is illustrated in FIG. 11. However, description of FIG. 11 may be applied to the outer portion OM disposed at the lower end of the folding part FP.

FIGS. 10A to 10C illustrate some of the first sensing coils RF. FIGS. 10A to 10C illustrate enlarged views of portions of the first extending lines EL1 of the first sensing coils RF disposed in the inner portion IN of the folding part FP and the first non-folding part NFP1 adjacent thereto.

In FIG. 10A, only six lines (hereinafter, referred to as the first to sixth lines L-1 to L-6) sequentially arranged among the first extending lines EL1 are illustrated, and portions of the first extensions EX1 of the lines disposed in the first non-folding part NFP1 and the first pattern portions PP1 disposed in the folding part FP are illustrated.

Referring to FIG. 10A, the first to sixth lines L-1 to L-6 may each extend in the second direction DR2 and may be sequentially arranged in the first direction DR1. For example, on the plane, the first and second lines L-1 and L-2 may be disposed adjacent to each other, the third and fourth lines L-3 and L-4 may be disposed adjacent to each other, and the fifth and sixth lines L-5 and L-6 may be disposed adjacent to each other.

The separation distance between the second line L-2 and the third line L-3 in the first direction DR1 may be greater than the separation distance between the first line L-1 and the second line L-2 in the first direction DR1. In addition, the separation distance between the fourth line L-4 and the fifth line L-5 in the first direction DR1 may be greater than the separation distance between the third line L-3 and the fourth line L-4 in the first direction DR1.

In this embodiment, first holes HL-N disposed in the inner portion IN of the folding part FP may include first group holes HG1 and second group holes HG2. For example, the first group holes HG1 may include a first-first hole H1-1 and a first-second hole H1-2 that extend in the first direction DR1 and that are arranged in the first direction DR1. The second group holes HG2 may be spaced apart from the first group holes HG1 in the second direction DR2. The second group holes HG2 may include a second-first hole H2-1, a second-second hole H2-2, and a second-third hole H2-3 that extend in the first direction DR1 and that are arranged in the first direction DR1. The first group holes HG1 and the second group holes HG2 may be provided in plural numbers and may be alternately arranged in the second direction DR2 in the folding part FP.

In this embodiment, the second group hole HG2 may be shifted from the first group hole HG1 by a certain distance in the first direction DR1. The remaining portion of the folding part FP other than the first holes HL-N may have a grid-patterned slit shape.

Each of the first pattern portions PP1 may include a first-first pattern P1-1, a first-second pattern P1-2, a second pattern P2, and a third pattern P3.

The first-first pattern P1-1 and the first-second pattern P1-2 may each extend in the first direction DR1 and may be spaced apart from each other in the second direction DR2 with one corresponding hole HL therebetween. The second pattern P2 may be connected to one end of the first-first pattern P1-1 and one end of the first-second pattern P1-2 and may connect the first-first pattern P1-1 and the first-second pattern P1-2. The second pattern P2 may extend along an end of the hole HL. The second pattern P2 may extend in a curved shape.

One end of the third pattern P3 may be connected to an opposite end of the first-second pattern P1-2, and an opposite end of the third pattern P3 may be connected to an opposite end of a first-first pattern P1-1 of the first pattern portion PP1. In an embodiment, the third pattern P3 may extend in a straight-line shape in the second direction DR2.

The first pattern portion PP1 of the first line L-1 and the first pattern portion PP1 of the second line L-2 may have symmetrical shapes with respect to a virtual line extending in the second direction DR2.

According to this embodiment, on the plane, four or fewer lines may be disposed between the first holes HL-N adjacent to each other in the first direction DR1, and two or fewer lines may be disposed between the first holes HL-N adjacent to each other in the second direction DR2. Meanwhile, this description may be identically applied not only to the first holes HL-N but also to holes disposed in the outer portion OM (refer to FIG. 11) that will be described below.

Each of the first holes HL-N may include a first end HE1 and a second end HE2 spaced apart from each other in the first direction DR1. Each of the first holes HL-N may have a width HW1 of 4 mm to 10 mm in the first direction DR1. Each of the holes HL may have a width HW2 of 0.1 mm to 0.5 mm in the second direction DR2.

In an embodiment, the distance d1 between a line and the first hole HL-N adjacent to each other may be less than or equal to 100 µm, more preferably, less than 75 µm. The distance d2 between lines adjacent to each other may be less than or equal to 50 µm, and more preferably, may range from 20 µ to 40 µm. The thickness (or, width) of each line may range from 40 µm to 200 µm.

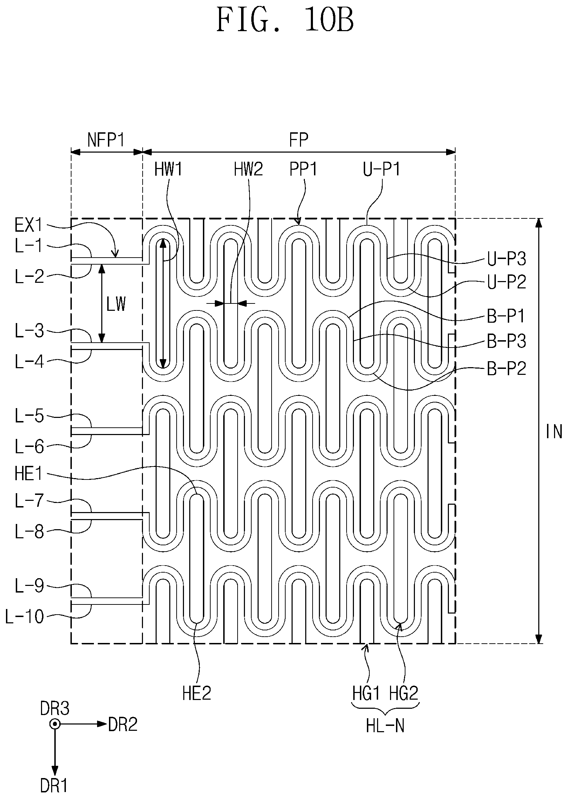

In FIG. 10B, only ten lines (hereinafter, referred to as the first to tenth lines L-1 to L-10) sequentially arranged among the first extending lines EL1 are illustrated, and portions of the first extensions EX1 disposed in the first non-folding part NFP1 and the first pattern portions PP1 disposed in the folding part FP are illustrated.

Referring to FIG. 10B, the first to tenth lines L-1 to L-10 may each extend in the second direction DR2 and may be sequentially arranged in the first direction DR1. For example, on the plane, the first and second lines L-1 and L-2 may be disposed adjacent to each other, the third and fourth lines L-3 and L-4 may be disposed adjacent to each other, and the fifth and sixth lines L-5 and L-6 may be disposed adjacent to each other. The seventh and eighth lines L-7 and L-8 may be disposed adjacent to each other, and the ninth and tenth lines L-9 and L-10 may be disposed adjacent to each other.

According to an embodiment, in the first direction DR1, the distance between the first line L-1 and the second line L-2, the distance between the third line L-3 and the fourth line L-4, the distance between the fifth line L-5 and the sixth line L-6, the distance between the seventh line L-7 and the eighth line L-8, and the distance between the ninth line L-9 and the tenth line L-10 (hereinafter, defined as the first distance) may be the same. According to an embodiment, the first distance may remain constant in the first non-folding part NFP1, the folding part FP, and the second non-folding part NFP2 (refer to FIG. 6A). The first distance may range from 20 µm to 40 µm.

In the first direction DR1, the distance between the second line L-2 and the third line L-3, the distance between the fourth line L-4 and the fifth line L-5, the distance between the sixth line L-6 and the seventh line L-7, and the distance between the eighth line L-8 and the ninth line L-9 (hereinafter, defined as the second distance LW) may be the same. The second distance LW may be greater than the first distance.

Meanwhile, according to an embodiment, the second distance LW between the second line L-2 and the third line L-3 and the second distance LW between the sixth line L-6 and the seventh line L-7 may be different from the second distance LW between the fourth line L-4 and the fifth line L-5, and the second distance LW between the eighth line L-8 and the ninth line L-9.

The first pattern portion PP1 of each of the first line L-1, the second line L-2, the fifth line L-5, the sixth line L-6, the ninth line L-9, and the tenth line L-10 may include first patterns U-P1, second patterns U-P2, and third patterns U-P3 disposed between the first patterns U-P1 and the second patterns U-P2. The first patterns U-P1 may extend along the first ends HE1 of the first holes HL-N included in the first group holes HG1 and may extend in a curved shape. The second patterns UP2 may extend along the second ends HE2 of the first holes HL-N included in the second group holes HG2 and may extend in a curved shape. The third patterns U-P3 may extend in a straight-line shape in the first direction DR1.

The first pattern portion PP1 of each of the third line L-3, the fourth line L-4, the seventh line L-7, and the eighth line L-8 may include first patterns B-P1, second patterns B-P2, and third patterns B-P3 disposed between the first patterns B-P1 and the second patterns B-P2. The first patterns B-P1 may extend along the first ends HE1 of the first holes HL-N included in the second group holes HG2 and may extend in a curved shape. The second patterns B-P2 may extend along the second ends HE2 of the first holes HL-N included in the first group holes HG1 and may extend in a curved shape. The third patterns B-P3 may extend in a straight-line shape in the first direction DR1. That is, in this embodiment, the first to tenth lines L-1 and L-10 may extend along both the first ends HE1 and the second ends HE2 of the two group holes HG1 and HG2.

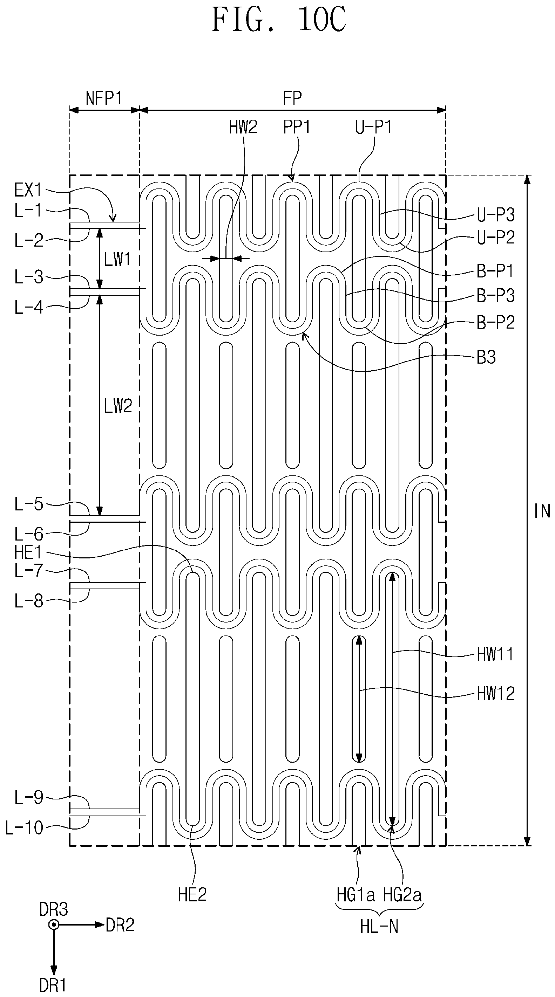

Referring to FIG. 10C, the width (hereinafter, referred to as the first hole width HW11) of first holes HL-N included in first group holes HG1a in the first direction DR1 may be different from the width (hereinafter, referred to as the second hole width HW12) of first holes HL-N included in second group holes HG2a in the first direction DR1. In an embodiment, the first hole width HW11 may be greater than the second hole width HW12. Accordingly, the second distance LW2 between a fourth line L-4 and a fifth line L-5 and the second distance LW2 between an eighth line L-8 and a ninth line L-9 may be greater than the second distance LW1 between a second line L-2 and a third line L-3 and the second distance between a sixth line L-6 and a seventh line L-7.

Referring to FIG. 11, the holes HL may include the first holes HL-N, the second holes HL-S, and the third holes HL-C and HL-M. The first holes HL-N may be holes disposed in the inner portion IN of the folding part FP, and the second holes HL-S and the third holes HL-C and HL-M may be holes at least partially disposed in the outer portion OM. The first holes HL-N have been described above with reference to FIGS. 10A to 10C, and therefore detailed description thereabout will be omitted. FIG. 11 illustrates an example that the first holes HL-N described above with reference to FIG. 10C are disposed in the inner portion IN.

The second holes HL-S may be holes spaced apart from the first group holes HG1a in the first direction DR1. In an embodiment, the second holes HL-S may have the same shape as the first group holes HG1a and may have a width HW2 equal to the first hole width HW11 of the first group holes HG1a. However, without being limited thereto, the width HW2 of the second holes HL-S may be smaller than the first hole width HW11.

The third holes HL-M and HL-C may be holes spaced apart from the second group holes HG2a in the first direction DR1. The third holes HL-M and HL-C may include the third-first holes HL-M and the third-second holes HL-C that have different shapes. The third-second holes HL-C may be the outermost holes in the outer portion OM. The third-first holes HL-M may be disposed between the third-second holes HL-C and the second group holes HG2a. Portions of the third-first holes HL-M may be disposed in the inner portion IN, and the remaining portions of the third-first holes HL-M may be disposed in the outer portion OM.

In an embodiment, the third-first holes HL-M may have a width HW31 smaller than the second hole width HW12 of the second group holes HG2a. The third-second holes HL-C may be arranged at the edge of the outer portion OM and may have a shape in which a portion is cut. Accordingly, each of the third-second holes HL-C may form an open opening. The width HW32 of the third-second holes HL-C may be smaller than the width HW31 of the third-first holes HL-M.

In this embodiment, the outer portion OM may be a portion where four lines are sequentially arranged from the edge of the folding part FP. That is, four lines may be sequentially arranged in the outer portion OM in the first direction DR1. The lines disposed in the outer portion OM may be arranged in a form similar to the form in which the lines disposed in the inner portion IN are arranged.

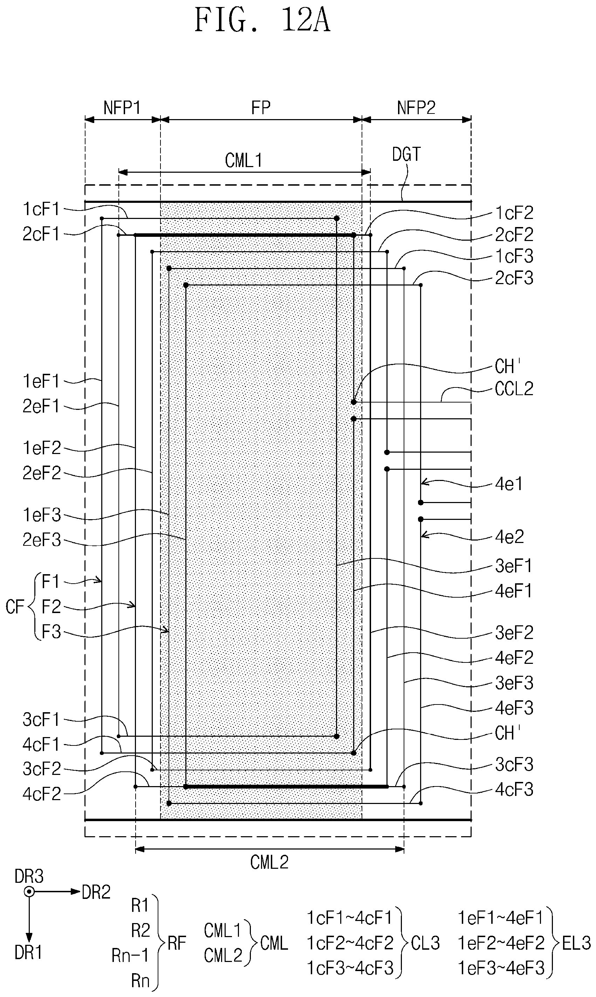

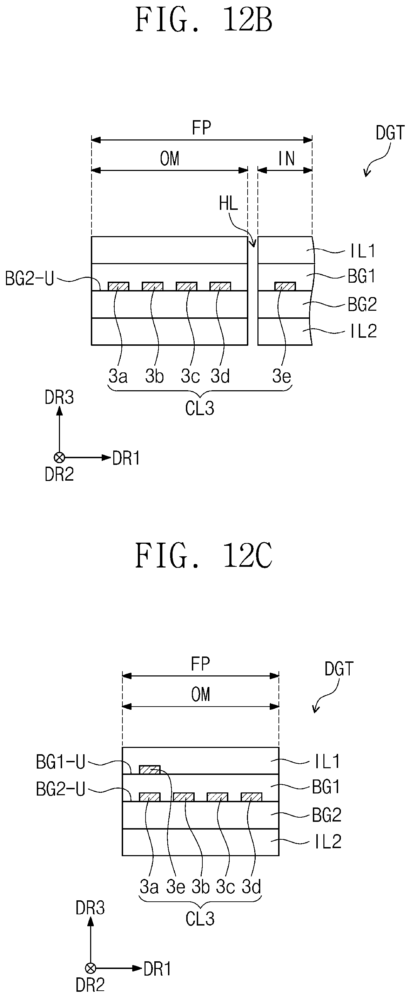

FIG. 12A is an enlarged plan view of a portion of the digitizer DGT according to an embodiment of the present disclosure. FIGS. 12B to 12D are enlarged cross-sectional views of a portion of the digitizer DGT according to an embodiment of the present disclosure. FIG. 12A illustrates an enlarged view of the second sensing coils CF at least partially disposed in the folding part FP. FIGS. 12B to 12D illustrate sections of the second sensing coils CF at least partially disposed in the folding part FP. Components identical/similar to the components described with reference to FIGS. 5A to 9 will be assigned with identical/similar reference numerals, and repetitive descriptions will be omitted.

FIG. 12A illustrates an example that three second sensing coils CF (hereinafter, referred to as the first folding coil F1, the second folding coil F2, and the third folding coil F3) are at least partially disposed in the folding part FP. The first to third folding coils F1, F2, and F3 may be sequentially arranged in the second direction DR2.

FIG. 12A illustrates an example that each of the first to third folding coils F1, F2, and F3 is implemented with a coil wound twice. However, without being limited thereto, each of the first to third folding coils F1, F2, and F3 may be implemented with a coil wound once, or may be implemented with a coil wound more than twice.

The first folding coil F1 may be disposed in the first non-folding part NFP1 and the folding part FP. The second folding coil F2 may be disposed in the first non-folding part NFP1, the folding part FP, and the second non-folding part NFP2. The third folding coil F3 may be disposed in the second non-folding part NFP2 and the folding part FP.

Each of the first to third folding coils F1, F2, and F3 may include third extending lines EL3 and third connecting lines CL3.

The third extending lines EL3 may include third-first, third-second, third-third, and third-fourth extending lines 1eF1 to 4eF1, 1eF2 to 4eF2, and 1eF3 to 4eF3. Each of the third extending lines EL3 may extend in the first direction DR1. The first folding coil F1 may include the third-first to third-fourth extending lines 1eF1, 2eF1, 3eF1, and 4eF1. The second folding coil F2 may include the third-first to third-fourth extending lines 1eF2, 2eF2, 3eF2, and 4eF2. The third folding coil F3 may include the third-first to third-fourth extending lines 1eF3, 2eF3, 3eF3, and 4eF3.

The third-first and third-second extending lines 1eF1 and 2eF1 of the first folding coil F1, the third-first and third-second extending lines 1eF2 and 2eF2 of the second folding coil F2, and the third-first and third-second extending lines 1eF3 and 2eF3 of the third folding coil F3 may be disposed relatively on the left side. The third-third and third-fourth extending lines 3eF1 and 4eF1 of the first folding coil F1, the third-third and third-fourth extending lines 3eF2 and 4eF2 of the second folding coil F2, and the third-third and third-fourth extending lines 3eF3 and 4eF3 of the third folding coil F3 may be disposed relatively on the right side.

The third connecting lines CL3 may include third-first, third-second, third-third, and third-fourth connecting lines 1cF1 to 4cF1, 1cF2 to 4cF2, and 1cF3 to 4cF3. The first folding coil F1 may include the third-first to third-fourth connecting lines 1cF1, 2cF1, 3cF1, and 4cF1. The second folding coil F2 may include the third-first to third-fourth connecting lines 1cF2, 2cF2, 3cF2, and 4cF2. The third folding coil F3 may include the third-first to third-fourth connecting lines 1cF3, 2cF3, 3cF3, and 4cF3.

Each of the third connecting lines CL3 may extend in the second direction DR2. At least a portion of each of the third connecting lines CL3 may be disposed in the folding part FP. Although FIG. 12A simply illustrates an example that each of the third connecting lines CL3 extends in a straight-line shape in the second direction DR2 in the folding part FP, the third connecting lines CL3 may curvedly extend along the peripheries of the holes HL (refer to FIG. 7A) in the folding part FP.

In an embodiment, the third extending lines 1eF3, 2eF3, 3eF1, and 4eF1 disposed in the folding part FP may be disposed in a layer different from the layer in which the third connecting lines CL3 are disposed, and the third extending lines 1eF3, 2eF3, 3eF1, and 4eF1 disposed in the folding part FP and the third connecting lines 1cF1, 2cF1, 1cF3, 2cF3, 3cF1, 4cF1, 3cF3, and 4cF3 connected thereto may be connected through contact holes CH' penetrating at least one base layer. The contact holes CH' may be defined in the folding part FP.

In the present disclosure, the digitizer DGT may include at least one common line CML. According to this embodiment, the one common line CML may provide the third connecting lines CL3 of the different folding coils. That is, the third connecting lines CL3 of the different folding coils may be shared as the common line CML.

In an embodiment, a plurality of common lines CML may be provided. The common lines CML may include a first common line CML1 and a second common line CML2. The first common line CML1 may extend to cross the folding part FP on the upper side. The second common line CML2 may extend to cross the folding part FP on the lower side.

The first common line CML1 may provide the third-second connecting line 2cF1 of the first folding coil F1 and the third-first connecting line 1cF2 of the second folding coil F2 together. That is, the third-second connecting line 2cF1 of the first folding coil F1 and the third-first connecting line 1cF2 of the second folding coil F2 may be shared as the first common line CML1.

The first common line CML1 may be connected with the third-second extending line 2eF1 and the third-fourth extending line 4eF1 of the first folding coil F1, and a portion of the first common line CML1 may constitute a portion of the first folding coil F1. The first common line CML1 may be connected with the third-first extending line 1eF2 and the third-third extending line 3eF2 of the second folding coil F2, and a portion of the first common line CML1 may constitute a portion of the second folding coil F2.

The second common line CML2 may provide the third-fourth connecting line 4cF2 of the second folding coil F2 and the third-third connecting line 3cF3 of the third folding coil F3 together. That is, the third-fourth connecting line 4cF2 of the second folding coil F2 and the third-third connecting line 3cF3 of the third folding coil F3 may be shared as the second common line CML2.

The second common line CML2 may be connected with the third-first extending line 1eF2 and the third-fourth extending line 4eF2 of the second folding coil F2. A portion of the second common line CML2 may constitute a portion of the second folding coil F2. The second common line CML2 may be connected with the third-second extending line 2eF3 and the third-third extending line 3eF3 of the third folding coil F3. A portion of the second common line CML2 may constitute a portion of the third folding coil F3.

Meanwhile, the type of the third connecting line CL3 of each of the first and second folding coils F1 and F2 shared in the first common line CML1 and the type of the third connecting line CL3 of each of the second and third folding coils F2 and F3 shared in the second common line CML2 are not limited thereto.

In this embodiment, only one of the first folding coil F1 and the second folding coil F2 may be driven to sense an external input. When the first folding coil F1 is driven to sense an external input, the second folding coil F2 may be driven to be floated. In this case, the first common line CML1 may be used for sensing operation of the first folding coil F1. When the second folding coil F2 is driven to sense an external input, the first folding coil F1 may be driven to be floated. In this case, the first common line CML1 may be used for sensing operation of the second folding coil F2.

In addition, only one of the second folding coil F2 and the third folding coil F3 may be driven to sense an external input. When the second folding coil F2 is driven to sense an external input, the third folding coil F3 may be driven to be floated. In this case, the second common line CML2 may be used for sensing operation of the second folding coil F2. When the third folding coil F3 is driven to sense an external input, the second folding coil F2 may be driven to be floated. In this case, the second common line CML2 may be used for sensing operation of the third folding coil F3.

The coil driven to be floated may remain in the floated state. For example, when a specific coil is driven to be floated, the electrical connection between the specific coil and the connector CNT may be blocked.

The first common line CML1, the third-first connecting line 1cF1 of the first folding coil F1, the third-second connecting line 2cF2 of the second folding coil F2, and the third-first and third-second connecting lines 1cF3 and 2cF3 of the third folding coil F3 may be disposed in the upper portion of the digitizer DGT. The second common line CML2, the third-third and third-fourth connecting lines 3cF1 and 4cF1 of the first folding coil F1, the third-third connecting line 3cF2 of the second folding coil F2, and the third-fourth connecting line 4cF3 of the third folding coil F3 may be disposed in the lower portion of the digitizer DGT. That is, five third connecting lines CL3 may be disposed in each of the upper portion and the lower portion of the digitizer DGT.

At least one of the first common line CML1, the third-first connecting line 1cF1 of the first folding coil F1, the third-second connecting line 2cF2 of the second folding coil F2, or the third-first and third-second connecting lines 1cF3 and 2cF3 of the third folding coil F3 may be disposed on the outermost side within the upper portion of the digitizer DGT.

At least one of the second common line CML2, the third-third and third-fourth connecting lines 3cF1 and 4cF1 of the first folding coil F1, the third-third connecting line 3cF2 of the second folding coil F2, and the third-fourth connecting line 4cF3 of the third folding coil F3 may be disposed on the outermost side within the lower portion of the digitizer DGT.

In FIGS. 12B to 12D, sections of the five third connecting lines CL3 (hereinafter, the upper third connecting lines 3a, 3b, 3c, 3d, and 3e) disposed in the upper portion of the digitizer DGT are illustrated. Although the five third connecting lines CL3 disposed in the lower portion of the digitizer DGT are omitted in FIGS. 12B to 12D, description of FIGS. 12B to 12D may be similarly applied to the five third connecting lines CL3 disposed in the lower portion of the digitizer DGT. One of the five upper third connecting lines 3a, 3b, 3c, 3d, and 3e may correspond to the first common linen CML1, and the rest may correspond to the third-first connecting line 1cF1 of the first folding coil F1, the third-second connecting line 2cF2 of the second folding coil F2, and the third-first and third-second connecting lines 1cF3 and 2cF3 of the third folding coil F3.

Referring to FIGS. 12A and 12B, the five upper third connecting lines 3a, 3b, 3c, 3d, and 3e may be disposed in the same layer and may be sequentially arranged. In an embodiment, the digitizer DGT may include the first base layer BG1, the second base layer BG2, the first cover layer IL1, and the second cover layer IL2, and the upper third connecting lines 3a, 3b, 3c, 3d, and 3e may all be disposed on the upper surface BG2-U of the second base layer BG2.

Among the five upper third connecting lines 3a, 3b, 3c, 3d, and 3e, four upper third connecting lines 3a, 3b, 3c, and 3d may be disposed in the outer portion OM, and one upper third connecting line 3e may be disposed in the inner portion IN. The type of the upper third connecting line 3e disposed in the inner portion IN is not limited to any one type.

Meanwhile, the sequence in which the upper third connecting lines 3a, 3b, 3c, 3d, and 3e are sequentially arranged in the direction from the outer portion OM toward the inner portion IN is not limited to any one embodiment.

Referring to FIGS. 12A and 12C, a part of the upper third connecting lines 3a, 3b, 3c, 3d, and 3e may be disposed in a layer different from the layer in which the remaining upper third connecting lines are disposed. In an embodiment, the digitizer DGT may include the first base layer BG1, the second base layer BG2, the first cover layer IL1, and the second cover layer IL2, and among the upper third connecting lines 3a, 3b, 3c, 3d, and 3e, one upper third connecting line 3e may be disposed in the uppermost layer, and four upper third connecting lines 3a, 3b, 3c, and 3d may be disposed below the one upper third connecting line 3e. Meanwhile, the number of third connecting lines 3e disposed in the uppermost layer is not limited to any one embodiment.

The upper third connecting line 3e disposed in the uppermost layer may be disposed in the same layer as the first extending lines EL1 (refer to FIG. 8A) and may be disposed on the upper surface BG1-U of the first base layer BG1. The remaining upper third connecting lines 3a, 3b, 3c, and 3d may be disposed on the upper surface BG2-U of the second base layer BG2. The type of the upper third connecting line 3e disposed in the uppermost layer is not limited to any one type.

The upper third connecting line 3e disposed in the uppermost layer may overlap one of the remaining upper third connecting lines 3a, 3b, 3c, and 3d. Accordingly, the five upper third connecting lines 3a, 3b, 3c, 3d, and 3e may all be disposed in the outer portion OM. In this case, the area that the first to third folding coils F1, F2, and F2 are capable of sensing may be increased as compared with when the five upper third connecting lines 3a, 3b, 3c, 3d, and 3e are sequentially arranged.

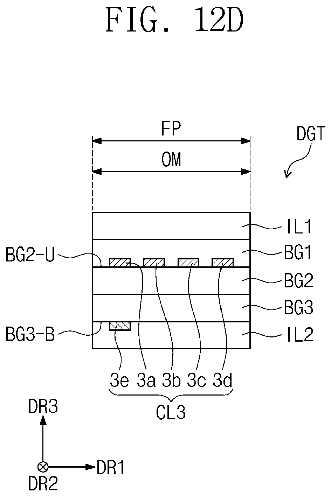

Referring to FIGS. 12A and 12D, a part of the upper third connecting lines 3a, 3b, 3c, 3d, and 3e may be disposed in a layer different from the layer in which the remaining upper third connecting lines are disposed. In an embodiment, the digitizer DGT may include the first base layer BG1, the second base layer BG2, the third base layer BG3, the first cover layer IL1, and the second cover layer IL2, and among the upper third connecting lines 3a, 3b, 3c, 3d, and 3e, one upper third connecting line 3e may be disposed in the lowermost layer, and the remaining four upper third connecting lines 3a, 3b, 3c, and 3d may be disposed above the one upper third connecting line 3e. Meanwhile, the number of third connecting lines 3e disposed in the lowermost layer is not limited to any one embodiment.

The upper third connecting line 3e disposed in the lowermost layer may be disposed on the lower surface BG3-B of the third base layer BG3. The remaining upper third connecting lines 3a, 3b, 3c, and 3d may be disposed on the upper surface BG2-U of the second base layer BG2. The type of the upper third connecting line 3e disposed in the lowermost layer is not limited to any one type.

The upper third connecting line 3e disposed in the lowermost layer may overlap one of the remaining upper third connecting lines 3a, 3b, 3c, and 3d. Accordingly, the five upper third connecting lines 3a, 3b, 3c, 3d, and 3e may all be disposed in the outer portion OM. In this case, the area that the first to third folding coils F1, F2, and F2 are capable of sensing may be increased as compared with when the five upper third connecting lines 3a, 3b, 3c, 3d, and 3e are sequentially arranged.

According to this embodiment, by providing the common line CML for the digitizer DGT, the number of lines passing through the folding part FP may be decreased. In particular, the folding coils F1, F2, and F3 at least partially disposed in the folding part FP may provide a wide sensing area as the third connecting lines CL3 are disposed adjacent to the outermost portion. However, in the folding part FP, the lines may extend through between the holes HL, and there may be a limitation in the number of lines disposed between the holes HL. That is, when compared to the non-folding parts NFP1 and NFP2, the folding part FP may have a limitation in the space in which the lines are disposed. In this case, the lines in the folding part FP may be provided to detour so as to be far away from the outermost part. Meanwhile, according to this embodiment, the number of lines that have to be disposed in the outermost part may be decreased through the common line CML. Accordingly, the wiring density in the outer portion OM may be reduced, and the number of lines provided in the form of a bypass path may be decreased. Thus, the sensing performance in the folding part FP may be improved.

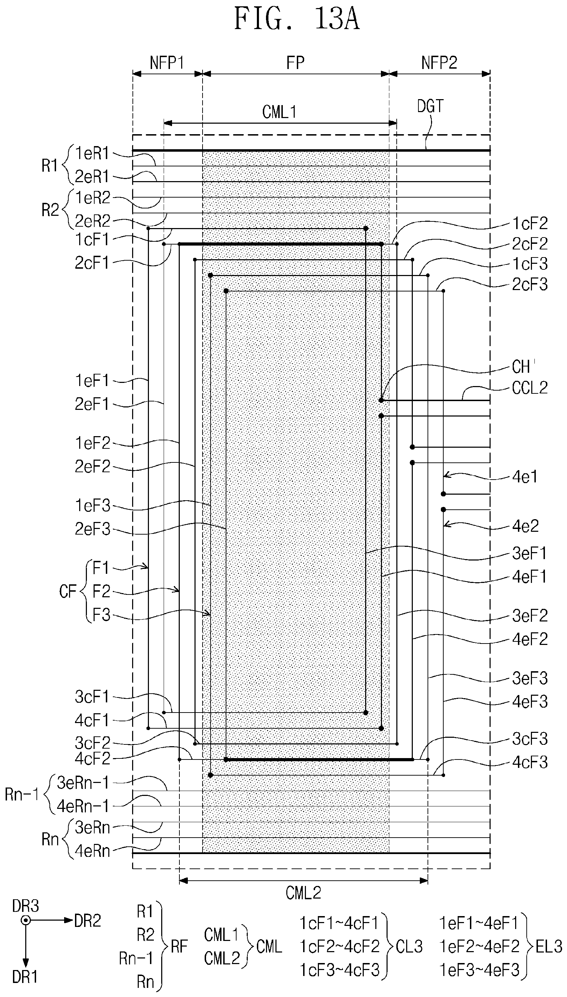

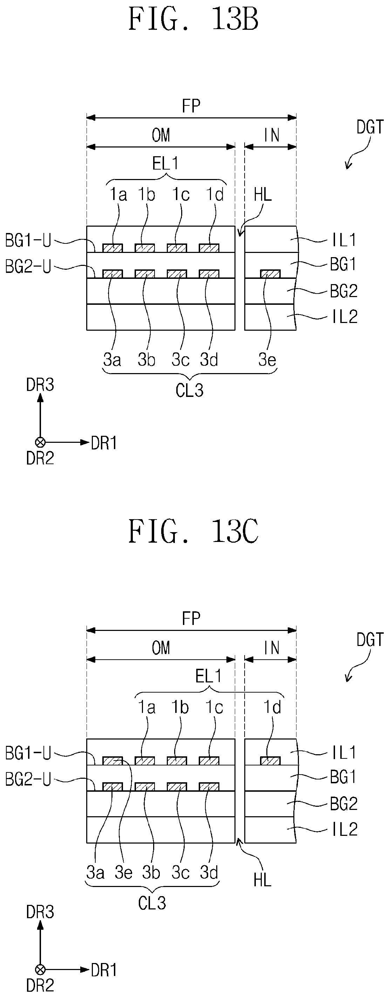

FIG. 13A is an enlarged plan view of a portion of the digitizer DGT according to an embodiment of the present disclosure. FIGS. 13B to 13D are enlarged cross-sectional views of a portion of the digitizer DGT according to an embodiment of the present disclosure. Components identical/similar to the components described with reference to FIGS. 5A to 9 and 12A to 12D will be assigned with identical/similar reference numerals, and repetitive descriptions will be omitted.

In this embodiment, some of the first sensing coils RF may be disposed together in each of the upper portion and the lower portion of the digitizer DGT. Some of the first extending lines EL1 (refer to FIG. 6A) of the first sensing coils RF may be disposed in each of the upper portion and the lower portion of the digitizer DGT.

N first sensing coils RF may be sequentially arranged in the first direction DR1, and among the n first sensing coils RF, only the first sensing coils RF disposed in the upper portion and the lower portion of the digitizer DGT are illustrated in FIG. 13A.

In an embodiment, portions of first-first and second-first sensing coils R1 and R2 may be disposed in the upper portion of the digitizer DGT, and portions of (n-1)^{th}-first and n^{th}-first sensing coils Rn-1 and Rn may be disposed in the lower portion of the digitizer DGT (n being a natural number of 4 or more).

More specifically, first-first and first-second extending lines 1eR1 and 2eR1 of the first-first sensing coils R1 and first-first and first-second extending lines 1eR2 and 2eR2 of the second-first sensing coils R2 may be disposed in the upper portion of the digitizer DGT. First-third and first-fourth extending lines 3eRn-1 and 4eRn-1 of the (n-1)^{th}-first sensing coil Rn-1 and first-third and first-fourth extending lines 3eRn and 4eRn of the n^{th}-first sensing coil Rn may be disposed in the lower portion of the digitizer DGT. That is, the four first extending lines 1eR1, 2eR1, 1eR2, and 2eR2 may be disposed in the upper portion of the digitizer DGT, and the four first extending lines 3eRn-1, 4eRn-1, 3eRn, and 4eRn may be disposed in the lower portion of the digitizer DGT.

Although FIG. 13A illustrates an example that in the upper portion and the lower portion of the digitizer DGT, the first extending lines 1eR1, 2eR1, 1eR2, 2eR2, 3eRn-1, 4eRn-1, 3eRn, and 4eRn are disposed outward of the third connecting lines CL3, the present disclosure is not limited thereto. At least some of the first extending lines 1eR1, 2eR1, 1eR2, 2eR2, 3eRn-1, 4eRn-1, 3eRn, and 4eRn may be disposed in a layer different from the layer in which at least some of the third connecting lines CL3 are disposed and may be disposed to overlap the at least some of the third connecting lines CL3. The arrangement form on the section will be described in detail with reference to FIGS. 13B to 13D.

In FIGS. 13B to 13D, sections of five third connecting lines CL3 (hereinafter, the upper third connecting lines 3a, 3b, 3c, 3d, and 3e) and four first extending lines EL1 (hereinafter, the upper first extending lines 1a, 1b, 1c, and 1d) disposed in the upper portion of the digitizer DGT are illustrated.

The four upper first extending lines 1a, 1b, 1c, and 1d may correspond to the first-first and first-second extending lines 1eR1 and 2dR1 of the first-first sensing coil R1 and the first-first1 and first-second extending lines 1eR2 and 2eR2 of the second-first sensing coil R2.

Two lines may be shared through the first common line CML1, and four long sides of the first sensing coils RF that pass through the upper portion of the folding part FP and six short sides of the second sensing coils CF that pass through the upper portion of the folding part FP may be provided as nine lines.

Referring to FIGS. 13A and 13B, the five upper third connecting lines 3a, 3b, 3c, 3d, and 3e may be disposed in the same layer and may be sequentially arranged. The four upper first extending lines 1a, 1b, 1c, and 1d may be disposed in the same layer and may be sequentially arranged.

In an embodiment, the digitizer DGT may include the first base layer BG1, the second base layer BG2, the first cover layer IL1, and the second cover layer IL2. The upper third connecting lines 3a, 3b, 3c, 3d, and 3e may all be disposed on the upper surface BG2-U of the second base layer BG2, and the upper first extending lines 1a, 1b, 1c, and 1d may all be disposed on the upper surface BG1-U of the first base layer BG1. In an embodiment, the four upper first extending lines 1a, 1b, 1c, and 1d may all be disposed in the outer portion OM.

Referring to FIGS. 13A and 13C, a part of the upper third connecting lines 3a, 3b, 3c, 3d, and 3e may be disposed in a layer different from the layer in which the remaining upper third connecting lines are disposed. In an embodiment, the digitizer DGT may include the first base layer BG1, the second base layer BG2, the first cover layer IL1, and the second cover layer IL2. Among the upper third connecting lines 3a, 3b, 3c, 3d, and 3e, one upper third connecting line 3e may be disposed in the uppermost layer, and four upper third connecting lines 3a, 3b, 3c, and 3d may be disposed below the one upper third connecting line 3e.

The upper third connecting line 3e disposed in the uppermost layer may be disposed in the same layer as the upper first extending lines 1a, 1b, 1c, and 1d and may be disposed on the upper surface BG1-U of the first base layer BG1. The remaining upper third connecting lines 3a, 3b, 3c, and 3d may be disposed on the upper surface BG2-U of the second base layer BG2.

In an embodiment, the five upper third connecting lines 3a, 3b, 3c, 3d, and 3e may all be disposed in the outer portion OM. The upper third connecting line 3e disposed in the uppermost layer may overlap one of the remaining upper third connecting lines 3a, 3b, 3c, and 3d.

Among the four upper first extending lines 1a, 1b, 1c, and 1d, three upper first extending lines 1a, 1b, and 1c may be disposed in the outer portion OM, and one upper first extending line 1d may be disposed in the inner portion IN. The upper first extending lines 1a, 1b, and 1c disposed in the outer portion OM may overlap the upper third connecting lines 3a, 3b, 3c, and 3d disposed below the upper first extending lines 1a, 1b, and 1c. However, embodiments are not limited thereto. The four upper first extending lines 1a, 1b, 1c, and 1d may all be disposed in the outer portion OM, and the upper third connecting line 3e disposed in the uppermost layer may be disposed in the inner portion IN.

Meanwhile, the number of third connecting lines 3e disposed in the uppermost layer is not limited to any one embodiment.

Referring to FIG. 13A to 13D, a part of the upper third connecting lines 3a, 3b, 3c, 3d, and 3e may be disposed In a layer different from the layer in which the remaining upper third connecting lines are disposed. In an embodiment, the digitizer DGT may include the first base layer BG1, the second base layer BG2, the third base layer BG3, the first cover layer IL1, and the second cover layer IL2.

Among the upper third connecting lines 3a, 3b, 3c, 3d, and 3e, one upper third connecting line 3e may be disposed in the lowermost layer, and four upper third connecting lines 3a, 3b, 3c, and 3d may be disposed above the one upper third connecting line 3e. The upper third connecting line 3e disposed in the lowermost layer may be disposed on the lower surface BG3-B of the third base layer BG3, and the remaining upper third connecting lines 3a, 3b, 3c, and 3d may be disposed on the upper surface BG2-U of the second base layer BG2.

The upper first extending lines 1a, 1b, 1c, and 1d may be disposed above the upper third connecting lines 3a, 3b, 3c, 3d, and 3e. The upper first extending lines 1a, 1b, 1c, and 1d may be disposed on the upper surface BG1-U of the first base layer BG1.

The four upper first extending lines 1a, 1b, 1c, and 1d and the five upper third connecting lines 3a, 3b, 3c, 3d, and 3d may all be disposed in the outer portion OM. The upper third connecting line 3e disposed in the lowermost layer may overlap one of the remaining upper third connecting lines 3a, 3b, 3c, and 3d. The upper first extending lines 1a, 1b, 1c, and 1d may overlap the upper third connecting lines 3a, 3b, 3c, and 3d.

Meanwhile, the number of third connecting lines 3e disposed in the lowermost layer is not limited to any one embodiment.

Although not illustrated, according to an embodiment of the present disclosure, some of the upper first extending lines 1a, 1b, 1c, and 1d may be disposed on the lower surface BG3-B of the third base layer GB3, and some of the upper third connecting lines 3a, 3b, 3c, 3d, and 3e may be disposed on the upper surface BG1-U of the first base layer BG1.

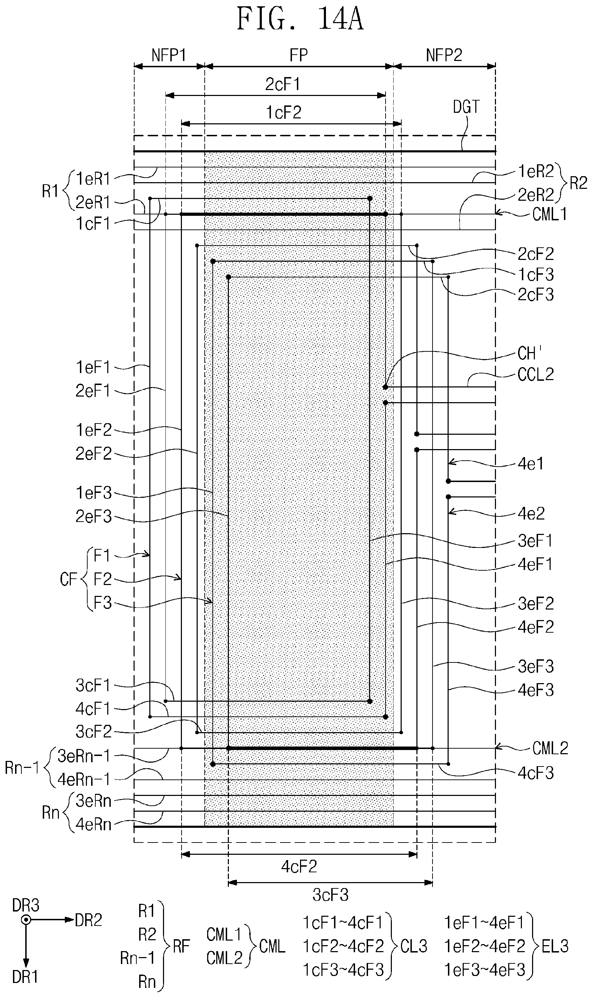

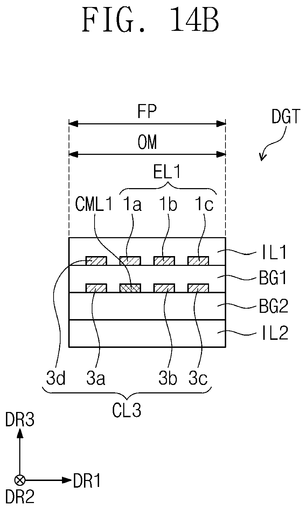

FIG. 14A is an enlarged plan view of a portion of the digitizer DGT according to an embodiment of the present disclosure. FIG. 14B is an enlarged cross-sectional view of a portion of the digitizer DGT according to an embodiment of the present disclosure. Components identical/similar to the components described with reference to FIGS. 5A to 9 and 12A to 13D will be assigned with identical/similar reference numerals, and repetitive descriptions will be omitted.

Referring to FIGS. 14A and 14B, the common lines CML may include the first common line CML1 and the second common line CML2. According to this embodiment, on the upper side of the digitizer DGT, the first common line CML1 may extend from the first non-folding part NFP1 to the second non-folding part NFP2 to cross the folding part FP. On the lower side of the digitizer DGT, the second common line CML2 may extend from the first non-folding part NFP1 to the second non-folding part NFP2 to cross the folding part FP.

In this embodiment, each of the first and second common lines CML1 and CML2 may be shared with one first sensing coil RF as well as two folding coils F1, F2, and F3.

The first common line CML1 may provide a portion of the first-first sensing coil R1, a portion of the first folding coil F1, and a portion of the second folding coil F2.

The first common line CML1 may provide the first-second extending line 2eR1 of the first-first sensing coil R1, the third-second connecting line 2cF1 of the first folding coil F1, and the third-first connecting line 1cF2 of the second folding coil F2 together. That is, the first-second extending line 2eR1 of the first-first sensing coil R1, the third-second connecting line 2cF1 of the first folding coil F1, and the third-first connecting line 1cF2 of the second folding coil F2 may be shared as the first common line CML1.

The first common line CML1 may extend parallel to the first-first extending line 1eR1 of the first-first sensing coil R1. Likewise to the first extending lines EL1 illustrated in FIG. 6A, the first common line CML1 may also extend to the left inactive area NAA (refer to FIG. 6A), the active area AA (refer to FIG. 6A), and the right inactive area NAA (refer to FIG. 6A).

The second common line CML2 may provide a portion of the (n-1)^{th}-first sensing coil Rn-1, a portion of the second folding coil F2, and a portion of the third folding coil F3.

The second common line CML2 may provide the first-third extending line 3eRn-1 of the (n-1)^{th}-first sensing coil Rn-1, the third-fourth connecting line 4cF2 of the second folding coil F2, and the third-third connecting line 3cF3 of the third folding coil F3 together. That is, the first-third extending line 3eRn-1 of the (n-1)^{th}-first sensing coil Rn-1, the third-fourth connecting line 4cF2 of the second folding coil F2, and the third-third connecting line 3cF3 of the third folding coil F3 may be shared as the second common line CML2.

The second common line CML2 may extend parallel to the first-fourth extending line 4eRn1 of the (n-1)^{th}-first sensing coil Rn-1. Likewise to the first extending lines EL1 illustrated in FIG. 6A, the second common line CML2 may also extend to the left inactive area NAA (refer to FIG. 6A), the active area AA (refer to FIG. 6A), and the right inactive area NAA (refer to FIG. 6A).

In this embodiment, only one of the first-first sensing coil R1, the first folding coil F1, and the second folding coil F2 may be driven to sense an external input. For example, when the first-first sensing coil R1 is driven to sense an external input, the first and second folding coils F1 and F2 may be driven to be floated.

In addition, only one of the (n-1)^{th}-first sensing coil Rn-1, the second folding coil F2, and the third folding coil F3 may be driven to sense an external input. For example, when the (n-1)^{th}-first sensing coil Rn-1 is driven to sense an external input, the second and third folding coils F2 and F3 may be driven to be floated.

In this embodiment, four third connecting lines CL3, three first extending lines EL1 (refer to FIG. 6A), and one common line CML may be disposed in each of the upper portion and the lower portion of the digitizer DGT, and the common line CML may be shared by two third connecting lines CL3 and one first extending line EL1 (refer to FIG. 6A).

In FIG. 14B, a section of four third connecting lines CL3 (hereinafter, the upper third connecting lines 3a, 3b, 3c, and 3d), three first extending lines EL1 (hereinafter, the upper first extending lines 1a, 1b, and 1c), and one upper common line CML disposed in the upper portion of the digitizer DGT are illustrated.

The four upper third connecting lines 3a, 3b, 3c, and 3d may correspond to the third-first connecting line 1cF1 of the first folding coil F1, the third-second connecting line 2cF2 of the second folding coil F2, and the third-first and third-second connecting lines 1cF3 and 2cF3 of the third folding coil F3. The three upper first extending lines 1a, 1b, and 1c may correspond to the first-first extending line 1eR1 of the first-first sensing coil R1 and the first-first and first-second extending lines 1eR2 and 2eR2 of the second-first sensing coil R2. The one upper common line CML1 may correspond to the first common line CML1.

In an embodiment, the digitizer DGT may include the first base layer BG1, the second base layer BG2, the first cover layer IL1, and the second cover layer IL2. The upper third connecting lines 3a, 3b, 3c, and 3d and the upper common line CML1 may be disposed on the upper surface BG2-U of the second base layer BG2, and the upper first extending lines 1a, 1b, and 1c may be disposed on the upper surface BG1-U of the first base layer BG1.

Three lines may be shared through the upper common line CML1, and four long sides of two first sensing coils RF that pass through the upper portion of the folding part FP and six short sides of three second sensing coils CF that pass through the upper portion of the folding part FP may be provided as eight lines. The eight lines may be provided in a two-layer structure and may all be disposed in the outer portion OM.

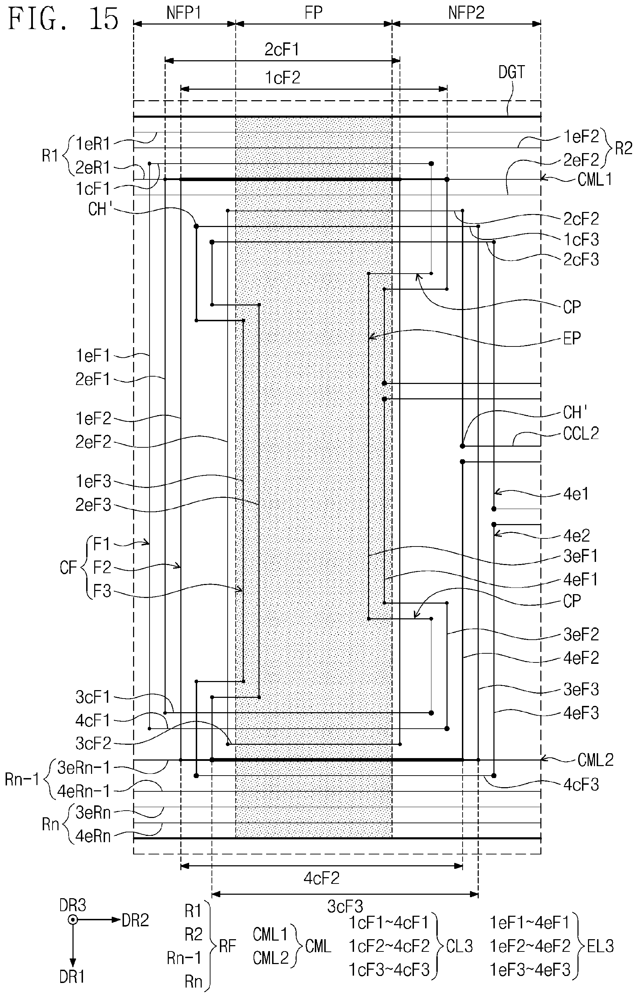

FIG. 15 is an enlarged plan view of a portion of the digitizer DGT according to an embodiment of the present disclosure. Components identical/similar to the components described with reference to FIGS. 5A to 9 and 12A to 14B will be assigned with identical/similar reference numerals, and repetitive descriptions will be omitted.

Referring to FIG. 15, in this embodiment, the third extending lines 1eF3, 2eF3, 3eF1, and 4eF1 passing through the folding part FP may be disposed in a layer different from the layer in which the third connecting lines CL3 are disposed, and the third extending lines 1eF3, 2eF3, 3eF1, and 4eF1 disposed in the folding part FP and the third connecting lines 1cF1, 2cF1, 1cF3, 2cF3, 3cF1, 4cF1, 3cF3, and 4cF3 connected thereto may be connected through contact holes CH' penetrating at least one base layer. According to this embodiment, the contact holes CH' may be spaced apart from the folding part FP and may be defined in the first non-folding part NFP1 or the second non-folding part NFP2.

Each of the third extending lines 1eF3, 2dF3, 3eF1, and 4eF1 passing through the folding part FP may include an extension EP and a connecting portion CP. The extension EP is a portion extending in the first direction DR1 in the folding part FP. The connecting portion CP is a portion that connects the end of the extension EP and the corresponding third connecting line 1cF1, 2cF1, 1cF3, 2cF3, 3cF1, 4cF1, 3cF3, or 4cF3. The connecting portion CP may extend from the folding part FP to the contact hole CH' defined in the first non-folding part NFP1, or may extend from the folding part FP to the contact hole CH' defined in the second non-folding part NFP2.

According to this embodiment, the number of contact holes CH' disposed in the folding part FP may be reduced, or the contact holes CH' may not be disposed in the folding part FP. Accordingly, damage to the contact holes contact holes CH' due to a folding operation may be prevented, and poor connection of lines connected through the contact holes CH' may be prevented. In addition, to fill the contact holes CH', thick lines may be provided near the contact holes CH', but compromising in the folding characteristics of the digitizer DGT due to this may be reduced or prevented.

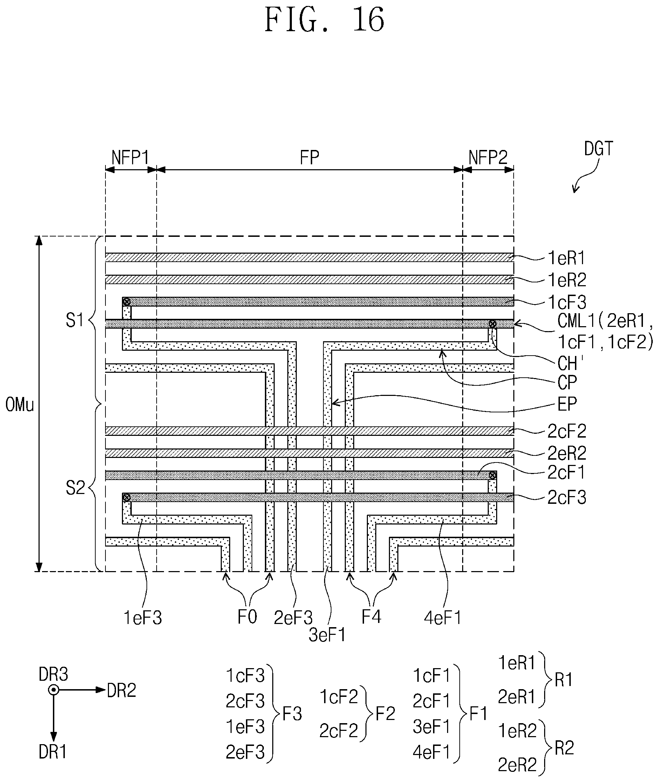

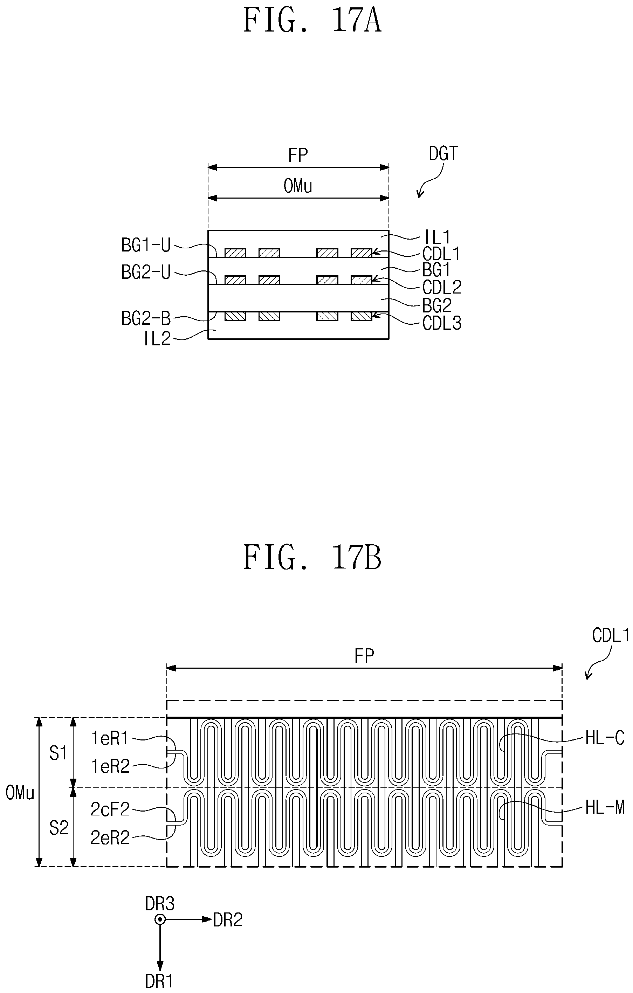

FIG. 16 is an enlarged plan view of a portion of the digitizer DGT according to an embodiment of the present disclosure. FIG. 17A is an enlarged cross-sectional view of a portion of the digitizer DGT according to an embodiment of the present disclosure. FIGS. 17B to 17D are enlarged plan views of a portion of the digitizer DGT according to an embodiment of the present disclosure. FIGS. 16 to 17D illustrate enlarged views of lines disposed in the outer portion on the upper side (hereinafter, the upper outer portion OMu). Description of FIGS. 16 to 17D may be similarly applied to lines disposed in the outer portion OM (refer to FIG. 11) on the lower side. Components identical/similar to the components described with reference to FIGS. 5A to 15 will be assigned with identical/similar reference numerals, and repetitive descriptions will be omitted.

Referring to FIG. 16, in this embodiment, portions of the first to third folding coils F1, F2, and F3, a portion of the first-first sensing coil R1, and a portion of the second-first sensing coil R2 described above with reference to FIG. 15 may be disposed in the upper outer portion OMu. In addition, a portion of a folding coil (hereinafter, the left folding coil F0) disposed on the left side with respect to the first to third folding coils F1, F2, and F3 and a portion of a folding coil (hereinafter, the right folding coil F4) disposed on the right side with respect to the first to third folding coils F1, F2, and F3 may be disposed together in the upper outer portion OMu. That is, portions of the five folding coils F0 to F5 and portions of the two first sensing coils R1 and R2 may be disposed in the upper outer portion OMu.

Referring to FIG. 17A, in this embodiment, the digitizer DGT may include the first base layer BG1, the second base layer BG2, the first cover layer IL1, and the second cover layer IL2. Lines disposed on the upper surface BG1-U of the first base layer BG1 and covered by the first cover layer IL1 may constitute a first conductive layer CDL1. Lines disposed on the upper surface BG2-U of the second base layer BG2 and covered by the first base layer BG1 may constitute a second conductive layer CDL2. Lines disposed on the lower surface BG2-B of the second base layer BG2 and covered by the second cover layer IL2 may constitute a third conductive layer CDL3. According to this embodiment, the conductive layers in the upper outer portion OMu may be disposed in a three-layer structure.

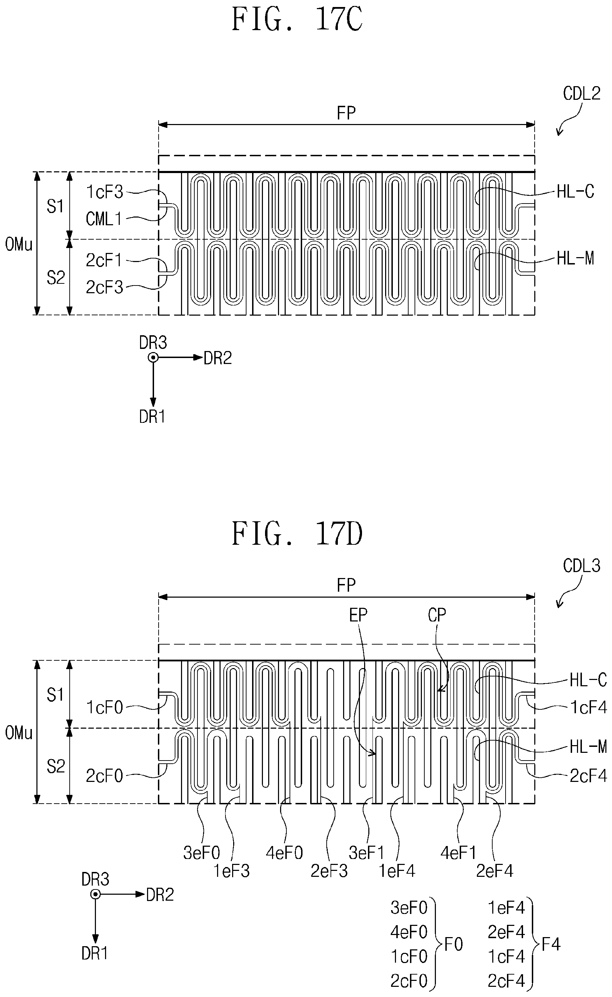

FIG. 17B illustrates a plan view of the first conductive layer CDL1 in the upper outer portion OMu, FIG. 17C illustrates a plan view of the second conductive layer CDL2 in the upper outer portion OMu, and FIG. 17D illustrates a plan view of the third conductive layer CDL3 in the upper outer portion OMu.

Referring to FIGS. 17B to 17D, the outer portion OM may include a first section S1 and a second section S2. The first section S1 may be disposed closer to the edge of the folding part FP than the second section S2. The first section S1 may a portion in which the third-second holes HL-C are disposed, and lines disposed in the first section S1 may extend along the third-second holes HL-C. The second section S2 may a portion in which the third-first holes HL-M are disposed, and lines disposed in the second section S2 may extend along the third-first holes HL-M. In an embodiment, the width of each of the first section S1 and the second section S2 in the first direction DR1 may be less than or equal to 2 millimeters (mm).

Referring to FIGS. 16, 17A, and 17B, the first-first extending line 1eR1 of the first-first sensing coil R1, the first-first and first-second extending lines 1eR2 and 2eR2 of the second-first sensing coil R2, and the third-second connecting line 2cF2 of the second folding coil F2 may be included in the first conductive layer CDL1.

In an embodiment, the first-first extending line 1eR1 of the first-first sensing coil R1 and the first-first extending line 1eR2 of the second-first sensing coil R2 may cross the first section S1, and the first-second extending line 2eR2 of the second-first sensing coil R2 and the third-second connecting line 2cF2 of the second folding coil F2 may cross the second section S2.

Referring to FIGS. 16, 17A, and 17C, the third-first and third-second connecting lines 1cF3 and 2cF3 of the third folding coil F3, the first common line CML1, and the third-second connecting line 2cF1 of the first folding coil F1 may be included in the second conductive layer CDL2. In this embodiment, the first common line CML1 may be shared as the first-second extending line 2eR1 of the first-first sensing coil R1, the third-first connecting line 1cF1 of the first folding coil F1, and the third-first connecting line 1cF2 of the second folding coil F2.

In an embodiment, the third-first connecting line 1cF3 of the third folding coil F3 and the first common line CML1 may cross the first section S1, and the third-second connecting line 2cF1 of the first folding coil F1 and the third-second connecting line 2cF3 of the third folding coil F3 may cross the second section S2.

Referring to FIGS. 16, 17A, and 17D, the third-third and third-fourth extending lines 3eF1 and 4eF1 of the first folding coil F1 and the third-first and third-second extending lines 1eF3 and 2eF3 of the third folding coil F3 may be included in the third conductive layer CDL3.

As illustrated in FIG. 16, the third-second extending line 3eF1 of the first folding coil F1 may be connected to the first common line CML1 through the contact hole CH' in the second non-folding part NFP2. The third-fourth extending line 4eF1 of the first folding coil F1 may be connected to the third-second connecting line 2cF1 through the contact hole CH' in the second non-folding part NFP2. The third-first extending line 1eF3 of the third folding coil F3 may be connected to the third-second connecting line 2cF3 through the contact hole CH' in the first non-folding part NFP1. The third-second extending line 2eF3 of the third folding coil F3 may be connected to the third-first connecting line 1cF3 through the contact hole CH' in the first non-folding part NFP1.

As illustrated in FIGS. 16 and 17D, the connecting portion CP of each of the third-third and third-fourth extending lines 3eF1 and 4eF1 of the first folding coil F1 may extend from the first non-folding part NFP1 into the first section S1 of the folding part FP, and the extension EP may extend in the first direction DR1 in the folding part FP. The connecting portion CP of each of the third-first and third-second extending lines 1eF3 and 2eF3 of the third folding coil F3 may extend from the second non-folding part NFP2 into the first section S1 of the folding part FP, and the extension EP may extend in the first direction DR1 in the folding part FP.

A portion of the left folding coil F0 and a portion of the right folding coil F4 may be included in the third conductive layer CDL3. More specifically, among the third connecting lines EL3 (refer to FIG. 7A) and the third extending lines EL3 (refer to FIG. 7A) of the left folding coil F0, the third extending lines EL3 (refer to FIG. 7A) disposed in the folding part FP may be included in the third conductive layer CDL3.

The third-first and third-second connecting lines 1cF0 and 2cF0 of the left folding coil F0 may extend from the first non-folding part NFP1 to the folding part FP, and the third-third and third-fourth extending lines 3eF0 and 4eF0 of the left folding coil F0 may extend from the third-first and third-second connecting lines 1cF0 and 2cF0 in the first direction DR1. The third-first connecting line 1cF0 of the left folding coil F0 may pass through the first section S1, and the third-second connecting line 2cF0 of the left folding coil F0 may pass through the second section S2.

The third-first and third-second connecting lines 1cF4 and 2cF4 of the right folding coil F4 may extend from the second non-folding part NFP2 to the folding part FP, and the third-first and third-second extending lines 1eF4 and 2eF4 of the right folding coil F4 may extend from the third-first and third-second connecting lines 1cF4 and 2cF4 in the first direction DR1. The third-first connecting line 1cF4 of the right folding coil F4 may pass through the first section S1, and the third-second connecting line 2cF4 of the right folding coil F4 may pass through the second section S2.

According to this embodiment, three lines may be shared through the first common line CML1, and four long sides of two first sensing coils RF that pass through the upper portion of the folding part FP, eight short sides of five second sensing coils CF that pass through the upper portion of the folding part FP, eight long sides passing through the folding part FP may be provided as twelve lines. The twelve lines may be provided in a three-layer structure and may all be disposed in the upper outer portion OMu.

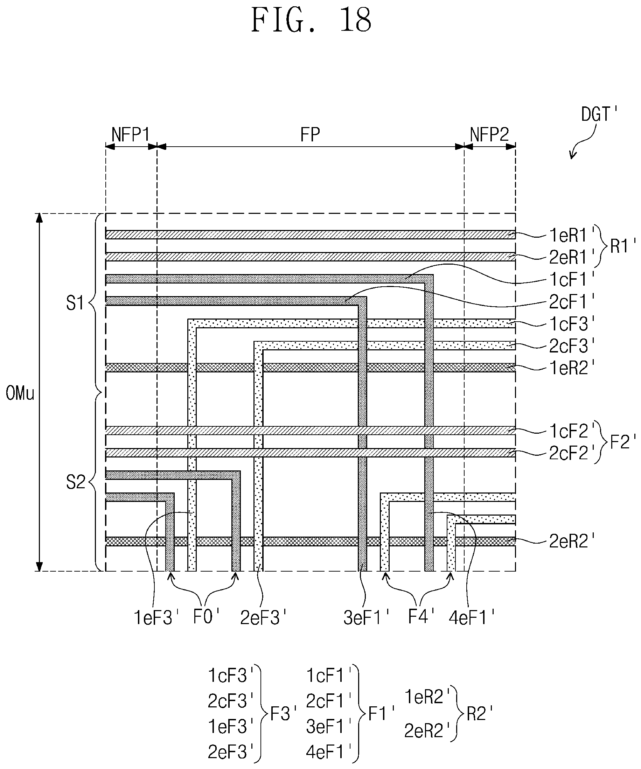

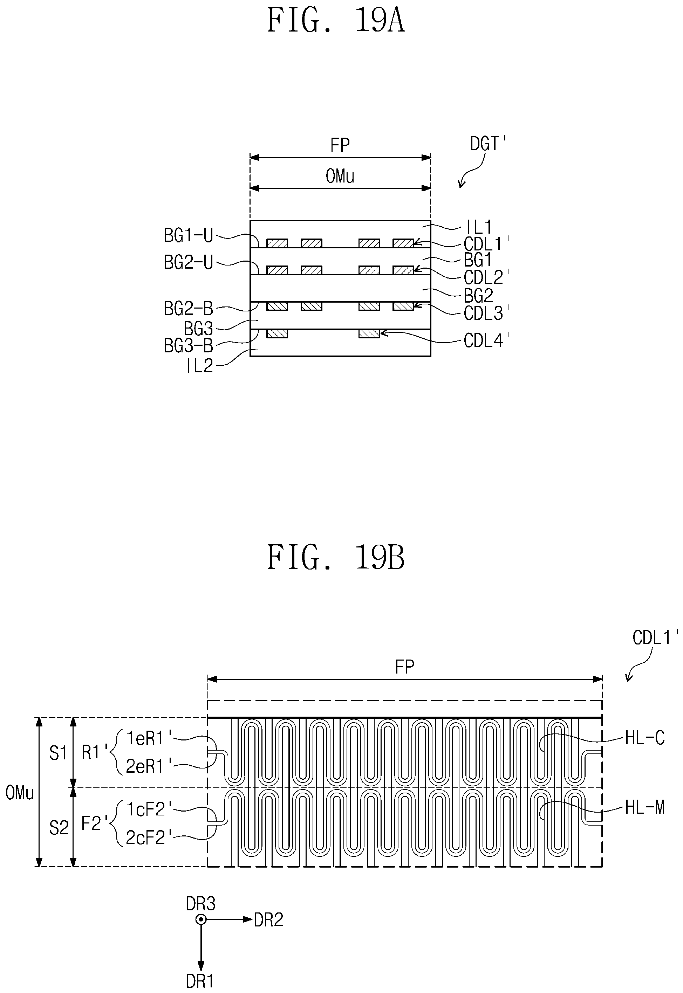

FIG. 18 is an enlarged plan view of a portion of a digitizer DGT' according to a comparative example. FIG. 19A is an enlarged cross-sectional view of a portion of the digitizer DGT' according to the comparative example. FIGS. 19B to 19E are enlarged plan views of a portion of the digitizer DGT' according to the comparative example. FIGS. 18 to 19E illustrate enlarged views of lines disposed in an outer portion on an upper side (hereinafter, the upper outer portion OMu). Description of FIGS. 18 to 19E may be similarly applied to lines disposed in a lower outer portion OM (refer to FIG. 11).

Referring to FIG. 18, in the comparative example, portions of five folding coils F0' to F4' and portions of two sensing coils R1' and R2' may be disposed in the upper outer portion OMu as in the embodiment described above with reference to FIG. 16.

Referring to FIG. 19A, in the comparative example, the digitizer DGT' may include a first base layer BG1, a second base layer BG2, a third base layer BG3, a first cover layer IL1, and a second cover layer IL2. Lines disposed on the upper surface BG1-U of the first base layer BG1 and covered by the first cover layer IL1 may constitute a first conductive layer CDL1'. Lines disposed on the upper surface BG2-U of the second base layer BG2 and covered by the first base layer BG1 may constitute a second conductive layer CDL2'. Lines disposed on the lower surface BG2-B of the second base layer BG2 and covered by the third base layer BG3 may constitute a third conductive layer CDL3'. Lines disposed on the lower surface BG3-B of the third base layer BG3 and covered by the second cover layer IL2 may constitute a fourth conductive layer CDL4'. According to the comparative example, the conductive layers in the upper outer portion OMu may be disposed in a four-layer structure.

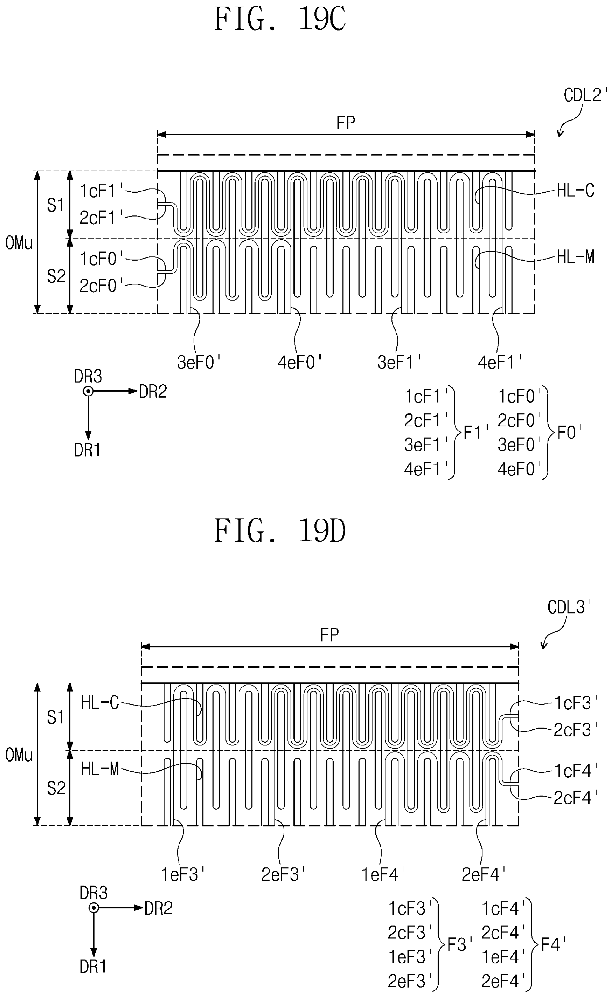

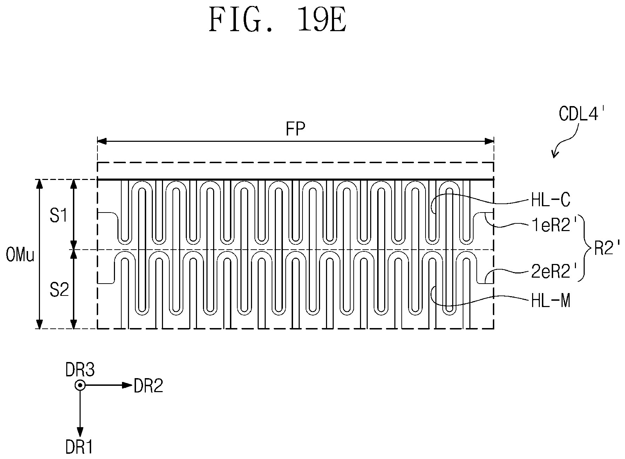

FIG. 19B illustrates a plan view of the first conductive layer CDL1' in the upper outer portion OMu, FIG. 19C illustrates a plan view of the second conductive layer CDL2' in the upper outer portion OMu, FIG. 19D illustrates a plan view of the third conductive layer CDL3' in the upper outer portion OMu, and FIG. 19E illustrates a plan view of the fourth conductive layer CDL4' in the upper outer portion OMu.

Referring to FIGS. 18 to 19E, in the comparative example, a portion of the first-first sensing coil R1' and a portion of the second folding coil F2' may be included in the first conductive layer CDL1', and a portion of the first folding coil F1' and a portion of the left folding coil F0' may be included in the second conductive layer CDL2'. A portion of the third folding coil F3' and a portion of the right folding coil F4' may be included in the third conductive layer CDL3', and a portion of the second-first sensing coil R2' may be included in the fourth conductive layer CDL4'.

Referring to FIGS. 18, 19A, and 19B, first-first and first-second extending lines 1eR1' and 2eR2' of the first-first sensing coil R1' may cross a first section S1, and third-first and third-second connecting lines 1cF2' and 2cF2' of the second folding coil F2' may cross a second section S2.

Referring to FIGS. 18, 19A, and 19C, third-first and third-second connecting lines 1cF1' and 2cF1' of the first folding coil F1' may extend from a first non-folding part NFP1 to a folding part FP, and third-third and third-fourth extending lines 3eF1' and 4eF1' of the first folding coil F1' may extend from the third-first and third-second connecting lines 1cF1' and 2cF1' in the first direction DR1. The third-first and third-second connecting lines 1cF1' and 2cF1' of the first folding coil F1' may pass through the first section S1.

Third-first and third-second connecting lines 1cF0' and 2cF0' of the left folding coil F0' may extend from the first non-folding part NFP1 to the folding part FP, and third-third and third-fourth extending lines 3eF0' and 4eF0' of the left folding coil F0' may extend from the third-first and third-second connecting lines 1cF0' and 2cF0' in the first direction DR1. The third-first and third-second connecting lines 1cF0' and 2cF0' of the left folding coil F0' may pass through the second section S2.

Referring to FIGS. 18, 19A, and 19D, third-first and third-second connecting lines 1cF3' and 2cF3' of the third folding coil F3' may extend from a second non-folding part NFP2 to the folding part FP, and third-first and third-second extending lines 1eF3' and 2eF3' of the third folding coil F3' may extend from the third-first and third-second connecting lines 1cF3' and 2cF3' in the first direction DR1. The third-first and third-second connecting lines 1cF3' and 2cF3' of the third folding coil F3' may pass through the first section S1.

Third-first and third-second connecting lines 1cF4' and 2cF4' of the right folding coil F4' may extend from the second non-folding part NFP2 to the folding part FP, and third-first and third-second extending lines 1eF4' and 2eF4' of the right folding coil F4' may extend from the third-first and third-second connecting lines 1cF4' and 2cF4' in the first direction DR1. The third-first and third-second connecting lines 1cF4' and 2cF4' of the right folding coil F4' may pass through the second section S2.

Referring to FIGS. 18, 19A, and 19E, a first-first extending line 1eR2' of the second-first sensing coil R2' may cross the first section S1. A first-second extending line 2eR2' of the second-first sensing coil R2' may cross the second section S2.

According to the comparative example, four long sides of two first sensing coils RF' that pass through the upper portion of the folding part FP, eight short sides of five second sensing coils CF' that pass through the upper portion of the folding part FP, and eight long sides that pass through the folding part FP may be provided as fourteen lines. To pass through the upper outer portion OMu, the fourteen lines have to have a four-layer structure. In contrast, according to the embodiment of the present disclosure described above with reference to FIGS. 16 to 17D, a three-layer structure may be provided because fewer lines are arranged when the same numbers of long sides/short sides are provided. Accordingly, according to the embodiment of the present disclosure, the wiring density in the thickness direction may be reduced even though a bypass line due to space limitation is not included, and thus the digitizer DGT (refer to FIG. 16) with improved sensing performance and improved folding characteristics may be provided.

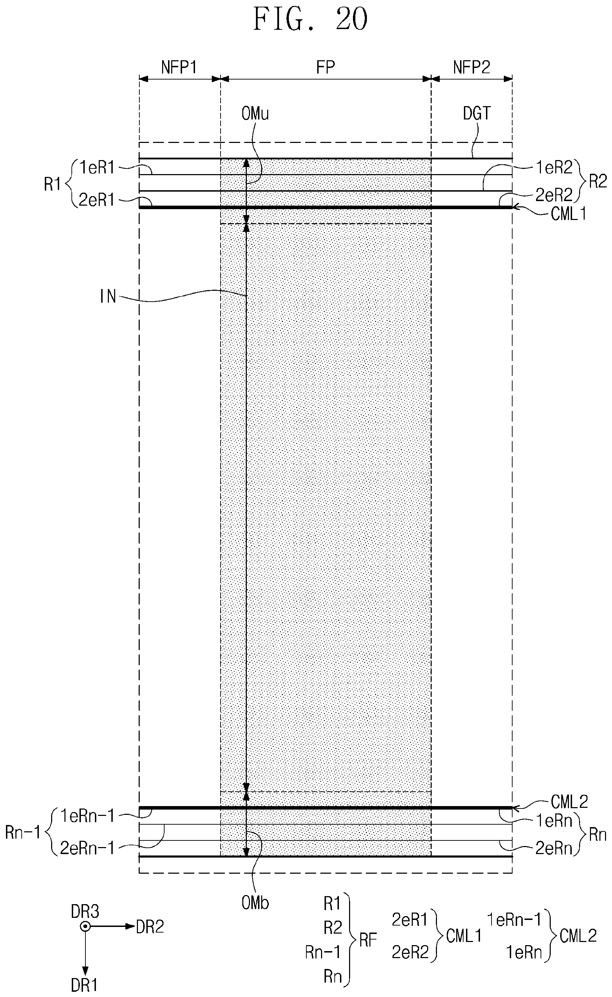

FIGS. 20 to 23 are enlarged plan views of a portion of the digitizer DGT according to an embodiment of the present disclosure. Components identical/similar to the components described with reference to FIGS. 5A to 17D will be assigned with identical/similar reference numerals, and repetitive descriptions will be omitted.

Referring to FIG. 20, in this embodiment, some of the first sensing coils RF may be disposed in each of the upper outer portion OMu and the lower outer portion OMb of the digitizer DGT. Portions of the first-first and second-first sensing coils R1 and R2 may be disposed in the upper outer portion OMu, and portions of the (n-1)^{th}-first and n^{th}-first sensing coils Rn-1 and Rn may be disposed in the lower outer portion OMb.

The common lines CML may include the first common line CML1 and the second common line CML2. Each of the first and second common lines CML1 and CML2 may extend to the left inactive area NAA (refer to FIG. 6A), the active area AA (refer to FIG. 6A), and the right inactive area NAA (refer to FIG. 6A). The first common line CML1 may extend to cross the upper outer portion OMu. The second common line CML2 may extend to cross the lower outer portion OMb.

In this embodiment, each of the first and second common lines CML1 and CML2 may be shared by two first sensing coils RF.

The first common line CML1 may provide a portion of the first-first sensing coil R1 and a portion of the second-first folding coil R2. The first common line CML1 may be shared as the first-second extending line 2eR1 of the first-first sensing coil R1 and the first-second extending line 2eR2 of the second-first sensing coil R2.

The second common line CML2 may provide a portion of the (n-1)^{th}-first sensing coil Rn-1 and a portion of the n^{th}-first sensing coil Rn. The second common line CML2 may be shared as the first-first extending line 1eRn-1 of the (n-1)^{th}-first sensing coil Rn-1 and the first-first extending line 1eRn of the n^{th}-first sensing coil Rn.

Meanwhile, although FIG. 20 illustrates an example that one common line is disposed in each of the upper outer portion OMu and the lower outer portion OMb, the present disclosure is not limited thereto. A plurality of common lines may be disposed in each of the upper outer portion OMu and the lower outer portion OMb.

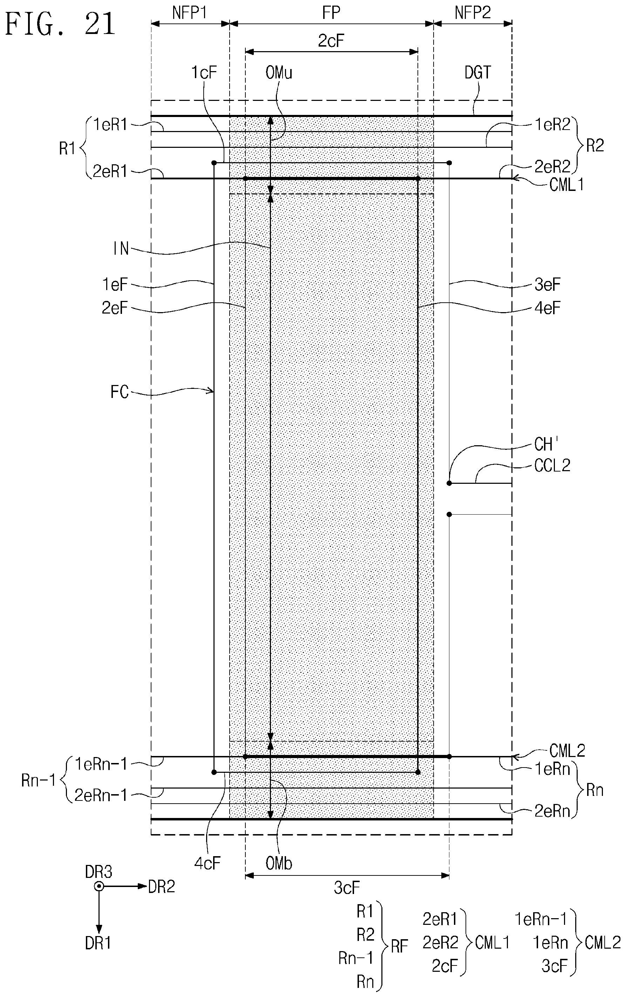

Referring to FIG. 21, in this embodiment, some of the first sensing coils RF and a portion of a folding coil FC may be disposed in each of the upper outer portion OMu and the lower outer portion OMb of the digitizer DGT. Portions of the first-first and second-first sensing coils R1 and R2 and a portion of the folding coil FC may be disposed in the upper outer portion OMu, and portions of the (n-1)^{th}-first and n^{th}-first sensing coils Rn-1 and Rn and a portion of the folding coil FC may be disposed in the lower outer portion OMb. The folding coil FC may include third-first to third-fourth extending lines 1eF, 2eF, 3dF, and 4eF and third-first to third-fourth connecting lines 1cF, 2cF, 3cF, and 4cF.

The common lines CML may include the first common line CML1 and the second common line CML2. The first common line CML1 may extend to cross the upper outer portion OMu. The second common line CML2 may extend to cross the lower outer portion OMb. In this embodiment, each of the first and second common lines CML1 and CML2 may be shared by two first sensing coils RF and one folding coil FC.

The first common line CML1 may provide a portion of the first-first sensing coil R1, a portion of the second-first sensing coil R2, and a portion of the folding coil FC. The first common line CML1 may be shared as the first-second extending line 2eR1 of the first-first sensing coil R1, the first-second extending line 2eR2 of the second-first sensing coil R2, and the third-second connecting line 2cF of the folding coil FC.

The second common line CML2 may provide a portion of the (n-1)^{th}-first sensing coil Rn-1, a portion of the n^{th}-first sensing coil Rn, and a portion of the folding coil FC. The second common line CML2 may be shared as the first-first extending line 1eRn-1 of the (n-1)^{th}-first sensing coil Rn-1, the first-first extending line 1eRn of the n^{th}-first sensing coil Rn, and the third-third connecting line 3cF of the folding coil FC.

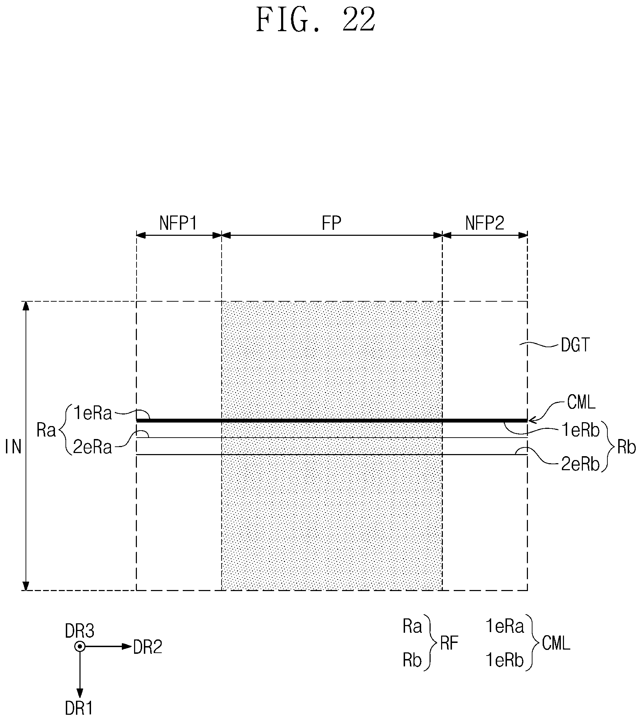

FIG. 22 illustrates an enlarged view of portions of lines passing through the inner portion IN. In FIG. 22, the i^{th}-first sensing coil Ra and the j^{th}-first sensing coil Rb are illustrated (i and j being different natural numbers).

Referring to FIG. 22, the i^{th}-first sensing coil Ra and the j^{th}-first sensing coil Rb may cross the inner portion IN. The i^{th}-first sensing coil Ra and the j^{th}-first sensing coil Rb may be first sensing coils disposed adjacent to each other (e.g., the j^{th} sensing line corresponds to the (i+1)^{th}-first sensing coil), but are not limited thereto.

In this embodiment, at least a portion of the common line CML may be disposed in the inner portion IN. In this embodiment, the common line CML may cross the inner portion IN. The common line CML may extend parallel to the first extending line EL1 (refer to FIG. 6A) adjacent thereto. The common line CML may extend to the left inactive area NAA (refer to FIG. 6A), the active area AA (refer to FIG. 6A), and the right inactive area NAA (refer to FIG. 6A).

The common line CML may be shared by the two first sensing coils Ra and Rb. In FIG. 22, the common line CML is illustrated as being shared as a first-first extending lien 1eRa of the i^{th}-first sensing coil Ra and a first-first extending line 1eRb of the j^{th}-first sensing coil Rb. However, without being limited thereto, the common line CML may be shared by one of the first-second to first-fourth extending lines 12e, 13e, and 14e (refer to FIG. 6B) of the i^{th}-first sensing coil Ra, or may be shared by one of the first-second to first-fourth extending lines 12e, 13e, and 14e (refer to FIG. 6B) of the j^{th}-first sensing coil Rb.

Meanwhile, although one common line disposed in the inner portion IN is illustrated in FIG. 22, a plurality of common lines may be disposed in the inner portion IN.

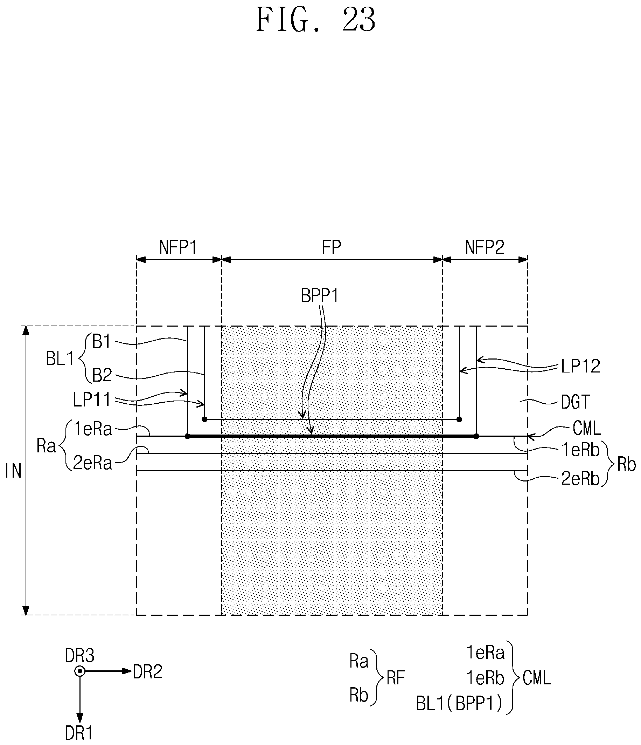

FIG. 23 illustrates an enlarged view of portions of lines passing through the inner portion IN. In FIG. 23, the i^{th}-first sensing coil Ra, the j^{th}-first sensing coil Rb, and a pair of first bridge lines B1 and B2 are illustrated.

Referring to FIG. 23, in this embodiment, the common line CML may cross the inner portion IN. The common line CML may be shared by two first sensing coils Rf and one first bridge line B1. The first-first extending line 1eRa of the i^{th}-first sensing coil Ra, the first-first extending line 1eRb of the j^{th}-first sensing coil Rb, and a first bridge pattern portion BPP1 of the first bridge line B1 may be shared as the common line CML. In FIG. 23, the types of shared first extending lines EL1 (refer to FIG. 6B) are illustrated, and the present disclosure is not limited thereto.

Meanwhile, embodiments are not limited thereto, and the common line CML may be shared by the first sensing coils RF and the second bridge line BL2 (refer to FIG. 7A).

The embodiments illustrated in FIGS. 12A to 23 are illustrative, and the types of lines in the digitizer DGT that are shared by the common line CML are not limited to any one embodiment. Some of the lines curvedly extending along the peripheries of the holes HL (refer to FIG. 7A) in the folding part FP may be shared by the common line CML. Accordingly, a density of the lines arranged in the folding part FP may be decreased, and the number of lines provided in the form of a bypass path may be decreased. Thus, the sensing performance in the folding part FP may be improved.

On the one hand, omitting bypass lines may occur when adding a conductivelayer, although the thickness of the digitizer (DGT) may increase, potentially compromising folding reliability, and lines may become densely packed in the thickness direction, potentially compromising line reliability during folding operations. However, according to this embodiment, it is possible to reduce bypass path without adding a additional conductive layer. Accordingly, wiring density may be reduced without compromising folding reliability and line reliability.

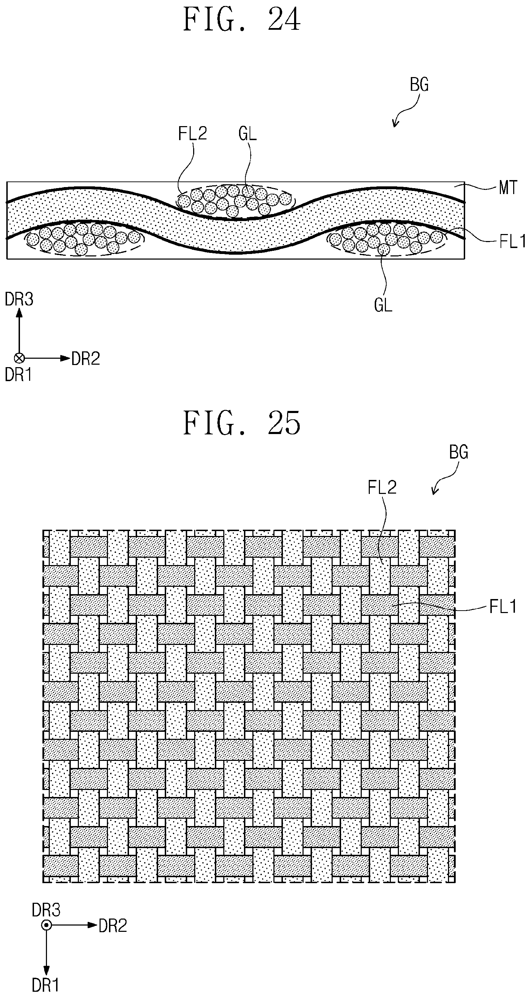

FIG. 24 is a cross-sectional view of a base layer BG included in the digitizer DGT (refer to FIG. 5A) according to an embodiment of the present disclosure. FIG. 25 is a plan view of the base layer BG included in the digitizer DGT (refer to FIG. 5A) according to an embodiment of the present disclosure. Description of the base layer BG that will be given below with reference to FIGS. 24 and 25 may be applied to the first to third base layers BG1, BG2, and BG3 and the first and second cover layers IL1 and IL2 described above with reference to FIGS. 8A to 9.

Referring to FIGS. 24 and 25, the base layer BG according to the present disclosure may include a matrix MT including a filler and fiber lines FL1 and FL2 disposed inside the matrix MT and interwoven with each other.

The fiber lines FL1 and FL2 may be alternately arranged in the first direction DR1 and the second direction DR2 and may have a fabric shape on the plane. Each of the fiber lines FL1 and FL2 may be provided in the form of a bundle of fibers GL. The diameter of one strand of fiber GL included in one fiber line may range from 3 µm to 10 µm.

Each of the fiber lines FL1 and FL2 may include a fiber reinforced composite. The fiber reinforced composite may be one of carbon fiber-reinforced plastic (CFRP) and glass fiber-reinforced plastic (GFRP). The fiber lines FL1 and FL2 may be disposed inside the matrix MT. The matrix MT according to an embodiment may include at least one of epoxy, polyester, polyamide, polycarbonate, polypropylene, polybutylene, or vinyl ester.

The matrix MT may include the filler. The filler may include at least one of silica, barium sulphate, sintered talc, barium titanate, titanium oxide, clay, alumina, mica, boehmite, zinc borate, or zinc tinate.

The base layer BG may have a modulus of 10GPa to 30GPa.

According to the present disclosure, the base layer BG included in the digitizer DGT (refer to FIG. 5A) may include the fiber bundle of glass fiber reinforced plastic or carbon fiber reinforced plastic disposed inside the matrix MT and may protect the lower part of the electronic device ED (refer to FIG. 1A) when the electronic device ED is folded.

The digitizer DGT (refer to FIG. 5A) of the present disclosure may be a component that senses a pen while functioning as a protective member. Accordingly, a separate metal plate may be omitted between the display module DM (refer to FIG. 5A) and the digitizer DGT (refer to FIG. 5A). Thus, costs may be reduced, and the slim electronic device ED (refer to FIG. 1A) may be provided.

While the present disclosure has been described with reference to embodiments thereof, it will be apparent to those of ordinary skill in the art that various changes and modifications may be made thereto without departing from the spirit and scope of the present disclosure as set forth in the following claims.

### INDUSTRIAL APPLICABILITY

Since the folding characteristics of the digitizer can be improved and the sensing sensitivity in the folding region can be enhanced, the present invention has high industrial applicability.

## Claims

1. An electronic device comprising:
a display module including an active area where an image is provided and a peripheral area adjacent to the active area; and
a digitizer disposed under the display module, the digitizer including a folding part folded about a folding axis extending in a first direction and a first non-folding part and a second non-folding part spaced apart from each other in a second direction crossing the first direction with the folding part therebetween,
wherein the digitizer includes a plurality of sensing coils, and different sensing coils among the plurality of sensing coils are shared through a common line disposed at least in the folding part.

2. The electronic device of claim 1, wherein the common line extends in the second direction.

3. The electronic device of claim 1, wherein when one of the different sensing coils shared through the common line is driven for sensing, the remaining different sensing coils shared through the common line are driven to be floated.

4. The electronic device of claim 1, wherein the plurality of sensing coils include:
first sensing coils arranged in the first direction, each of the first sensing coils being configured to extend in the second direction; and
second sensing coils arranged in the second direction, each of the second sensing coils being configured to extend in the first direction, wherein the second sensing coils include non-folding coils disposed in the first non-folding part or the second non-folding part and folding coils at least partially disposed in the folding part, and
wherein the first sensing coils and the second sensing coils are insulated from each other, and each of the first sensing coils and each of the second sensing coils forms an open loop.

5. The electronic device of claim 4, wherein the common line is shared by two folding coils.

6. The electronic device of claim 4, wherein the common line is shared by two folding coils and one first sensing coil.

7. The electronic device of claim 4, wherein the common line is shared by two first sensing coils.

8. The electronic device of claim 4, wherein the common line is shared by one folding coil and two first sensing coils.

9. The electronic device of claim 4, wherein each of the first sensing coils includes first extending lines configured to extend in the second direction and first connecting lines connected with the first extending lines and configured to extend in the first direction, and
wherein each of the first extending lines extends from the first non-folding part to the second non-folding part via the folding part.

10. The electronic device of claim 9, wherein each of the non-folding coils includes second extending lines configured to extend in the first direction and second connecting lines connected with the second extending lines and configured to extend in the second direction, and
wherein each of the folding coils includes third extending lines configured to extend in the first direction and third connecting lines connected with the third extending lines and configured to extend in the second direction, and each of the third connecting lines is disposed at least in the folding part.

11. The electronic device of claim 10, wherein the folding coils include a first folding coil, a second folding coil, and a third folding coil, the common line provided in plural, and the plurality of common lines include a first common line and a second common line,
wherein the first common line is shared by one third connecting line of the first folding coil and one third connecting line of the second folding coil, and
wherein the second common line is shared by another third connecting line of the second folding coil and one third connecting line of the third folding coil.

12. The electronic device of claim 11, wherein the digitizer includes a base layer, and third extending lines disposed in the folding part are connected to corresponding third connecting lines through contact holes formed through the base layer.

13. The electronic device of claim 12, wherein the contact holes are defined in the folding part, and
wherein the third extending lines disposed in the folding part extend in the first direction in the folding part.

14. The electronic device of claim 12, wherein the contact holes are defined in the first non-folding part or the second non-folding part, and
wherein each of the third extending lines disposed in the folding part includes an extension configured to extend in the first direction in the folding part and a connecting portion configured to connect the extension and a corresponding contact hole.

15. The electronic device of claim 12, wherein the folding part includes an inner portion and an upper outer portion and a lower outer portion spaced apart from each other in the first direction with the inner portion therebetween, and up to four lines are disposed in the same layer in each of the upper outer portion and the lower outer portion, and
wherein the first common line is disposed at least in the upper outer portion, and the second common line is disposed at least in the lower outer portion.

16. The electronic device of claim 15, wherein at least one of two first extending lines of a first-first sensing coil and two first extending lines of a second-first sensing coil cross the upper outer portion, and
wherein at least one of two first extending lines of an (n-1)^{th}-first sensing coil and two first extending lines of an n^{th}-first sensing coil cross the lower outer portion, and n is a natural number greater than or equal to 4.

17. The electronic device of claim 11, wherein the first common line is additionally shared by one first extending line of a first-first sensing coil, and
wherein the second common line is additionally shared by one first extending line of an (n-1)^{th}-first sensing coil, and n is a natural number greater than or equal to 4.

18. The electronic device of claim 10, wherein each of the first sensing coils and each of the folding coils forms an open loop wound twice,
wherein the first extending lines of each of the first sensing coils include first-first to first-fourth extending lines, and the first connecting lines of each of the first sensing coils include first-first to first-fourth connecting lines, and
wherein the third extending lines of each of the folding coils include third-first to third-fourth extending lines, and the third connecting lines of each of the folding coils include third-first to third-fourth connecting lines.

19. The electronic device of claim 18, wherein the folding coils include a first folding coil, a second folding coil, and a third folding coil arranged in the second direction, and
wherein the common line is shared by a third-first connecting line of the first folding coil, a third-first connecting line of the second folding coil, and a first-second extending line of a first-first sensing coil.

20. The electronic device of claim 19, wherein the digitizer includes:
a first base layer;
a second base layer disposed under the first base layer;
a first cover layer disposed on the first base layer;
a second cover layer disposed under the second base layer;
a first conductive layer disposed between the first base layer and the first cover layer;
a second conductive layer disposed between the first base layer and the second base layer; and
a third conductive layer disposed between the second base layer and the second cover layer, and
wherein the folding part includes an inner portion and an outer portion spaced apart from the inner portion in the first direction, and up to four lines are disposed in the same layer in the outer portion.

21. The electronic device of claim 20, wherein the folding coils further include a left folding coil and a right folding coil spaced apart from each other in the second direction with the first to third folding coils therebetween,
wherein a first-first extending line of the first-first sensing coil, first-first and first-second extending lines of a second-first sensing coil, and a third-second connecting line of the second folding coil are included in the first conductive layer and pass through the outer portion,
wherein the common line, a third-second connecting line of the first folding coil, and third-first and third-second connecting lines of the third folding coil are included in the second conductive layer and pass through the outer portion, and
wherein third-third and third-fourth extending lines of the first folding coil, third-first and third-second extending lines of the third folding coil, third-first and third-second connecting lines and third-third and third-fourth extending lines of the left folding coil, and third-first and third-second connecting lines and third-first and third-second extending lines of the right folding coil are included in the third conductive layer and pass through the outer portion.

22. The electronic device of claim 9, wherein the folding part includes an inner portion and an outer portion spaced apart from the inner portion in the first direction, and up to four lines are disposed in a same layer in the outer portion, and
wherein the common line is shared by one first extending line of an i^{th}-first sensing coil and one first extending line of a j^{th}-first sensing coil and passes through the inner portion.
and i and j are different natural numbers from each other.

23. The electronic device of claim 1, wherein the digitizer further includes bridge lines configured to electrically connect second sensing coils disposed in the first non-folding part and a connector and pass through the folding part, and the common line is additionally shared by at least one bridge line.

24. The electronic device of claim 1, wherein the folding part includes an inner portion and an outer portion spaced apart from the inner portion in the first direction, and first holes defined in the inner portion and second holes and third holes defined at least in the outer portion are defined in the folding part,
wherein the first holes include:
first group holes arranged in the first direction, each of the first group holes being configured to extend in the first direction; and
second group holes arranged in the first direction, each of the second group holes being configured to extend in the first direction, wherein the second group holes alternate with the first group holes and are shifted in the first direction with the first group holes,
wherein the second holes are spaced apart from the first group holes in the first direction, and each of the second holes extends in the first direction, and
wherein the third holes include:
third-first holes spaced apart from the second group holes in the first direction, each of the third-first holes being configured to extend in the first direction; and
third-second holes spaced apart from the third-first holes in the first direction and arranged in the second direction at an edge of the outer portion, wherein the third-second holes define an open opening.

25. The electronic device of claim 24, wherein up to four lines are disposed in the same layer between holes adjacent to each other in the first direction, and up to two lines are disposed in a same layer between holes adjacent to each other in the second direction.

26. The electronic device of claim 24, wherein at least one of the plurality of sensing coils includes a plurality of sensing lines configured to cross the folding part and curvedly extend along peripheries of the holes,
wherein a gap between a hole and a sensing line adjacent to each other is less than 75 micrometers,
wherein a gap between sensing lines adjacent to each other ranges from 20 micrometers to 40 micrometers, and
wherein each of the sensing lines has a width of 40 micrometers to 200 micrometers.

27. The electronic device of claim 1, wherein the digitizer includes:
a first base layer having first base holes defined therein;
a second base layer disposed under the first base layer, the second base layer having second base holes defined therein;
a first cover layer disposed on the first base layer, the first cover layer having first cover holes defined therein; and
a second cover layer disposed under the second base layer, the second cover layer having second cover holes defined therein, and
wherein holes are defined in the folding part of the digitizer, and each of the holes is defined by a corresponding first base hole, a corresponding second base hole, a corresponding first cover hole, and a corresponding second cover hole aligned in a thickness direction.

28. The electronic device of claim 27, wherein each of the first base layer, the second base layer, the first cover layer, and the second cover layer includes a fiber reinforced composite and has a modulus of 10GPa to 30GPa.

29. The electronic device of claim 1, wherein the digitizer includes:
a first base layer having first base holes defined therein;
a second base layer disposed under the first base layer, the second base layer having second base holes defined therein;
a third base layer disposed under the second base layer, the third base layer having third base holes defined therein;
a first cover layer disposed on the first base layer, the first cover layer having first cover holes defined therein; and
a second cover layer disposed under the third base layer, the second cover layer having second cover holes defined therein, and
wherein holes are defined in the folding part of the digitizer, and each of the holes is defined by a corresponding first base hole, a corresponding second base hole, a corresponding third base hole, a corresponding first cover hole, and a corresponding second cover hole aligned in a thickness direction.

30. An electronic device comprising:
a display module including an active area where an image is provided and a peripheral area adjacent to the active area; and
a digitizer disposed under the display module, the digitizer including a folding part folded about a folding axis extending in a first direction and a first non-folding part and a second non-folding part spaced apart from each other in a second direction crossing the first direction with the folding part therebetween,
wherein the digitizer includes:
a plurality of sensing coils, each of which includes a plurality of sensing lines; and
a plurality of bridge lines configured to connect the plurality of sensing coils and a connector, and
wherein some of the plurality of sensing lines and the plurality of bridge lines configured to pass through the folding part are shared through a common line.
